(19) Europäisches Patentamt
European Patent Office
Office européen des brevets

(11) **EP 1 322 120 B1**

(12) **EUROPEAN PATENT SPECIFICATION**

(45) Date of publication and mention
of the grant of the patent:
**30.03.2011 Bulletin 2011/13**

(51) Int Cl.:
*H04N 7/24* (2011.01)          *G06T 9/00* (2006.01)
*H04N 7/26* (2006.01)

(21) Application number: **02258174.8**

(22) Date of filing: **27.11.2002**

(54) **Encoding and decoding key value data of orientation interpolator node**

Schlüsselwertkodierung und -dekodierung von Orientierungsinterpolatorknoten

Codage et décodage de valeur clé d'un noeud à interpolation d'orientation

(84) Designated Contracting States:
**BE DE ES FR GB NL**

(30) Priority: **27.11.2001 US 333130 P**
**03.12.2001 US 334541 P**
**26.12.2001 US 342101 P**
**04.04.2002 US 369597 P**
**13.11.2002 KR 2002070496**

(43) Date of publication of application:
**25.06.2003 Bulletin 2003/26**

(73) Proprietor: **SAMSUNG ELECTRONICS CO., LTD.**
**Suwon-City, Kyungki-do (KR)**

(72) Inventors:
• **Kim, Do-Kyoon**
**Seongnam-city,**
**Kyungki-do 463-832 (KR)**
• **Jung, Seok-Yoon**
**Seoul (KR)**
• **Jang, Euee-seon,**
**101-2301 Gangbyeon Kunyoung Apt.**
**Seoul (KR)**
• **Woo, Sang-oak,**
**508-1303 Gongjak Maeul Lucky Apt.**
**Anyang-city,**
**Kyungki-do (KR)**
• **Lee, Shin-jun**
**Seoul (KR)**
• **Han, Mahn-jin,**
**307-602 Satbyeol Maeul Woobang Apt.**
**Seongnam-city,**
**Kyungki-do (KR)**
• **Jang, Gyeong-ja**
**Deokyang-gu,**
**Goyang-city,**
**Kyungki-do (KR)**

(74) Representative: **Exell, Jonathan Mark**
**Elkington & Fife**
**Prospect House**
**8 Pembroke Road**
**Sevenoaks**
**Kent TN13 1XR (GB)**

(56) References cited:
**WO-A-01/41156     US-A- 6 075 901**

• KIM J D K ET AL: "Animation data compression in MPEG-4: interpolators" PROCEEDINGS 2002 INTERNATIONAL CONFERENCE ON IMAGE PROCESSING. ICIP 2002. ROCHESTER, NY, SEPT. 22 - 25, 2002, INTERNATIONAL CONFERENCE ON IMAGE PROCESSING, NEW YORK, NY : IEEE, US, vol. VOL. 2 OF 3, 22 September 2002 (2002-09-22), pages 33-36, XP010607503 ISBN: 0-7803-7622-6
• MPEG: "Call for Proposals for Interpolator Compression N4098" ISO IEC JTC1 SC29 WG11, March 2001 (2001-03), XP001152019 SINGAPORE
• ISO/IEC JTC1/SC29/WG11 N4364 / HAN, M., COTARMANAC'H, A.: "InterpolatorCompression Core Experiments Description N4364" ISO IEC JTC1 SC29 WG11, [Online] July 2001 (2001-07), XP001152020 SYDNEY Retrieved from the Internet: URL:http://www.chiariglione.org/mpeg/worki ng_documents/mpeg-04/systems/ interpolator_ compression_ce.zip> [retrieved on 2005-05-15]
• JANG E S: "3D animation coding: its history and framework" MULTIMEDIA AND EXPO, 2000. ICME 2000. 2000 IEEE INTERNATIONAL CONFERENCE ON NEW YORK, NY, USA 30 JULY-2 AUG. 2000, PISCATAWAY, NJ, USA,IEEE, US, vol. 2, 30 July 2000 (2000-07-30), pages 1119-1122, XP010513206 ISBN: 0-7803-6536-4

- SIGNES J: "BINARY FORMAT FOR SCENE (BIFS): COMBINING MPEG-4 MEDIA TO BUILD RICH MULTIMEDIA SERVICES" PROCEEDINGS OF THE SPIE, SPIE, BELLINGHAM, VA, US, vol. 3653, 25 January 1999 (1999-01-25), pages 1506-1517, XP000984179 ISSN: 0277-786X

**Description**

The present invention relates to a method and an apparatus for encoding and decoding key value data of an animation, and more particularly, to a method and an apparatus for encoding and decoding key value data of an orientation interpolator node, which are converted into quaternion by encoding and decoding differences among orientation-converted values applied to an object in each keyframe.

MPEG-4 BIFS, which is one of the international multimedia standards, supports a keyframe-based animation using an interpolator node having keys and key values of an animation.

In order to represent animation as naturally and smoothly as possible using such a keyframe-based animation technique, a considerable number of keys and a considerable amount of key value data are required, and field data between key frames are filled in by interpolation. Interpolation in a virtual reality modeling language (VRML) involves linear or spherical interpolation.

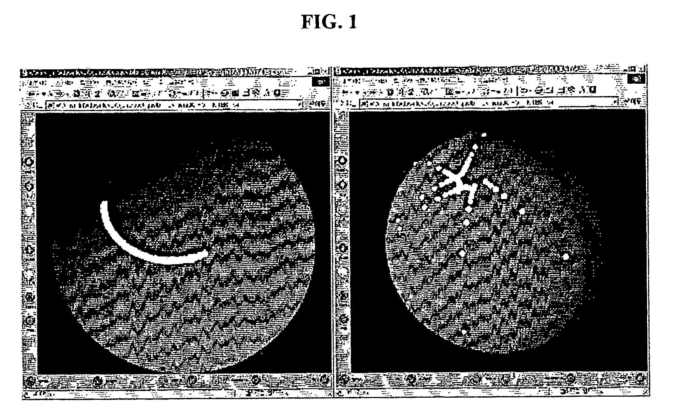

Keys and key values approximate an original animation curve on a temporal axis. FIG. 1 is a diagram illustrating two-dimensional trajectories of animation data, represented by an orientation interpolator node, in accordance with the passage of time on the surface of a three-dimensional sphere. As shown in FIG. 1, the conventional MPEG-4 BIFS supports spherical linear interpolation between keyframes, and an animation path looks similar to a set of segments representing the variation of the animation data.

In an orientation interpolator node provided by BIFS, key data indicate a predetermined moment of time on a temporal axis where an animation is located using discontinuous numbers between -∞ and ∞. Key value data represent information on the rotation of an object in a synthetic image at a predetermined moment of time indicated by key data. Information on the rotation of the object at another predetermined moment of time, which is not represented by key data, is obtained using key data corresponding to two moments of time, which are most adjacent to the predetermined moment of time, by spherical linear interpolation.

In spherical linear interpolation, rotation information is represented by a rotation axis and a rotation angle. MPEG-4 BIFS, like virtual reality modeling language (VRML), supports rotation information represented by a rotation axis and a rotation angle using an orientation interpolator node. When generating a smooth animation using key value data in spherical linear interpolation, differential values of key value data between keyframes are highly correlated with each other, which causes redundancy among data. Accordingly, it is effective to use a method for encoding key value data using differential values of data.

MPEG-4 BIFS provides two different methods for encoding field data represented by keys and key value data of an orientation interpolator node. One is a method for encoding field data using pulse code modulation (PCM) and the other is a method for encoding field data using differential pulse code modulation (DPCM) and entropy encoding.

In the method for encoding field data using PCM, only a quantization process is performed on key data and key value data to be encoded. Since the characteristics of data to be encoded are not considered in this method, this method is considered ineffective. In the method for encoding field data using PCM, field data of an orientation interpolator node are input, and key value data of the field data are converted into values in a quaternion space. Next, keys and key value data are quantized. Quantized field data are output in the form of binary data. In order to measure the degree to which the results of quaternion transformation are visually distorted as compared with original field data, the binary data are restored into key value data consisting of a rotation axis and a rotation angle. Restored field data of an orientation interpolator node are stored and then are output on a screen. It is possible to measure the degree of visual distortion of images caused by a quaternion error using the restored data. Distortion of images can be calculated with Equation (1) below.

$$D = \sqrt{\left(\frac{\sum_{i=0}^{i<N} \varepsilon_i}{N}\right)^2} = \sqrt{\left(\frac{\sum_{i=0}^{i<N} Q_i - \hat{Q}_i}{N}\right)^2} \qquad \cdots (1)$$

In Equation (1), N represents the number of field data, and $\varepsilon_i$ represents a differential value between encoded key value data $Q_i$ and key value data $\hat{Q}_i$ restored in a quaternion space.

On the other hand, in the method for encoding field data using DPCM and entropy encoding, a correlation between successive data is considered, and thus this method is considered more effective than the method for encoding field data using PCM in terms of encoding efficiency. In this method, a differential value between previously restored key value data and key value data to be encoded is calculated before a quantization process, and then the differential value is quantized, thus enhancing the encoding efficiency by taking advantage of the characteristics of data shown in the differential value.

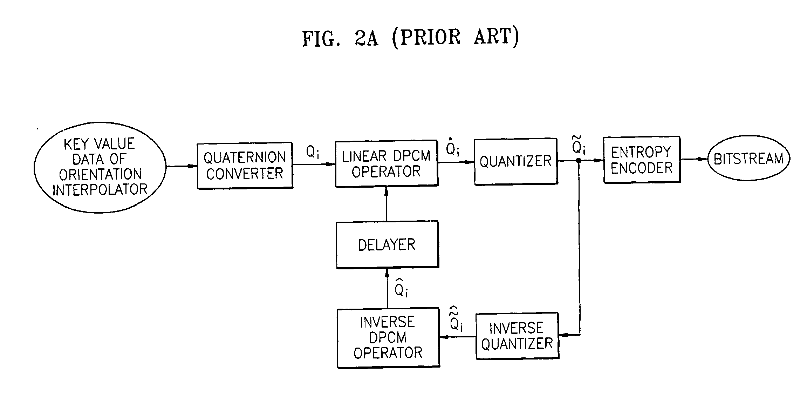

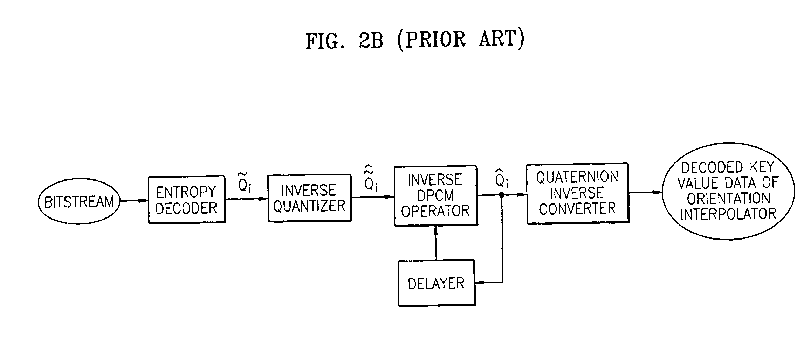

FIGS. 2A and 2B are block diagrams of a MPEG-4 PMFC encoder using linear DPCM and entropy encoding, and a MPEG-4 PMFC decoder using inverse linear DPCM and entropy decoding, respectively. A linear DPCM operator shown in FIG. 2A calculates differential data $\dot{Q}_i$ between current key value data and previously restored key value data following Equation (2).

$$\dot{Q}_i = Q_i - \hat{Q}_{i-1} = (q_{i,0} - \hat{q}_{i-1,0}, q_{i,1} - \hat{q}_{i-1,1}, q_{i,2} - \hat{q}_{i-2,2}, q_{i,3} - \hat{q}_{i-1,3}) \qquad \cdots (2)$$

In Equation (2), $Q_i$ represents original key value data at a predetermined moment of time (t), which are represented by a quaternion, and $\hat{Q}_{i-1}$ represents key value data at a predetermined moment of time (t-1), which are restored from an error compensation circuit.

However, the encoding method performed in the apparatus for encoding key value data shown in FIG. 2A does not have a high encoding efficiency. It is possible to easily figure out what the disadvantages of the encoding method are by analyzing key value data, which determine the rotation of an object in a quaternion space. Key value data are represented by a quaternion in the following equation.

$$Q = (\cos\frac{\theta}{2}, \frac{n_x}{\|n\|}\sin\frac{\theta}{2}, \frac{n_y}{\|n\|}\sin\frac{\theta}{2}, \frac{n_z}{\|n\|}\sin\frac{\theta}{2}) \qquad \cdots (3)$$

For example, when components of one quaternion have the same absolute values as their corresponding components of another quaternion but different signs in a quaternion space, as shown in Equation (3), the two quaternions are considered the same. In other words, the two quaternions provide the same effects in terms of the rotational transformation of an object in a 3D space, which means the factors that affect the rotational transformation of an object are a direction of a rotation axis and a rotation angle, rather than the vector of the rotation axis. However, like in MPEG-4 BIFS, if key value data are represented by a quaternion using Equation (3) and a differential value is linearly calculated by calculating differences in vectors between successive key value data, the differential value is not 0, which means that linear differential values do not reflect redundancy in rotational transformation well. Accordingly, it is impossible to precisely measure the quality of images using the method for measuring the distortion degree of images shown in Equation (1).

WO 01/41156 describes a method of processing a data file that specifies a hierarchy of nodes, to determine a range of parameters assumed by the nodes.

US 6,075,901 discloses a method and system for uniformly encoding arrays of values in a video stream.

MPEG has issued a call for proposals for interpolator compression and published a set of experimental conditions for evaluation of performance in this task (ISO/IEC JTC1/SC29/WG11 Output Documents N4098 and N4364, respectively).

A history of 3D animation coding is presented in Jang, "3D Animation Coding: its history and framework", Proceedings of IEEE International Conference on Multimedia and Expo 2000, vol. 2, pages 1119-1122.

An analysis of the MPEG-4 standard is presented in Signes, "Binary Format for Scene (BIFS): Combining MPEG-4 media to build rich multimedia services", Proceedings of the SPIE, vol. 3653, pages 1506-1517.

The present invention seeks to provide a method and an apparatus for encoding key value data of an orientation interpolator by calculating a rotational differential value, which can sufficiently reflect redundancy in rotational transformation.

The present invention also seeks to provide a method and an apparatus for decoding encoded key value data by encoding a rotational differential value.

The present invention further seeks to provide a method and an apparatus for generating rotational differential data, which are adopted in the method and the apparatus for encoding key value data according to the present invention.

According to a first aspect of the present invention, there is provided an apparatus for encoding key value data of an orientation interpolator representing rotation transformation of an object in keyframes, according to claim 15.

Preferably, the rotational differential data generator includes a quantizer which generates rotational differential data by quantizing three component values of the rotational differential value, a quantized data adjustor which adjusts three component values of rotational differential data input thereinto, an inverse quantizer which inversely quantizes the adjusted component values, a rotational differential value restorer which restores one component value, which has not been quantized, using the three inversely quantized component values and thus generate a restored rotational differential value, and an error measurement unit which measures an error between a rotational differential value input into the quantizer and the restored rotational differential value and outputs rotational differential data having adjusted component values so that the error can be minimized.

Alternatively, the rotational differential data generator may include a first quaternion multiplier which generates the rotational differential value using the rotational transformation value of the current keyframe and the restored rotational transformation value of the previous keyframe, a quantizer which generates rotational differential data by quantizing the rotational differential value, an inverse quantizer which generates a restored rotational differential value by inversely quantizing the rotational differential data, and a second quaternion multiplier which generates a restored rotational differential value of the current keyframe by quaternion-multiplying the restored rotational differential value by a rotational transformation value of the previous keyframe.

According to a second aspect of the present invention, there is provided a method for encoding key value data of an orientation interpolator representing the rotation of an object in each keyframe, according to claim 51. Preferably, the method includes generating the rotational differential value using a rotational transformation value of the current keyframe and a restored rotational transformation value of the previous keyframe, generating rotational differential data by quantizing the rotational differential value, generating a restored rotational differential value by inversely quantizing the rotational differential data, and generating a restored rotational transformation value of the current keyframe by quaternion-multiplying the restored rotational differential value by a rotational transformation value of the previous keyframe.

Preferably, the method includes generating rotational differential data by quantizing three component values of the rotational differential value, adjusting three component values of the rotational differential data, inversely quantizing the adjusted component values, generating a restored rotational differential value by restoring one component value using the three inversely quantized component values, and measuring an error between the rotational differential value and the restored rotational differential value and determining rotational differential data having adjusted component values so that the error can be minimized as rotational differential data to be entropy-encoded.

According to a third aspect of the present invention, there is provided an apparatus for decoding a bitstream, into which key value data of an orientation interpolator representing the rotational transformation of an object in keyframes are encoded, according to claim 35.

According to a fourth aspect of the present invention, there is provided a method for decoding a bitstream in a keyframe-based graphic animation method, into which key value data of an orientation interpolator representing the rotation of an object in each keyframe are encoded, according to claim 71.

According to a fifth aspect of the present invention, there is provided a bitstream, into which key value data of an orientation interpolator representing the rotation of an object in each keyframe are encoded, according to claim 75.

According to a sixth aspect of the present invention, there is provided an apparatus for generating rotational differential data, which generates differential data of rotational transformation values representing the rotation of an object in each frame, according to claim 1.

According to a seventh aspect of the present invention, there is provided a method for generating rotational differential data, which generates differential data of rotational transformation values representing the rotation of an object in each frame, according to claim 39.

The above and other aspects and advantages of the present invention will become more apparent by describing in detail preferred embodiments thereof with reference to the attached drawings in which:

FIG. 1 is a diagram illustrating two-dimensional trajectories of animation data, represented by an orientation interpolator node, in accordance with the passage of time on the surface of a three-dimensional sphere;

FIGS. 2A and 2B are block diagrams of a MPEG-4 PMFC encoder using linear DPCM and entropy encoding and a MPEG-4 PMFC decoder using inverse linear DPCM and entropy decoding, respectively;

FIG. 3A is a block diagram of an apparatus for encoding key value data according to a first embodiment of the present invention, and FIG. 3B is a block diagram of an apparatus for decoding key value data according to a first embodiment of the present invention;

FIG. 4A is a diagram illustrating a typical example of a probability distribution function (PDF) in each component of a rotational differential value;

FIG. 4B is an arc-tangent curve for nonlinear quantization;

FIG. 5A is an example of rotational differential data output from a quantizer according to a preferred embodiment of the present invention, FIG. 5B is a diagram illustrating the results of performing a linear DPCM operation on the differential data shown in FIG. 5A, and FIG. 5C is a diagram illustrating the results of performing a circular DPCM operation on the linear-DPCMed differential data shown in FIG. 5B;

FIG. 6A is a diagram illustrating an example of a function SignedAAC() used for entropy encoding, and FIG. 6B is a diagram illustrating an example of a function UnaryAAC() used for entropy encoding;

FIG. 7 is a diagram illustrating a rotation direction error occurring during encoding quaternion rotational transformation values using a rotational differential value;

FIG. 8A is a block diagram of a circular DPCM operator according to a second embodiment of the present invention, and FIG. 8B is a block diagram of a rotation direction error calculator shown in FIG. 8A;

FIG. 9A is a flowchart of a circular DPCM operation according to a second embodiment of the present invention, and FIG. 9B is a flowchart illustrating the operations of a rotation direction error calculator, a rotation direction error detector, and a rotation direction corrector shown in FIG. 9A;

FIG. 10A is a block diagram of a quantizer included in an apparatus for encoding key value data according to a third embodiment of the present invention, and FIG. 10B is a flowchart of the operation of the quantizer according to the third embodiment of the present invention;

FIG. 11A is a block diagram of an apparatus for decoding key value data of an orientation interpolator according to a preferred embodiment of the present invention, and FIG. 11B is a flowchart of a method for decoding key value data according to a preferred embodiment of the present invention;

FIG. 12 is a diagram illustrating the structure of a bitstream input into an entropy decoder;

FIGS. 13A through 13E are diagrams illustrating examples of SDL-language program codes, by which an apparatus for decoding key value data according to the present invention are realized;

FIG. 14 is a diagram illustrating an example of a method for measuring an error between an original animation path and a restored animation path; and

FIG. 15 is a diagram for comparing the performance of a method for encoding key value data according to the present invention with the performance of a conventional method for encoding key value data.

Hereinafter, the present invention will now be described more fully with reference to the accompanying drawings, in which preferred embodiments of the invention are shown.

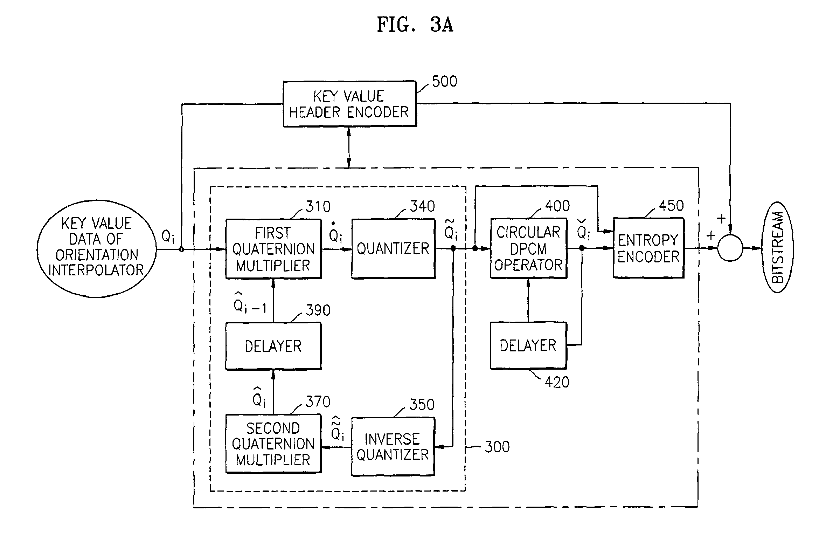

FIG. 3A is a block diagram of an apparatus for encoding key value data of an orientation interpolator node according to a first embodiment of the present invention. Referring to FIG. 3A, the apparatus for encoding key value data of an orientation interpolator node according to the first embodiment of the present invention includes a rotational DPCM operator 300, which calculates rotational differential values among rotational transformation values of an object in successive keyframes, which are obtained by applying quaternion key value data of the keyframes to their respective objects, quantizes the rotational differential values, and outputs rotational differential data, a circular DPCM operator 400, which selectively performs a linear DPCM operation and a circular DPCM operation on quantized rotational differential data, an entropy encoder 450, which entropy-encodes rotational-DPCMed or circular-DPCMed rotational differential data, and a key value header encoder 500, which encodes information necessary to decode encoded key value data of an orientation interpolator node.

The rotational DPCM operator 300 includes a first quaternion multiplier 310, which calculates a rotational differential value between a rotational transformation value of an object in a previous keyframe and a rotational transformation value of the object in a current keyframe by quaternion-multiplying the rotational transformation value of the object in the current keyframe by the rotational transformation value of the object in the previous keyframe, a quantizer 340, which generates quantized rotational differential data by non-linearly quantizing the rotational differential value input from the first quaternion multiplier 310, an inverse quantizer 350, which generates restored rotational differential data of the object in the current keyframe by inversely quantizing quantized rotational differential data, a second quaternion multiplier 370, which restores the rotational transformation value of the object in the current keyframe by quaternion-multiplying the rotational differential value of the object in the current keyframe by the rotational transformation values of the object in previous keyframes calculated by accumulating the rotational differential data, and a delayer 390, which outputs the restored rotational transformation value of the object in the current keyframe to the first quaternion multiplier 310 when a rotational transformation value of the object in a next keyframe is input.

Hereinafter, a rotational DPCM operation performed in a rotational DPCM operator according to the present invention will be described in greater detail.

In a linear DPCM method, which has been adopted in conventional MPEG-4 PMFC, a differential value between a quaternion rotational transformation value $Q_1$ ($Q_1 = (q_{1,0}, q_{i,1}, q_{1,2}, q_{1,3})$) representing rotational transformation of an object in a current keyframe (or representing the degree to which an object in a current keyframe is rotationally transformed) and a quaternion rotational transformation value $Q_2$ ($Q_2 = (q_{2,0}, q_{2,1}, q_{2,2}, q_{2,3})$) representing rotational transformation of the object in a next keyframe is calculated following Equation (4).

$$Q_{LinearDPCM} = (q_{1,0} - q_{2,0}, q_{1,1} - q_{2,1}, q_{1,2} - q_{2,2}, q_{1,3} - q_{2,3}) \qquad \cdots (4)$$

However, the linear DPCM method only calculates a differential value between quaternion components, which does not reflect any meaningful rotational differential value, i.e., an actual rotational differential value. Accordingly, the linear DPCM method cannot reduce redundancy among successive key value data to be encoded effectively. In addition, in the linear DPCM method, four components of a quaternion except for one component having the greatest value are encoded. Therefore, it is necessary to additionally encode 2-bit long information on the one component, which has not been encoded, and transmit the 2-bit long information to a decoder from an encoder.

In order to solve the above problem with the conventional linear DPCM method by reducing redundancy among successive key value data, the apparatus for encoding key value data according to the first embodiment of the present invention provides a rotational DPCM operation, in which actual rotational differential values are considered.

When $\hat{x}$ represents a reference vector representing a reference position of an object in a current keyframe, $(\hat{n}_{i-1}, \theta_{i-1})$ represents key value data when key data are equal to $k_{i-1}$, and $\hat{y}_{i-1}$ is a displacement vector of $\hat{x}$ obtained by rotationally transforming the object in the current keyframe, rotational transformation in a quaternion space can be expressed by the following equation.

$$Y_{i-1} = Q_{i-1} \times X_0 \times Q_{i-1}^* \qquad \cdots (5)$$

In Equation (5), $X_0$, $Y_{i-1}$, $Q_{i-1}$, and $Q_{i-1}^*$ represent unit quaternions of $\hat{x}$, $\hat{y}_{i-1}$, $(\hat{n}_{i-1}, \theta_{i-1})$, and $(\hat{n}_{i-1}, \theta_{i-1})^*$, respectively. In addition, $Q_{i-1}^*$ represents a quaternion complex conjugate of $Q_{i-1}$, and H represents quaternion multiplication.

In this manner, when key data are equal to $k_i$, rotational transformation in a quaternion space can be expressed by the following equation.

$$Y_i = Q_i \times X_0 \times Q_i^* \qquad \cdots (6)$$

A rotational differential value among successive rotational transformation values of successive key value data can be calculated following Equation (7).

$$Y_i = Q_i \times X_0 \times Q_i^* = Q_i \times Q_{i-1}^* \times Y_{i-1} \times Q_{i-1} \times Q_i^* = \dot{Q}_i \times Y_{i-1} \times \dot{Q}_i^* \qquad \cdots (7)$$

Accordingly, a rotational differential value can be defined by the following equation, which is derived from Equations (5) and (6).

$$\dot{Q}_i = Q_i \times Q_{i-1}^* \qquad \cdots (8)$$

In order to prevent a quantization error from affecting a next rotational differential value, the apparatus for encoding key value data according to the first embodiment of the present invention redefines the rotational differential value defined by Equation (8) using a rotational transformation value in a next keyframe and a restored rotational transformation value $\hat{Q}_{i-1}^*$ in a previous keyframe, which is shown in Equation (9).

$$\dot{Q}_i = Q_i \times \hat{Q}^*_{i-1} \qquad \cdots (9)$$

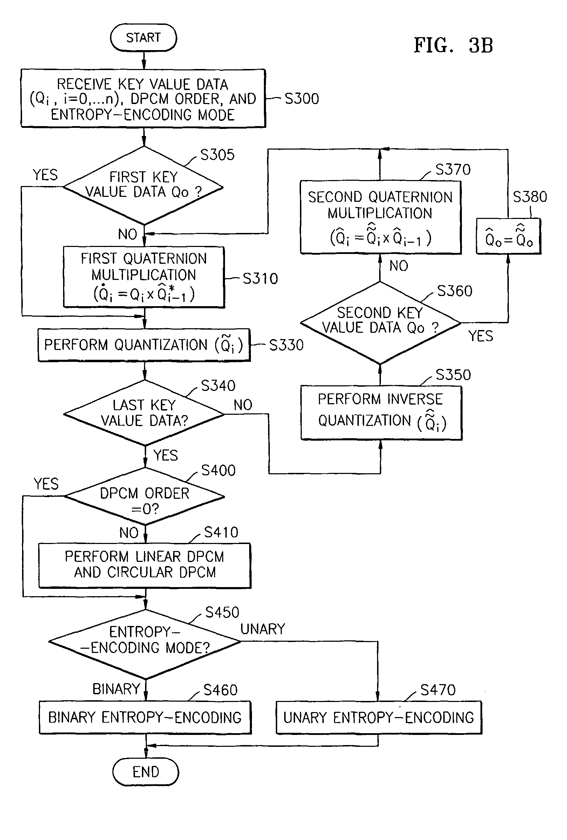

Hereinafter, a method for encoding key value data according to a preferred embodiment of the present invention will be described with reference to FIG. 3B. FIG. 3B is a flowchart of a method for encoding key value data according to a preferred embodiment of the present invention.

The apparatus for encoding key value data according to the first embodiment of the present invention receives the order of DPCM, an entropy-encoding mode, and key value data in step S300.

Next, the first quaternion multiplier 310 receives key value data $Q_i$ represented by a quaternion and checks whether or not the input key value data $Q_i$ are first key value data $Q_0$ in step S305. If the input key value data $Q_i$ are the first key value data $Q_0$, it means that there is no accumulated quaternion transformation value used for quaternion multiplication. Accordingly, the first quaternion multiplier 310 outputs the input key value data $Q_i$ to the quantizer 340. If the input key value data $Q_i$ are not the first key value data $Q_0$, the first quaternion multiplier 310 calculates a quaternion differential value $\dot{Q}_i$, which is a differential value between the key value data of the current keyframe and the restored key value data of the previous keyframe, in step S310 by quaternion-multiplying ($Q_i$ H $\hat{Q}^*_{i-1}$) the restored quaternion transformation value $\hat{Q}^*_{i-1}$ (complex conjugate of $\hat{Q}_{i-1}$) in the previous keyframe by the input key value data $Q_i$ represented by a quaternion transformation value.

The quantizer 340 receives the first key value data $Q_0$ or the quaternion rotational differential value $\dddot{Q}_i$ from the first quaternion multiplier 310 and quantizes the input using a predetermined number of quantization bits in step S330.

Since all rotational quaternion differential values are each represented by unit quaternion, a norm of a quaternion representing a rotational differential value is always 1. Therefore, a component among four components of a quaternion, which has not been encoded, can be decoded using the other three components. The apparatus for encoding key value data of an orientation interpolator node according to the first embodiment of the present invention encodes only three components among the four components of a quaternion in order to reduce the amount of data to be encoded. Accordingly, the quantizer 340 quantizes only the three components which will be encoded.

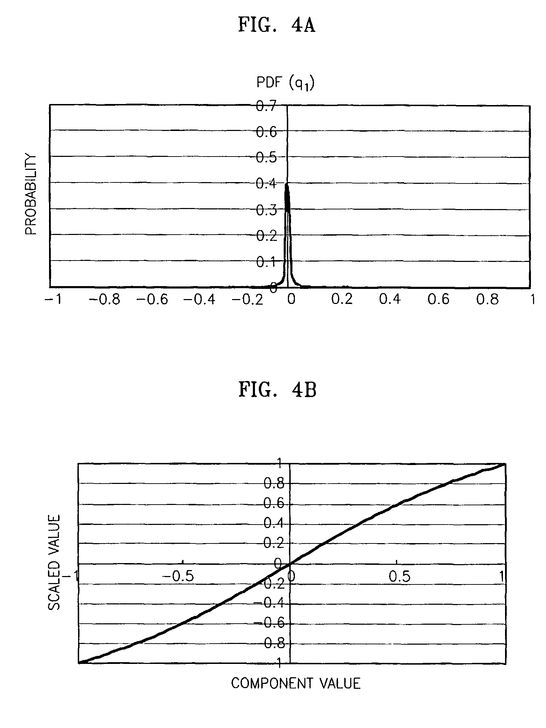

The quantizer 340 according to the present invention performs non-linear quantization rather than general linear quantization, and the reason will be described below with reference to FIG. 4A.

FIG. 4A is a diagram illustrating a typical example of a probability distribution function (PDF) in each component of a rotational differential value. As shown in FIG. 4A, component values of rotation differential values generally concentrate around 0, which is called energy compaction and means it is possible to reduce redundancy among pieces of rotation information effectively. Accordingly, in order to quantize rotational differential values, reflecting lower component values of each of the rotational differential values more sufficiently, quantization needs to be performed on the lower component values more elaborately, and that is why the quantizer 340 according to the present invention performs non-linear quantization. Here, the quantizer 340 uses an arc-tangent curve in order to allot a non-linear scale factor to each of the rotational differential values.

FIG. 4B is an arc-tangent curve used for quantization according to the present invention. As shown in FIG. 4B, the arc-tangent curve provides an appropriate resolution to higher input values and provides a much higher resolution to lower input values. The quantizer 340 quantizes a rotational differential value in step S330 using a non-linear scale function, which is shown in the following equation.

$$\tilde{q}_i = floor(q_i{'} \cdot (2^{nQBits-1} - 1) + 0.5) \qquad (q_i{'} \geq 0) \qquad \cdots (10)$$
$$= -floor(-q_i{'} \cdot (2^{nQBits-1} - 1) + 0.5) \quad (q_i{'} < 0)$$
$$(q_i{'} = \frac{4}{\pi} \cdot \tan^{-1}(\dot{q}_i), i = 1, 2, 3, -1 \leq \dot{q}_i \leq 1)$$

Here, $q_i$ represents each component of the rotational differential value input into the quantizer 340, $q_i{'}$ represents a scaled value of $q_i$, nQBits represents a predetermined number of quantization bits used for quantization, and floor(x) represents a function for converting an input value x into a maximum integer of no greater than x.

The quantizer 340 performs quantization on the input rotational differential value and then checks whether or not the quantized rotational differential data correspond to last key value data to be encoded. If the quantized rotational differential data correspond to the last key value data, the quantizer 340 outputs the quantized rotational differential data to the circular DPCM operator 400. If the quantized rotational differential data do not correspond to the last key value data, the quantizer 340 outputs the quantized rotational differential data to the inverse quantizer 350.

In step S340, the inverse quantizer 350 inversely quantizes the quantized rotational differential data input from the quantizer 340 and outputs a restored rotational differential value in step S350.

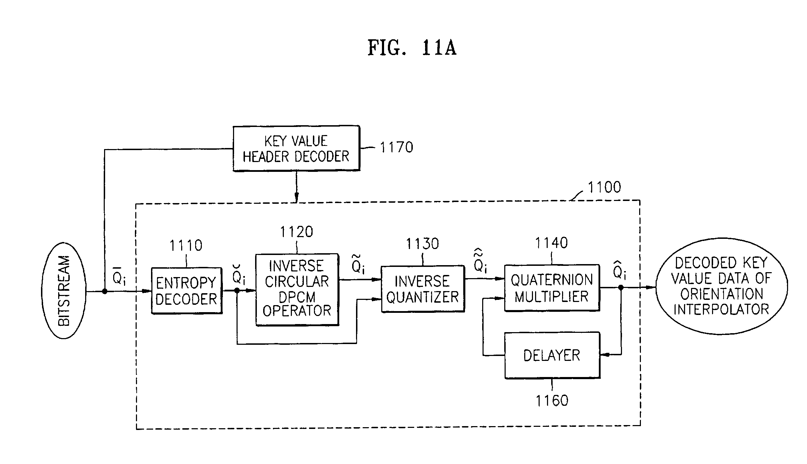

As described above, the apparatus for encoding key value data according to the first embodiment of the present invention encodes only three components of a quaternion representing a rotational differential value by quantizing the three components other than the first component. An inverse quantizer 1130 of an apparatus for decoding key value data, which is shown in FIG. 11A, and the inverse quantizer 350, which has been described above, are supposed to restore the other one, which has not been encoded, among the four components of the rotational differential value, using the three encoded components. Since all rotational differential values are each represented by a unit quaternion, the norm of a quaternion representing a rotational differential value is always 1. Therefore, it is possible to restore the first component among the four components of the rotational differential value using the following equation.

$$\hat{q}_0 = \sqrt{1 - (\hat{q}_1^2 + \hat{q}_2^2 + \hat{q}_3^2)} \quad (\hat{q}_0 \geq 0) \qquad \cdots (11)$$

In Equation (11), $\hat{q}_1$, $\hat{q}_2$, and $\hat{q}_3$ represent three restored components of a rotational differential value, and $\hat{q}_0$ represents a first component restored using the three restored components $\hat{q}_1$, $\hat{q}_2$, and $\hat{q}_3$.

In order to restore the first component $\hat{q}_0$ following Equation (11), the first component $\hat{q}_0$ must have a positive value, and this condition can be satisfied by taking advantage of the characteristics of a quaternion, which appear when applying a quaternion to rotational transformation of an object in a 3D space and are shown in Equation (12).

$$Y = Q \times X \times Q^* = (-Q) \times X \times (-Q)^* \qquad \cdots (12)$$

Equation (12) shows that rotational transformation values Q and -Q are the same in terms of their functions when applying rotational transformation to an object in a 3D space. Accordingly, if the first component of a rotational differential value in the apparatus for encoding key value data according to the first embodiment of the present invention has a negative value, the rotational differential value can be easily converted into a positive number by multiplying each of the components of the rotational differential value by -1. In this case, however, the sum of the square of each of the components of a restored rotational differential value except for the first component may exceed 1 due to a quantization error. In this case, $\hat{q}_0$ cannot be determined by Equation (11) and is considered a value which is close to 0 and is smaller than a minimum value which can be quantized by the quantizer 340. The fact that $\hat{q}_0$ has such a value means that the object has been rotationally transformed by as much as about 180 degrees. Accordingly, an apparatus for decoding key value data needs a method for determining $\hat{q}_0$ while minimizing the effect of the restored first component value $\hat{q}_0$ on the three restored component values $\hat{q}_1$, $\hat{q}_2$, and $\hat{q}_3$, and the method will be also applied to the inverse quantizer 350 of the apparatus for encoding key value data according to the first embodiment of the present invention. For example, the minimum value which can be quantized by the quantizer 340 and the minimum value multiplied by a predetermined integer may be determined as $\hat{q}_0$. The following equation may be used to determine $\hat{q}_0$.

$$\hat{q}_0 = a \cdot 2^{-m} \qquad \cdots (13)$$

In Equation (13), 'a' represents an arbitrary constant, and m represents a predetermined number of quantization bits.

While 2-bit long information on each key value data is required for decoding in the conventional MPEG-4 BIFS PMFC method, the 2-bit long information is not necessary in the present invention, and thus the number of bits to be encoded can be decreased by as much as 2N when encoding N key value data.

The restored rotational differential value output from the inverse quantizer 350 is input into the second quaternion multiplier 370, and the second quaternion multiplier 370 checks if an input keyframe is a first keyframe to be encoded in step S360. If the input keyframe is the first keyframe to be encoded, the second quaternion multiplier 370 accumulates the restored rotational transformation value of the first keyframe input from the inverse quantizer 350 $(\hat{Q}_0 = \hat{\tilde{Q}}_0)$ and outputs the accumulated value to the delayer 390 in step S380.

If the input keyframe is the first keyframe to be encoded, the second quaternion multiplier 370 restores a rotational transformation value $\hat{Q}_i$ of a current keyframe in step S370 by quaternion-multiplying a rotational differential value $\hat{\tilde{Q}}_i$ of the current keyframe and a restored rotational transformation value $\hat{Q}_{i-1}$ of a previous keyframe

$$(\hat{Q}_i = \hat{\tilde{Q}}_i \times \hat{Q}_{i-1}).$$

The second quaternion multiplier 370 outputs the restored rotational transformation value $\hat{Q}_i$ of the current keyframe to the delayer 390, and then the delayer 390 keeps $\hat{Q}_i$ until a rotational transformation value of a next keyframe is input so that $\hat{Q}_{i-1}$ can be the same as $\hat{Q}_{i-1}$ and then outputs $\hat{Q}_{i-1}$ to the first quaternion multiplier 310.

When a rotational transformation value $Q_i$ of a current keyframe is input into the first quaternion multiplier 310, the first quaternion multiplier 310 also receives the restored rotational transformation value $\hat{Q}_{i-1}$ of a previous keyframe from the delayer 390 and generates a rotational differential value $\dot{Q}_i$ between the rotational transformation value of the current keyframe and the restored rotational transformation value of the previous keyframe in step S310 by quaternion-multiplying the restored quaternion transformation value $\hat{Q}^*_{i-1}$ in the previous keyframe by $Q_i$. $(Q_i \text{ H } \hat{Q}^*_{i-1})$.

The generated rotational differential value is output to the quantizer 340 and then is quantized by the quantizer 340 in step S330, as described above. The quantizer 340 outputs rotational differential data generated by quantizing a rotational differential value to the circular DPCM operator 400 in step S340 if the input rotational differential value correspond to the last key value data.

The circular DPCM operator 400 checks if the order of DPCM of the quantized rotational differential data input from the quantizer 340 is 0. If the order of DPCM is 0, the circular DPCM operator 400 outputs the quantized rotational differential data to the entropy encoder 450 in step S400 without performing a linear DPCM operation and a circular DPCM operation. If the order of DPCM is not 0, the circular DPCM operator 400 performs a linear DPCM operation and a circular DPCM operation on the quantized rotational differential data in step S410.

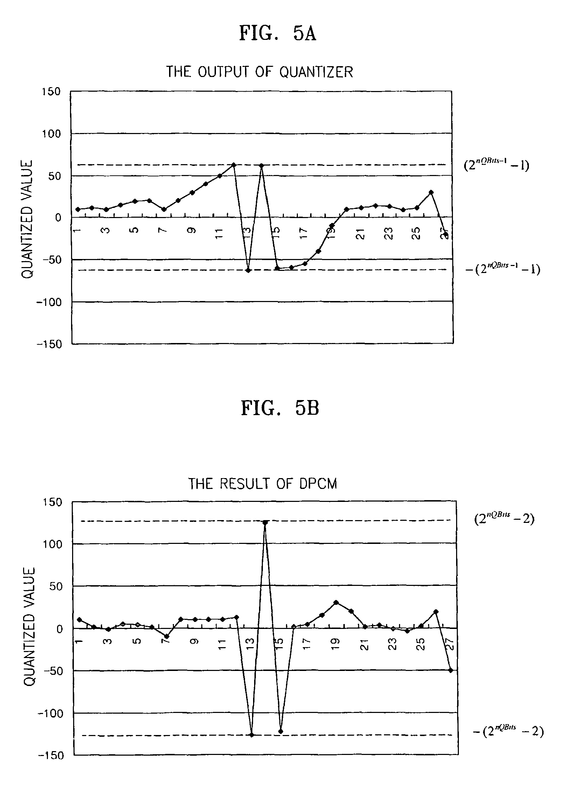

FIG. 5A is a diagram illustrating an example of differential data output from the quantizer 340, and FIG. 5B is a diagram illustrating the results of performing a linear DPCM operation on the differential data output from the quantizer 340.

As shown in FIG. 5B, as a result of a linear DPCM operation, the range of differential data to be encoded can be increased two times larger than it used to be. The purpose of the performance of the circular DPCM operation is to maintain the range of differential data within the range of quantized differential data.

The circular DPCM operation is performed on the assumption that a maximum value and a minimum value in a quantization range are circularly connected to each other. Accordingly, if differential data, which are the results of performing linear DPCM on two consecutive quantized data, are greater than half of the maximum value in the quantization range, they can be represented by smaller values by subtracting the maximum value from the differential data.

If the differential data are smaller than half of the minimum value in the quantization range, they can be represented by smaller values even more by adding the maximum value in the quantization range to the differential data.

When $\tilde{Q}_i$ and $\tilde{Q}_{i-1}$ represent quantized rotational differential data at two successive moments of time $t_i$ and $t_{i-1}$, respectively, a linear DPCM operation is performed on the two successive quantized rotational differential data $\tilde{Q}_i$ and $\tilde{Q}_{i-1}$ following Equation (14).

$$X_i = \tilde{Q}_i - \tilde{Q}_{i-1} = (\tilde{q}_{i,1} - \tilde{q}_{i-1,1}, \tilde{q}_{i,2} - \tilde{q}_{i-1,2}, \tilde{q}_{i,3} - \tilde{q}_{i-1,3})^T \qquad \cdots (14)$$

In addition, a circular DPCM operation is performed on the differential data obtained following Equation (14), following Equation (15).

$$\check{Q}_i = \min(|X_i|, |X'_i|) \qquad \cdots (15)$$
$$X'_i = X_i - (2^{nQBits} - 1) \quad (if \ X_i \geq 0)$$
$$X'_i = X_i + (2^{nQBits} - 1) \quad (otherwise)$$

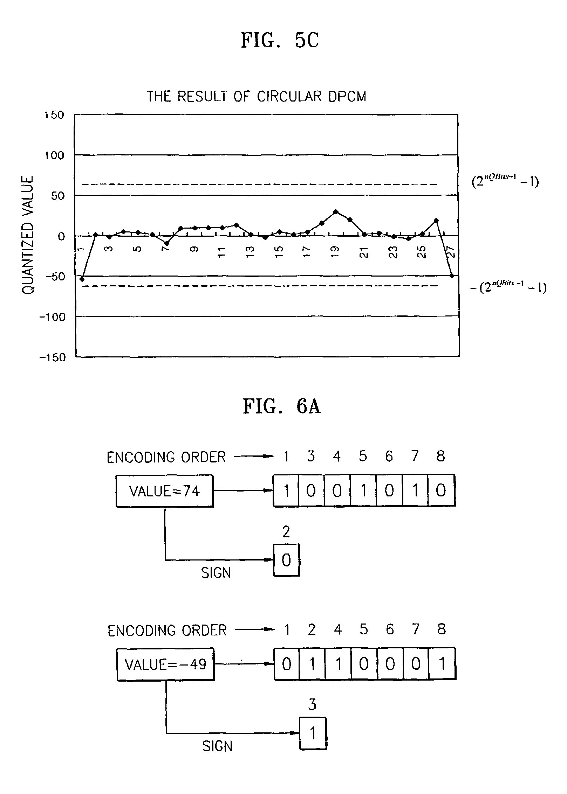

In Equation (15), nQBits represents a predetermined number of quantization bits. FIG. 5C is a diagram illustrating the results of performing a circular DPCM operation on the DPCMed differential data shown in FIG. 5B. As shown in FIG. 5C, the range of the circular-DPCMed differential data is much smaller than the range of the linear-DPCMed differential data.

The entropy encoder 450 receives the rotational differential data or the circular-DPCMed rotational differential data from the circular DPCM operator 400 depending on the order of DPCM of the rotational differential data and then encodes the input differential data by removing bit redundancy.

Referring to FIG. 3B again, the entropy encoder 450 checks an entropy encoding mode in step S450.

If the entropy encoding mode is a binary entropy encoding mode, the entropy encoder 450 encodes the input differential data using a function SignedAAC() in step S460. If the entropy encoding mode is a unary entropy encoding mode, the entropy encoder 450 encodes the input differential data using a function UnaryAAC() in step S470.

The function SignedAAC() is used to encode differential data using an adaptive binary arithmetic encoder, which encodes the sign and magnitude of the differential data on each bit plane.

FIG. 6A is a diagram illustrating an example of the function SignedAAC(). Referring to FIG. 6A, when an input value is 74 and the number of bits required for encoding the input value is 8, the sign of the input value is 0 and a binary number representing the input number is 1001010. Signs and all bit planes are encoded in the following way:

First step: a binary number is encoded on every bit plane in an order of from its most significant bit (MSB) to its least significant bit (LSB);
Second step: it is checked if the bit, which is currently being encoded, is 0;
Third step: if the bit currently being encoded is not 0, the sign of the binary number is encoded next; and
Fourth step: the remaining bits of the binary number are encoded.

The function Unary AAC() converts a value to be encoded into a predetermined number of bits, which consist of a series of 0s, a flag bit 1 indicating that the series of zeros end, and one bit representing the sign of the value. Here, the number of zeros corresponds to the magnitude of the value.

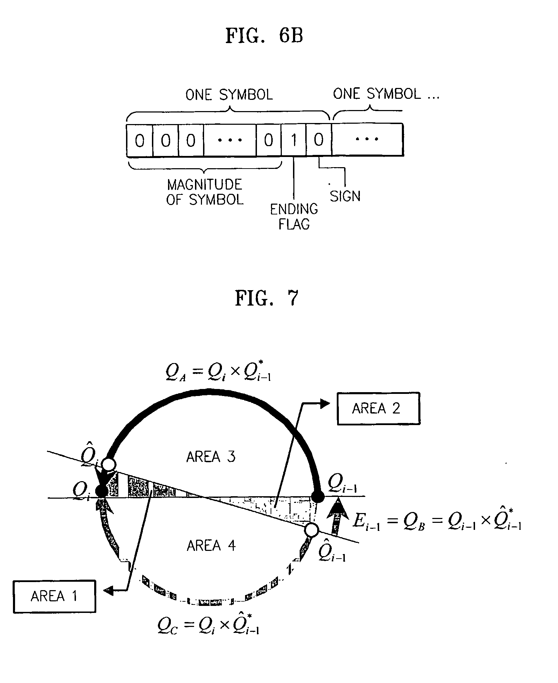

The function Unary AAC() will be described more fully in the following with reference to FIG. 6B. For example, 256 is encoded into a series of bits consisting of two hundred fifty six 0s, 1 which is a flag bit indicating the series of 0s ends, and 0 which represents the sign of 256, i.e., a plus sign by the function Unary AAC(). Due to Unary AAC(), redundancy among the bits representing the symbol to be encoded increases, which enhances the efficiency of encoding the symbol.

Hereinafter, an apparatus for encoding key value data according to a second embodiment of the present invention will be described. The apparatus for encoding key value data according to the second embodiment of the present invention includes a means for correcting a rotation direction error occurring during quantization as well as all the elements of the apparatus for encoding key value data according to the first embodiment of the present invention.

FIG. 7 is a diagram illustrating a rotation direction error generated during encoding quaternion rotational transformation values using rotational differential values. The rotation direction error occurs because the quaternion encoding method performed in the apparatus for encoding key value data according to the present invention is a loss encoding method.

In FIG. 7, when $Q_i$, $Q_{i-1}$, $\hat{Q}_i$, and $\hat{Q}_{i-1}$ represent a rotational transformation value currently being applied to an object in an i-th keyframe, a rotational transformation value applied to the object in a previous keyframe, a value restored from $Q_i$, and a value restored from $Q_{i-1}$, respectively, the locations of the object rotated by rotational transformations respectively applied by $Q_i$, $Q_{i-1}$, $\hat{Q}_i$, and $\hat{Q}_{i-1}$, may be represented by four different areas, as shown in FIG. 7.

In other words, if the object rotates from $Q_{i-1}$ to $Q_i$ along a shortest arc so that the object is located in area 1 and area 3 after rotating by $Q_i$ and $Q_{i-1}$, the object is considered to have rotated from $Q_{i-1}$ to $Q_i$ counterclockwise. Meanwhile, if the object rotates from $Q_{i-1}$ to $Q_i$ along a shortest way so that the object is located in area 2 and area 4 after rotating by $Q_{i-1}$ and $Q_i$, the object is considered to have rotated from $Q_{i-1}$ to $Q_i$ clockwise.

On the other hand, if the object rotates following rotation information which has been encoded and then decoded, an apparatus for decoding key value data rotates the object using $\hat{Q}_i$ and $\hat{Q}_{i-1}$ corresponding to $Q_i$ and $Q_{i-1}$, respectively. Accordingly, if the relative location of the object rotated by $\hat{Q}_i$ with respect to the location of the object rotated by $\hat{Q}_{i-1}$ is area 2 or 3 $\hat{Q}_{i-1}$, the object rotates counterclockwise. If the relative location of the object rotated by $\hat{Q}_i$ with respect to the location of the object rotated by $\hat{Q}_{i-1}$ is area 1 or 4, the object rotates clockwise. In areas 1 and 2, the rotation direction of the object when using an original rotational transformation value may be opposite to the rotation direction of the object when using a decoded rotational transformation value, because $Q_i$ and $\hat{Q}_i$ are different due to loss encoding, which is performed to encode quaternion rotational transformation values. In order to solve this problem, it is required to minimize the degree to which the object rotates in a wrong direction, which is opposite to a desired direction, or to correct the rotation direction of the object when the object rotates in a wrong direction so that the object rotate in a desired direction. In the present invention, the method for correcting the rotation direction of the object so as to make the object rotate in a desired direction is adopted.

Referring to FIG. 7 again, the concept of correction of a rotation direction error according to the present invention will be described briefly in the following. If a rotation direction error, like the phenomenon occurring in areas 1 and 2, is detected, quaternion rotational differential values to be encoded are controlled so as to rotate in a right direction, in which case the inconsistency in rotation directions still occurs in area 2. However, in area 2, unlike in area 1, differences between original quaternion values and restored quaternion values are relatively small. Accordingly, rotation direction correction according to the second embodiment of the present invention is performed on only area 1.

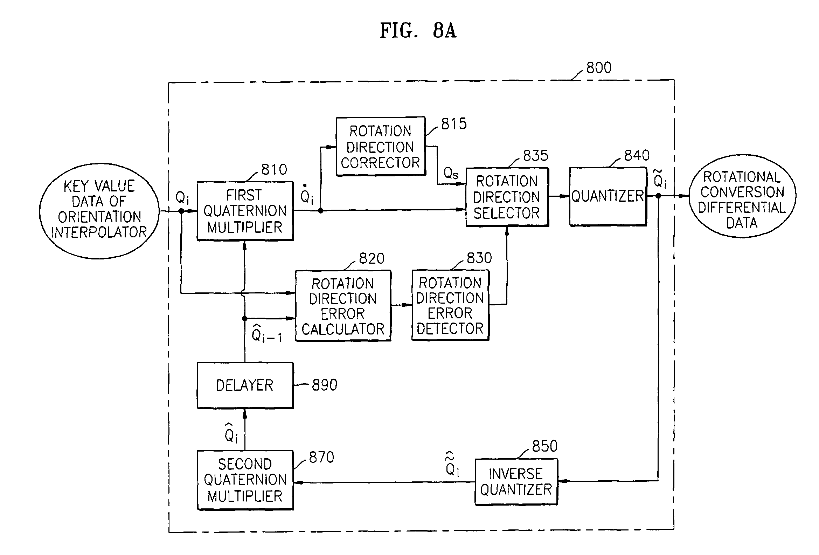

Hereinafter, the apparatus for encoding key value data, which performs rotation direction correction, according to the second embodiment of the present invention will be described with reference to FIGS. 8A through 9B. The apparatus for encoding key value data according to the second embodiment of the present invention has almost the same structure as the apparatus for encoding key value data according to the first embodiment of the present invention. The only difference between them is the structure of a rotational DPCM operator, and thus only the structure of a rotational DPCM operator in the apparatus for encoding key value data according to the second embodiment of the present invention will described in the following.

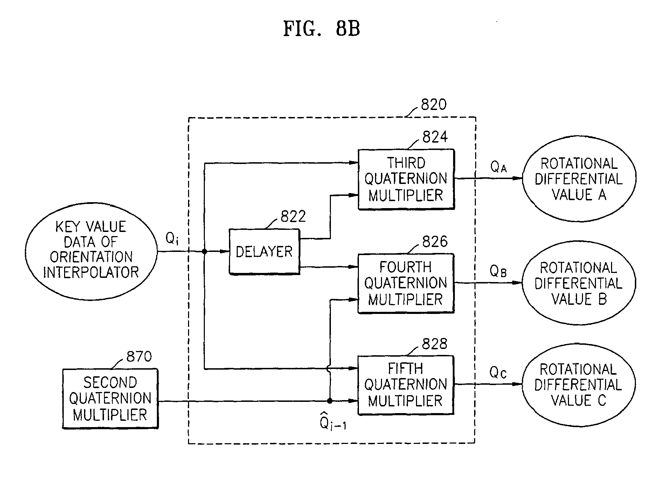

FIG. 8A is a block diagram of a rotational DPCM operator 800 according to the second embodiment of the present invention, and FIG. 8B is a block diagram of a rotation direction error calculator 820 shown in FIG. 8A.

Referring to FIG. 8A, the rotational DPCM operator 800 includes a rotation direction error calculator 820, which receives a rotational transformation value of an object in a current keyframe and a restored rotational transformation value of the object in a previous keyframe and calculates rotation direction errors, a rotation direction error detector 830, which detects based on the rotation direction errors input from the rotation direction error calculator 820 whether or not an error sufficient to change the rotation direction of the object has occurred during decoding, a rotation direction corrector 815, which corrects and outputs a rotational differential value input from the first quaternion multiplier 810 so that the object, which is located already rotated following a decoded rotational transformation value of the previous keyframe, can rotate further by as much as 180 degrees in an original rotation direction, and a rotation direction selector 835, which selects the rotational differential value input from the rotation direction corrector 815 or the rotational differential value input from the first quaternion multiplier 810 depending on a value input from the rotation direction error detector 830 and outputs the selected value to the quantizer 840.

Referring to FIG. 8B, the rotation direction error calculator 820 shown in FIG. 8A includes a delayer 822, which stores an input rotational transformation value until a rotational transformation value of a next keyframe is input, a third quaternion multiplier 824, which receives the input rotational transformation value and a rotational transformation value of a previous keyframe output from the delayer 822 and calculates a rotational differential value between the input rotational transformation value and the rotational transformation value of the previous keyframe by quaternion multiplication, a fourth quaternion multiplier 826, which calculates a rotational differential value between the rotational transformation value of the previous keyframe output from the delayer 822 and the restored rotational transformation value of the previous keyframe, and a fifth quaternion multiplier 828, which calculates between the input rotational transformation value and the restored rotational transformation value of the previous keyframe.

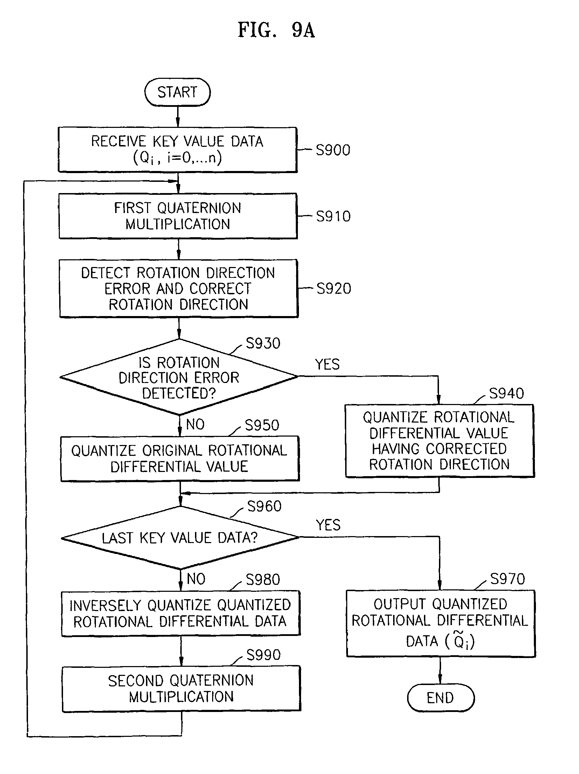

Hereinafter, a rotational DPCM operation according to a second embodiment of the present invention will be described in greater detail with reference to FIG. 9A.

Key value data $Q_i$ of an orientation interpolator node, which are about to be encoded, are input into the first quaternion multiplier 810 and the rotation direction error calculator 820 of the rotational DPCM operator 800 in step S900.

The first quaternion multiplier 810, like the first quaternion multiplier in the apparatus for encoding key value data according to the first embodiment of the present invention, generates a rotational differential value $\dot{Q}_i$ by quaternion-multiplying $(Q_i \times \hat{Q}^*_{i-1})$ an input rotational transformation value of a current keyframe by a restored rotational transformation value of a previous keyframe input from the second quaternion multiplier 870 and outputs the generated rotational differential value $\dot{Q}_i$ to the rotation direction corrector 815 and the rotation direction selector 835 in step S910.

The rotation direction corrector 815 corrects a rotational differential value input thereinto following Equation (16) and outputs the corrected rotational differential value $Q_s$ to the rotation direction selector 835. The rotation direction error calculator 820 receives the rotational transformation value $Q_i$ of the current keyframe and the restored rotational transformation value $\hat{Q}_{i-1}$ of the previous keyframe input from the second quaternion multiplier 870 and calculates rotational transformation values $Q_A$, $Q_B$, and $Q_C$, which will be described later. The rotation direction error detector 830 detects using the rotational differential value input from the rotation direction error calculator 820 whether or not a rotation direction error has occurred and outputs the result of the detection to the rotation direction selector 835 in step S920.

$$Q_s = \begin{pmatrix} |\delta_T| \\ -\dfrac{1}{\sqrt{(\dot{q}_{R,1})^2 + (\dot{q}_{R,2})^2 + (\dot{q}_{R,3})^2}}\,\dot{q}_{R,1} \\ -\dfrac{1}{\sqrt{(\dot{q}_{R,1})^2 + (\dot{q}_{R,2})^2 + (\dot{q}_{R,3})^2}}\,\dot{q}_{R,2} \\ -\dfrac{1}{\sqrt{(\dot{q}_{R,1})^2 + (\dot{q}_{R,2})^2 + (\dot{q}_{R,3})^2}}\,\dot{q}_{R,3} \end{pmatrix} \quad \cdots (16)$$

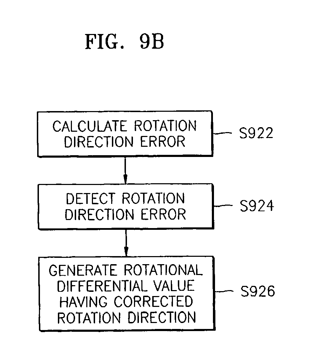

In Equation (16), $\delta_T$ represents a constant very close to 0, and $(\dot{q}_{R,0}, \dot{q}_{R,1}, \dot{q}_{R,2}, \dot{q}_{R,3})^T$ represents the rotational differential value $\dot{Q}_i$ output from the first quaternion multiplier 810. The rotation direction error calculator 820, the rotation direction error detector 830, and the rotation direction corrector 815 will be described later with reference to FIG. 9B.

The rotation direction selector 835 checks whether or not a rotation direction error has occurred so that the object rotates in the opposite direction to a desired direction when decoding an encoded key value data using a logic value input from the rotation direction error detector 830. If a rotation direction error has not occurred, the rotation direction selector 835 outputs the rotation differential value input from the first quaternion multiplier 810 to the quantizer 840 in step S930. If a rotation direction error has occurred, the rotation direction selector 835 outputs the corrected rotational differential value input from the rotation direction corrector 815 in step S930.

The quantizer 840 quantizes the original rotational differential data $Q_i$ or the corrected rotational differential data $Q_s$ in steps S940 and 950 in the same quantization method as in the first embodiment of the present invention.

The quantizer 840 checks whether or not quantized rotational differential data $\tilde{Q}_i$ belong to the last key value data in step S960. If the quantized rotational differential data $\tilde{Q}_i$ correspond to the last key value data, the quantizer 840 outputs the quantized rotational differential data $\tilde{Q}_i$ to a circular DPCM operator 400 in step S970. If the quantized rotational differential data $\tilde{Q}_i$ do not correspond to the last key value data, the quantizer 840 outputs the quantized rotational differential data $\tilde{Q}_i$ to the inverse quantizer 850.

The inverse quantizer 850 inversely quantizes the quantized rotational differential data $\tilde{Q}_i$ in the same inverse quantization method as in the first embodiment of the present invention and outputs restored rotational differential data

$\hat{\tilde{Q}}_i$   to the second quaternion multiplier 870 in step S980.

The second quaternion multiplier 870 generates a restored rotational conersion value $\hat{Q}_i$ of a current keyframe by quaternion-multiplying the restored rotational differential value   $\hat{\tilde{Q}}_i$   by a rotational transformation value $\hat{Q}_{i-1}$ of a previous keyframe. The second quaternion multiplier 870 outputs a rotational transformation value of a current keyframe to the first quaternion multiplier 810 and the rotation direction error calculator 820 via the delayer 890 in step S990.

Hereinafter, the operations of the rotation direction error calculator 820, the rotation direction error detector 830, and the rotation direction corrector 815 will be described with reference to FIG. 9B.

The rotation direction error calculator 820 calculates rotational differential values corresponding to areas 2 through 4, which have been described above with reference to FIG. 7.

The rotation direction error calculator 820 receives a rotation transformation value, which corresponds to key value data of a keyframe to be encoded, receives a restored rotational transformation value of a previous keyframe prior to the current keyframe, and calculates a rotation direction error in step S922.

The rotational transformation value corresponding to the key value data of an orientation interpolator of the current keyframe are directly input into the third quaternion multiplier 824 and the fifth quaternion multiplier 828 and are input into the fourth quaternion multiplier 826 via the delayer 822 when a rotational transformation value of a next keyframe is input. In addition, the restored rotational transformation value of the previous keyframe output from the second quaternion multiplier 870 is input into the fourth quaternion multiplier 826 and the fifth quaternion multiplier 828.

The third quaternion multiplier 824 generates the rotational differential value $Q_A$ by quaternion-multiplying ($Q_A = Q_i \times Q^*_{i-1}$) the rotational transformation value of the current keyframe by the rotational transformation value of the previous keyframe and outputs $Q_A$ to the rotation direction error detector 830. The rotational differential value $Q_A$ represents an original rotation direction of an object during a time interval [$t_{i-1}$, $t_i$].

The fourth quaternion multiplier 826 generates the rotational differential value $Q_B$ by quaternion-multiplying ($Q_B = Q_{i-1} \times \hat{Q}^*_{i-1}$) the rotational transformation value of the previous keyframe by the restored rotational transformation value of the previous keyframe and outputs $Q_B$ to the rotation direction error detector 830. The rotational differential value $Q_B$ calculated by the fourth quaternion multiplier 826 represents the rotation direction error and rotation direction of an object, which are affected by a quantization error, at a predetermined moment of time $t_{i-1}$ and corresponds to area 2 shown in FIG. 7.

The fifth quaternion multiplier 828 generates the rotational differential value $Q_C$ by quaternion-multiplying ($Q_C = Q_i \times \hat{Q}^*_{i-1}$) the rotational transformation value of the current keyframe by the restored rotational transformation value of the previous keyframe and outputs $Q_C$ to the rotation direction error detector 830. The rotational differential value $Q_C$ calculated by the fifth quaternion multiplier 828 represents a rotational differential value to be encoded at the predetermined moment of time $t_i$ and corresponds to area 4 shown in FIG. 7.

The rotation direction error detector 830 checks using the rotational differential values $Q_A$, $Q_B$, and $Q_C$ input from the rotation direction error calculator 820 whether or not the object rotates in an opposition direction to an original direction in the process of decoding encoded key value data in step S924. For doing this, the rotation direction error detector 830 checks whether or not the rotational differential values $Q_A$, $Q_B$, and $Q_C$ satisfy Inequalities (17) through (21). First of all, the rotation direction error detector 830 checks if the rotational differential values $Q_A$ and $Q_C$ satisfy Inequality (17).

$$\begin{pmatrix} q_{A,1} \\ q_{A,2} \\ q_{A,3} \end{pmatrix} \cdot \begin{pmatrix} q_{C,1} \\ q_{C,2} \\ q_{C,3} \end{pmatrix} < 0 \qquad \cdots (17)$$

In Inequality (17), when the rotational differential value $Q_A$ input from the rotation direction error calculator 820 is expressed by $Q_A = (q_{A,0}, q_{A,1}, q_{A,2}, q_{A,3})^T$, $\begin{pmatrix} q_{A,1} \\ q_{A,2} \\ q_{A,3} \end{pmatrix}$ represents a three-dimensional vector $(q_{A,1}, q_{A,2}, q_{A,3})^T$ consisting of the four components $q_{A,0}$, $q_{A,1}$, $q_{A,2}$, and $q_{A,3}$ of $Q_A$ except for the first component $q_{A,0}$. $\begin{pmatrix} q_{C,1} \\ q_{C,2} \\ q_{C,3} \end{pmatrix}$ represents a three-

dimensional vector $(q_{C,1}, q_{C,2}, q_{C,3})^T$ consisting of the four components $q_{C,0}$, $q_{C,1}$, $q_{C,2}$, and $q_{C,3}$ of $Q_C$ except for the first component $q_{C,0}$. Inequality (17) shows a condition that a inner product of the two 3D vectors $(q_{A,1}, q_{A,2}, q_{A,3})^T$ and $(q_{C,1}, q_{C,2}, q_{C,3})^T$ is smaller than 0.

If the inner product in Inequality (17) is smaller than 0, the rotation direction of an object when using $Q_A$ is opposite to the rotation direction of the object when using $Q_C$. When the inner product is smaller than 0, a value of a logic expression shown in Inequality (17) is set as 'true'. When the inner product is greater than 0, the value of the logic expression is set as 'false'.

$$\begin{pmatrix} q_{B,1} \\ q_{B,2} \\ q_{B,3} \end{pmatrix} \cdot \begin{pmatrix} q_{C,1} \\ q_{C,2} \\ q_{C,3} \end{pmatrix} < 0 \qquad \cdots(18)$$

In Inequality (18), when the rotational differential value $Q_B$ input from the rotation direction error calculator 820 is expressed by $Q_B = (q_{B,0}, q_{B,1}, q_{B,2}, q_{B,3})^T$, $\begin{pmatrix} q_{B,1} \\ q_{B,2} \\ q_{B,3} \end{pmatrix}$ represents a three-dimensional vector $(q_{B,1}, q_{B,2}, q_{B,3})^T$ consisting of the four components $q_{B,0}$, $q_{B,1}$, $q_{B,2}$, and $q_{B,3}$ of $Q_B$ except for the first component $q_{B,0}$. $\begin{pmatrix} q_{C,1} \\ q_{C,2} \\ q_{C,3} \end{pmatrix}$ represents a three-dimensional vector $(q_{C,1}, q_{C,2}, q_{C,3})^T$ consisting of the four components $q_{C,0}$, $q_{C,1}$, $q_{C,2}$, and $q_{C,3}$ of $Q_C$ except for the first component $q_{C,0}$. Inequality (18) shows a condition that a inner product of the two 3D vectors $(q_{B,1}, q_{B,2}, q_{B,3})^T$ and $(q_{C,1}, q_{C,2}, q_{C,3})^T$ is smaller than 0.

If the inner product of in Inequality (18) is smaller than 0, the rotation direction of an object when using $Q_B$ is opposite to the rotation direction of the object when using $Q_C$. When the inner product is smaller than 0, a value of a logic expression shown in Inequality (18) is set as 'true'. When the inner product is greater than 0, the value of the logic expression is set as 'false'.

$$A_{TH} < 2\cos^{-1}\left|q_{A,0}\right| \qquad \cdots(19)$$

In Inequality (19), $q_{A,0}$ represents the first component of the rotational differential value $Q_A$, and $A_{TH}$ is set to a predetermined constant close to 0. When in Inequality (19), $2\cos^{-1}|q_{A,0}|$ is greater than $A_{TH}$, a value of a logic expression shown in Inequality (19) is defined as 'true'. When $2\cos^{-1}|q_{A,0}|$ is not greater than $A_{TH}$, the value of the logic expression is defined as 'false'. When Inequality (19) is set as 'false', it means that a rotation angle $\theta$ $(=2\cos^{-1}|q_{A,0}|)$ smaller than the predetermined constant $A_{TH}$ can be ignored when realizing an apparatus for encoding key value data according to the present invention. Even though there exists as much a rotation direction error as the rotation angle 0, the rotation direction error does not cause severely distorted images to human eyes, especially when using an error measurement method proposed by the present invention.

$$A_{TH} < 2\cos^{-1}\left|q_{B,0}\right| \qquad \cdots(20)$$

In Inequality (20), $q_{B,0}$ represents the first component of the rotational differential value $Q_B$, and $A_{TH}$ is the same as the corresponding one in Inequality (19). When in Inequality (20), $2\cos^{-1}|q_{B,0}|$ is greater than $A_{TH}$, a value of a logic expression shown in Inequality (20) is defined as 'true'. When $2\cos^{-1}|q_{B,0}|$ is not greater than $A_{TH}$, the value of the logic expression is defined as 'false'.

$$A_{TH} < 2\cos^{-1}\left|q_{C,0}\right| \qquad \cdots(21)$$

In Inequality (21), $q_{C,0}$ represents the first component of the rotational differential value $Q_C$, and $A_{TH}$ is the same as the corresponding one in Inequality (19). When in Inequality (21), $2\cos^{-1}|q_{C,0}|$ is greater than $A_{TH}$, a value of a logic expression shown in Inequality (21) is defined as 'true'. When $2\cos^{-1}|q_{C,0}|$ is not greater than $A_{TH}$, the value of the logic expression is defined as 'false'.

The rotation direction error detector 830 performs an AND operation on the logic values of Inequalities (17) through (21) and outputs the result of the AND operation to the rotation direction selector 835.

The first quaternion multiplier 810 has two input values $Q_i$ and $\hat{Q}_{i-1}$ at a predetermined moment of time t. The first quaternion multiplier 810 outputs a rotational differential value using the two input values $Q_i$ and $\hat{Q}_{i-1}$. As described above, in area 1, the apparatus for decoding encoded key value data, which receives rotational differential data, rotates an object clockwise. However, the object must rotate from a place where it is currently located after rotating by predetermined degrees indicated by $Q_{i-1}$ to a place where it is supposed to be located after rotating by predetermined degrees indicated by $Q_i$, and thus the original rotation direction of the object must be a counterclockwise direction.

Accordingly, the rotation direction corrector 815 corrects the rotation direction of the object so that the object can rotate by as much as a rotation angle indicated by $\hat{Q}_{i-1}$ in the same direction as it has rotated based on $Q_i$, as shown in FIG. 7, i.e., so that the object can rotate counterclockwise from the place where it is currently located after rotating based on $\hat{Q}_{i-1}$ to the place where it is supposed to be located after rotating by as much as a rotation angle indicated by $Q_i$.

For doing this, the rotation direction corrector 815 sets up new rotation information to make the object rotate counterclockwise by as much as 180 degrees from a place where it is currently located after rotating by predetermined degrees following $\hat{Q}_{i-1}$. Accordingly, the rotation direction of the object is corrected to be the same as the original one, and a rotation direction error can be minimized. The rotation direction corrector 815 receives the rotational differential data $\dot{Q}_i$ of the current keyframe from the first quaternion multiplier 810, generates rotational differential data having a corrected rotation direction, and outputs the corrected rotational differential data to the rotation direction selector 835 in step S926.

Referring to FIG. 9A, the rotation direction selector 835 checks if the logic values input from the rotation direction error detector 830 are true in step S930. If the input logic values are true, the rotation direction selector 835 determines that the same phenomenon as has occurred in area 1 shown in FIG. 7 has occurred and outputs the corrected rotational differential value $Q_s$ defined by Equation (16) to the quantizer 840 in step S940.

On the other hand, if the input logic values are false, the rotation direction selector 835 determines that the same phenomenon as has occurred in area 1 has not occurred and outputs the rotational differential value $\dot{Q}_i$ input from the first quaternion multiplier 810 to the quantizer 840 in step S950.

Hereinafter, an apparatus for encoding key value data according to a third embodiment of the present invention will be described.

Since the apparatuses for encoding key value data according to the first and second embodiments of the present invention encodes only three components among the four components of a rotational differential value, they may not be able to restore a first component value of the quaternion using Equation (11) because of a quantization error. For example, a first component of a restored rotational differential value may be an imaginary number.

In order to prevent the problem with encoding only three components of a quaternion, the apparatus for encoding key value data according to the third embodiment of the present invention includes a quantizer, which can appropriately adjust three quantized component values so that when decoding encoded key value data, the other component can be restored into a positive real number and distortion of images can be minimized.

The apparatus for encoding key value data according to the third embodiment of the present invention is the same as the apparatuses for encoding key value data according to the first or second embodiments of the present invention except for the structure of a quantizer, and thus only the structure of the quantizer will be described in the following.

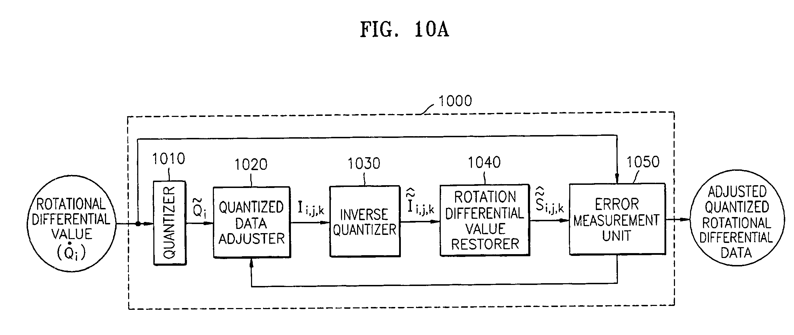

FIG. 10A is a block diagram of a quantizer included in an apparatus for encoding key value data according to the third embodiment of the present invention. Referring to FIG. 10A, a quantizer 1000 includes a quantization unit 1010, which quantizes a rotational differential value input thereinto, a quantization data adjustor 1020, which adjusts a quantized rotational differential value, an inverse quantizer 1030, which inversely quantizes quantized rotational differential data, a rotational differential value restorer 1040, which restores all component values of quantized rotational differential data by restoring a first component of the quantized rotational differential data using the inversely quantized components, and an error measurement unit 1050, which measures an error between a restored differential value and an originally input rotational differential value and renews quantized rotational differential data.

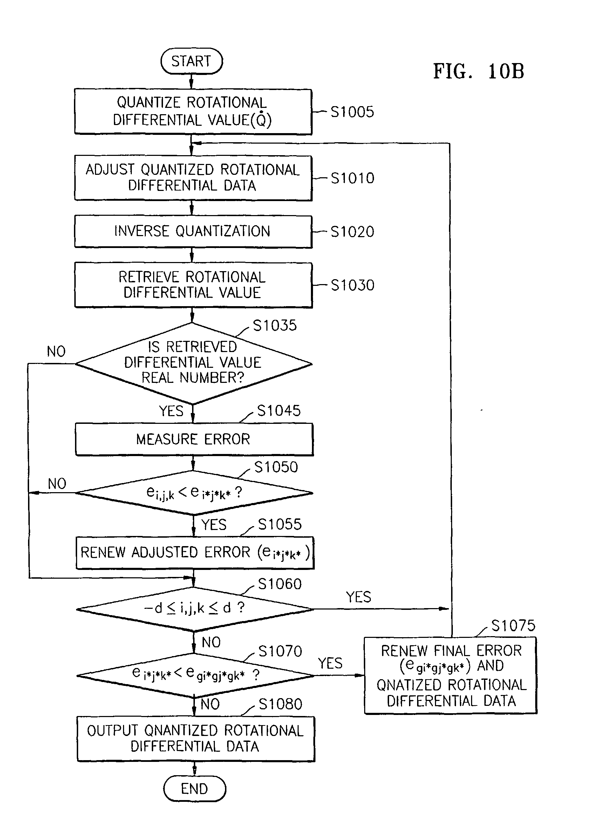

FIG. 10B is a flowchart of the operation of the quantizer 1010. Referring to FIG. 10B, when a rotational differential value $\dot{Q}$ is input from a first quaternion multiplier, the quantizer 1010 quantizes the input rotational differential value $\dot{Q}$ using Equation (10) and outputs quantized rotational differential data $\tilde{Q}$ to the quantization data adjustor 1020 in step S1005.

The quantization data adjustor 1020 adjusts three components of the quantized rotational differential data $\tilde{Q}$ following Equation (22) in step S1010.

$$I_{ijk} = \widetilde{Q} + D_{ijk}, \, D_{ijk} = (i, j, k)^T \quad (-d \le i, j, k \le d \ where \ i, j, k, and \ d \ are \ \text{int}egers) \qquad \cdots(22)$$

In Equation (22), i, j, and k are variables, which will be added to rotational differential data so as to adjust the rotational differential data, and d is used to define the range of i, j, and k. The three adjusted components of the quantized rotational differential data $\widetilde{Q}$ are output to the inverse quantizer 1030.

The inverse quantizer 1030 inversely quantizes adjusted quantized rotational differential data $I_{ijk}$ and outputs inversely quantized rotational differential value $\hat{\tilde{I}}_{ijk}$ (or the results of the inverse quantization) to the rotational differential value restorer 1040 in step S1020.

The rotational differential value restorer 1040, which receives three components of the inversely quantized rotational differential value $\hat{\tilde{I}}_{ijk}$, restores a first component of rotational differential data following Equation (11) and outputs a restored rotational differential value to the error measurement unit 1050 in step S1030.

The error measurement unit 1050 checks a first component value of a rotational differential value input thereinto. If the first component value is a real number, the error measurement unit 1050 performs error measurement. On the other hand, if the first component value is an imaginary number, the method moves on to step S1060 in step S1040.

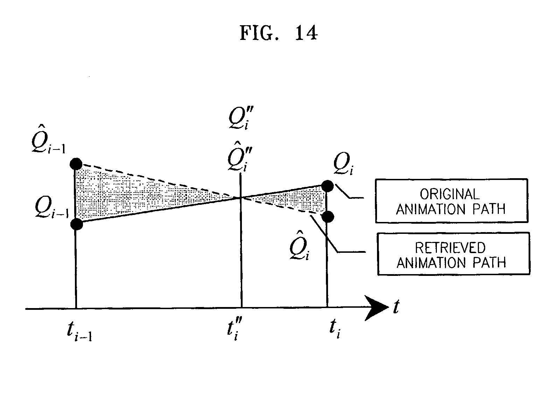

When the first component of the input rotational differential value is a real number, the error measurement unit 1050 measures an error $e_{ijk}$ between an original rotational differential value and a restored rotational differential value in step S1045 and checks if $e_{ijk}$ is smaller than an adjusted error $e_{i^*j^*k^*}$ in step S1050. The method of measuring $e_{ijk}$ between the original rotational differential value and the restored rotational differential value will be described later with reference to FIG. 14.

If the measured error $e_{ijk}$ is smaller than the adjusted error $e_{i^*j^*k^*}$, $e_{ijk}$ replaces $e_{i^*j^*k^*}$ in step S1055 and then it is checked whether or not the variables i, j, and k belong to an adjustment range [-d, +d] in step S1060. If the variables i, j, and k belong to the adjustment range [-d, +d], the error measurement unit 1040 repeatedly performs steps S1010 through S1055. In step S1010 during each cycle of steps S1010 through S1055, 1 is added to second through fourth components of quantized rotational differential data in a nested loop fashion.

For example, a quantized data adjustor 1020 maintains the second and third components, tries to make the restored first component become a real value by adding a value of k to the fourth component value while gradually increasing the value of k by continuously adding 1 to the value of k ($-d \le k \le d$) before the value of k exceeds +d, and then finds four adjusted component values, which can minimize an error between an input rotational differential value and a restored rotational differential value.

If the value of k reaches +d, the quantized data adjustor 1020 tries to make the restored first component become a real value by initializing the value of k with -d and adding a value of j to the third component value while increasing the value of j by adding 1 to the value of j ($-d \le j \le d$) and adding a value of k to the fourth component value while gradually increasing the value of k by continuously adding 1 to the value of k ($-d \le k \le d$) before the value of k exceeds +d, and then finds four adjusted component values, which can minimize an error between an input rotational differential value and a restored rotational differential value.

If the value of j reaches +d, the quantized data adjustor 1020 tries to make the restored first component become a real value by initializing the values of j and k with -d and adding a value of i to the second component value while increasing the value of i by adding 1 to the value of i ($-d \le i \le d$) and adding a value of j to the third component value and adding a value of k to the fourth component value while gradually increasing the value of k by continuously adding 1 to the value of k ($-d \le k \le d$) before the value of k exceeds +d, and then finds four adjusted component values, which can minimize an error between an input rotational differential value and a restored rotational differential value.

The aforementioned process is repeated until i, j, k reach +d and the quantized data adjustor 1020 finds four adjusted component values, which can minimize an error between an input rotational differential value and a restored rotational differential value.

The error measurement unit 1050 checks if the adjusted error $e_{i^*j^*k^*}$ is smaller than a final error $e_{gi^*gj^*gk^*}$ in step S1070 while changing the second through fourth component values. If $e_{i^*j^*k^*}$ is smaller than $e_{gi^*gj^*gk^*}$, $e_{i^*j^*k^*}$ replaces $e_{gi^*gj^*gk^*}$ and quantized rotational differential data are corrected following Equation (23) in step S1075.

$$\widetilde{Q}^* = (\widetilde{q}_1, \widetilde{q}_2, \widetilde{q}_3)^T + (i^*, j^*, k^*)^T \qquad \cdots (23)$$

Thereafter, the error measurement unit 1050 outputs the corrected rotational differential data to the quantized data adjustor 1020.

The quantized data adjustor 1020 sets the values of the variables i, j, and k to -d and performs steps S1010 through S1060 again on rotational differential data input thereinto. Then, the quantized data adjustor 1020 checks if there exists rotational differential data having a smaller error with the input rotational differential data than a previously stored final error.

If the adjusted error $e_{i^*j^*k^*}$ is not smaller than the final error $e_{gi^*gj^*gk^*}$, the error measurement unit 1050 outputs quantized rotational differential data $\widetilde{Q}^{g*} = \widetilde{Q}^* = (\widetilde{q}_1{}^*, \widetilde{q}_2{}^*, \widetilde{q}_3{}^*)^T$ corresponding to the currently stored final error $e_{gi^*gj^*gk^*}$ to a circular DPCM operator in step S1080.

Hereinafter, an apparatus and a method for decoding an encoded bitstream, into which key value data are encoded using the apparatus for encoding key value data according to the present invention, will be described with reference to FIGS. 11A through 12.

FIG. 11A is a block diagram of an apparatus for decoding an encoded bitstream according to a preferred embodiment of the present invention. Referring to FIG. 11A, the apparatus for decoding an encoded bitstream according to the present invention includes a key value header decoder 1170, which decodes header information required for decoding key value data represented by a quaternion from an input bitstream and provides the decoded header information to a key value data decoder 1100, an entropy decoder 1110, which generates circular-DPCMed rotational differential data or quantized rotational differential data by entropy-decoding entropy-encoded key value data from the input bitstream, an inverse circular DPCM operator 1120, which generates quantized rotational differential data by performing an inverse circular DPCM operation on circular-DPCMed rotational differential data input thereinto, an inverse quantizer 1130, which generates a rotational differential value by inversely quantizing quantized rotational differential data, and a quaternion multiplier 1140, which generates a rotational transformation value of a current keyframe by quaternion-multiplying a rotational differential value of the current keyframe by a rotational transformation value of a previous keyframe.

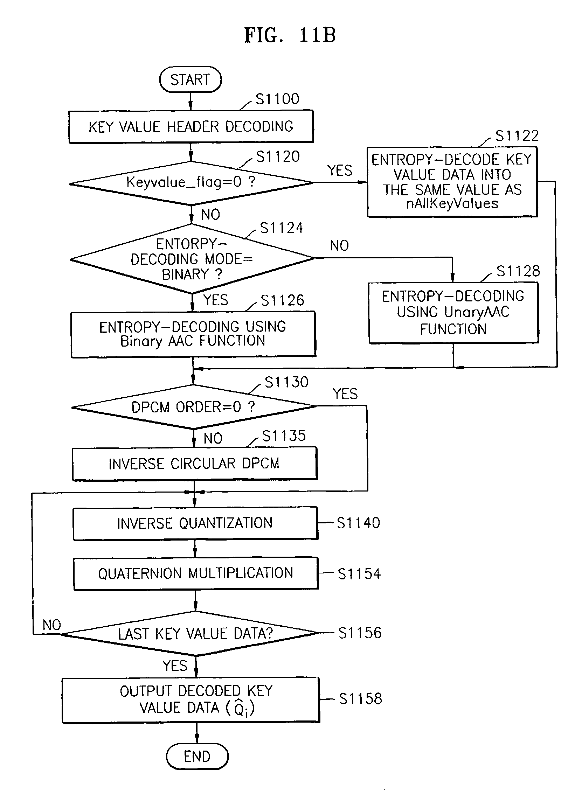

FIG. 11B is a flowchart of a method for decoding key value data according to a preferred embodiment of the present invention. Referring to FIG. 11B, a bitstream, into which key value data are encoded using the apparatus for encoding key value data according to the present invention, is input into the key value header decoder 1170 and the entropy decoder 1110 of the key value data decoder 1100.

The key value header decoder 1170 decodes header information required for decoding key value data from the input bitstream and provides the decoded header information to the key value data decoder 1100 in step S1100.

In the header information, first and second intra key value data quantized into quaternions based on the order of DPCM and a plurality of flags used to decode other key value data are encoded.

If the order of DPCM is 1 (for example, if nKVDPCMOrder, which is one of the plurality of flags, is set to 0), first quantized key value data are included in the header information as intra key value data. If a quaternion value of first inversely quantized key value data satisfies $\hat{Q}_0 = (\hat{q}_{0,0}, \hat{q}_{0,1}, \hat{q}_{0,2}, \hat{q}_{0,3})^T$, the first inversely quantized key value data are calculated following Equation (24).

$$\hat{q}_{0,0} = \tan\left(\frac{\pi}{4} * \left(\frac{|firstQKV\_S|}{2^{nKVQBit-1} - 1}\right)\right) \qquad \cdots (24)$$

$$\hat{q}_{0,1} = \tan\left(\frac{\pi}{4} * \left(xSign * \frac{|firstQKV\_X|}{2^{nKVQBit-1} - 1}\right)\right)$$

$$\hat{q}_{0,2} = \tan\left(\frac{\pi}{4} * \left(ySign * \frac{|firstQKV\_Y|}{2^{nKVQBit-1} - 1}\right)\right)$$

$$\hat{q}_{0,3} = \tan\left(\frac{\pi}{4} * \left(zSign * \frac{|firstQKV\_Z|}{2^{nKVQBit-1} - 1}\right)\right)$$

In Equation (24), xSign is 1 only when nFirstXSign in class OrilDPCMKeyValueHeader, which will be described later, is 1 and is -1 under other conditions. ySign and zSign have the same relationships with nFirstYSign and nFirstZSign, respectively, as the relationship between xSign and nFirstXSign.

The restored quaternion component values defined by Equation (24) are converted into angular displacements to be used as an orientation interpolator. Each of the angular displacements restored from the key value data can be expressed by a four-dimensional vector $(\hat{x}_i, \hat{y}_i, \hat{z}_i, \hat{\theta}_i)^T$ where i represents current key data, $(\hat{x}_i, \hat{y}_i, \hat{z}_i)$ represents the vector of a rotation axis, and $\hat{\theta}_i$ represents a counterclockwise rotation angle. Accordingly, the restored quaternion component values are converted into angular displacements following Equation (25).

$$\hat{x}_0 = \hat{q}_{0,1} * \frac{1}{\sin(\frac{\hat{\theta}_0}{2})} \qquad \cdots (25)$$

$$\hat{y}_0 = \hat{q}_{0,2} * \frac{1}{\sin(\frac{\hat{\theta}_0}{2})}$$

$$\hat{z}_0 = \hat{q}_{0,3} * \frac{1}{\sin(\frac{\hat{\theta}_0}{2})}$$

$$\hat{\theta}_0 = \arccos(\hat{q}_{0,0}) * 2$$

If the order of DPCM is 2, for example, if nKVDPCMOrder is set to 1, first and second quantized key value data are included in the header information. The first quantized key value data are restored in the same way as described above. The second key value data, however, are restored in a different method. In other words, only three components of the second quantized key value data are transmitted along with an encoded bitstream and their values are not intra key value data but differential values $(\tilde{Q}_1 = (\tilde{q}_{1,1}, \tilde{q}_{1,2}, \tilde{q}_{1,3}))$ with the first key value data. Supposing a quaternion representing the second key value data of inversely quantized key value data satisfies $\hat{\tilde{Q}}_1 = (\hat{\tilde{q}}_{1,0}, \hat{\tilde{q}}_{1,1}, \hat{\tilde{q}}_{1,2}, \hat{\tilde{q}}_{1,3})^T$,

$\hat{\tilde{Q}}_1$ is calculated following Equation (26).

$$\hat{\tilde{q}}_{1,0} = \sqrt{1 - (\hat{\tilde{q}}_{1,1}^2 + \hat{\tilde{q}}_{1,2}^2 + \hat{\tilde{q}}_{1,3}^2)} \qquad \cdots(26)$$

$$\hat{\tilde{q}}_{1,1} = \tan(\frac{\pi}{4} * \left( \sec ondXSign * \frac{\left| \sec ondQKV\_X \right|}{2^{nKVQBit-1} - 1} \right))$$

$$\hat{\tilde{q}}_{1,2} = \tan(\frac{\pi}{4} * \left( \sec ondYSign * \frac{\left| \sec ondQKV\_Y \right|}{2^{nKVQBit-1} - 1} \right))$$

$$\hat{\tilde{q}}_{1,3} = \tan(\frac{\pi}{4} * \left( \sec ondZSign * \frac{\left| \sec ondQKV\_Z \right|}{2^{nKVQBit-1} - 1} \right))$$

In Equation (26), secondXSign is 1 only when when nSecondXSign in class OrilDPCMKeyValueHeader is 1 and is -1 under other conditions. secondYSign and secondZSign have the same relationships with nSecondYSign and nSecondZSign, respectively as the relationship between secondXSign and nSecondXSign. If a quaternion $\hat{Q}_1$ representing second inversely quantized key value data satisfies $\hat{Q}_1 = (\hat{q}_{1,0}, \hat{q}_{1,1}, \hat{q}_{1,2}, \hat{q}_{1,3})^T$, $\hat{Q}_1$ is calculated by multiplying $\hat{\tilde{Q}}_1$ by $\hat{Q}_0$. In other words, $\hat{Q}_1 = \hat{\tilde{Q}}_1 \times \hat{Q}_0$.

The key value header decoder 1170 outputs decoded key value data and decoded header information to the key value decoder 1100.

The entropy decoder 1110 receives a bitstream, into which differential data of key value data are encoded, and entropy-decodes the input bitstream using decoding information decoded by the key value header decoder 1170 in steps S1120 through S1128.

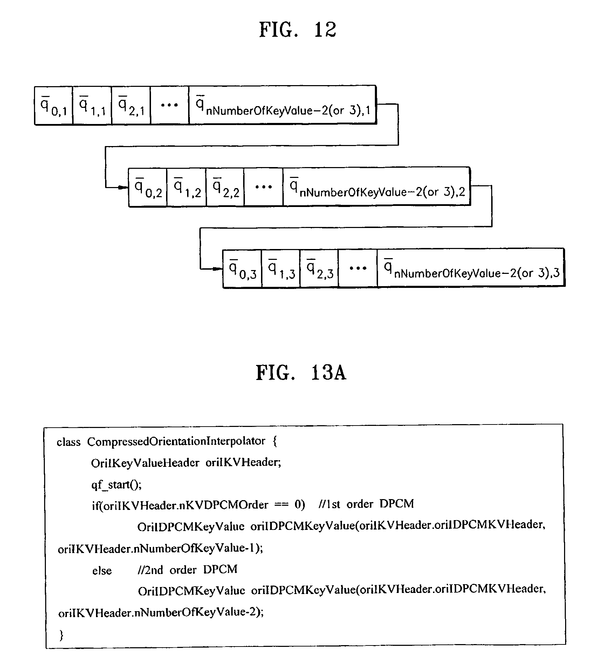

FIG. 12 is a diagram illustrating the structure of a bitstream input into the entropy decoder 1110. In FIG. 12, supposing N (nNumberOfKeyValue) represents the number of encoded key value data, the number of rotational differential data of each component included in a bitstream is N-1 (0, 1, ..., nNumberOfKeyValue-2) when the order of DPCM is 0. When the order of DPCM is 1, the number of rotational differential data of each of the components included in the bitstream is N-2 (0, 1, ..., nNumberOfKeyValue-3).

The entropy decoder 1110 receives x_keyvalue_flag, y_keyvalue_flag, and z_keyvalue_flag from the key value header decoder 1170 and checks if x_keyvalue_flag, y_keyvalue_flag, and z_keyvalue_flag are each set to 1 in step S1120.

When x_keyvalue_flag, y_keyvalue_flag, and z_keyvalue_flag are each set to 0, it is considered that all quantized key value data or all differential data of each component are the same as nAllKeyValues in class OrilKeyValue-CodingBit. Accordingly, the entropy decoder 1110 decodes the key value data of each of the components into the same value as nAllKeyValues input from the key value header decoder 1170 and outputs the decoded key value data to the inverse circular DPCM operator 1120 in step S1122.

If x_keyvalue_flag, y_keyvalue_flag, and z_keyvalue_flag are not set to 0, for example, if x_keyvalue_flag, y_keyvalue_flag, and z_keyvalue_flag are set to 1, the entropy decoder 1110 checks an entropy decoding mode input from the key value header decoder 1170 in order to decode each component of input key value data ($\bar{Q}i = (\bar{q}_{i,1}, \bar{q}_{i,2}, \bar{q}_{i,3})$) in step S1124.

When the entropy decoding mode is a binary decoding mode, the entropy decoder 1110 decodes an adaptive-arithmetically encoded bitstream using a function decodeSignedAAC() shown in Table 1 and outputs quantized rotational differential data to the inverse circular DPCM operator 1120 in step S1126.

Table 1

```
void decodeSignedAAC(int *nDecodedValue, int qstep, QState *signContext, QState
*valueContext) {
        int b;
        b = qstep - 2;
        int msb = 0;
        do {
                qf_decode(&msb, &valueContext[b]);
                msb = msb << b;
                b--;
        } while (msb == 0 && b >=0);
        int sgn = 0;
        int rest = 0;
        if(msb != 0) {
                qf_decode(&sgn, signContext);
                while (b >= 0) {
                        int temp = 0;
                        qf_decode(&temp, &valueContext[b]);
                        rest |= (temp << b);
                        b--;
                }
        }
        if(sgn)
                *nDecodedValue = -(msb+rest);
        else
                *nDecodedValue = (msb+rest);
}
```

On the other hand, when the entropy decoding mode is not a binary decoding mode, the entropy decoder 1110 decodes the input bitstream using a function decodeUnaryAAC() in step S1128. The function decodeUnaryAAC() decodes the input bitstream by consecutively reading 0 until 1 is read from the bitstream, converting the number of successive 0s into its absolute value, reading a bit next to the bit '1', and converting the bit into a sign bit and then outputs quantized rotational differential data to the inverse circular DPCM operator 1120. An example of the function decodeUnaryAAC() is shown in Table 2.

Table 2

```
void decodeUnaryAAC(int* nDecodedValue, QState* signContext, QState* valueContext)
{
        int nBits = -1;
        bit bBit;
        do {
                qf_decode(&bBit, valueContext);
                nBits++;
        } while(bBit == 0);
        if(nBits != 0) {
                qf_decode(&bBit, signContext);
                if(bBit == 0)
                        * nDecodedValue = nBits;
                else
                        * nDecodedValue = -nBits;
        }
        else
                * nDecodedValue = 0;
}
```

A function qf_decode() adopted in the aforementioned functions decodeSignedAAC() and decodeUnaryAAC() is used to read the bit 1 from an adaptive-arithmetically encoded bitstream and is defined by a document ISO/IEC 14496-2: 1999 Coding of Audio-Visual Objects: Visual, authorized by the International Standardization Organization.

The inverse circular DPCM operator 1120 receives the entropy-decoded key value data from the entropy decoder 1110 and checks the order of DPCM input from the key value header decoder 1170. If the order of DPCM is 0, the inverse circular DPCM operator 1120 outputs decoded rotational differential data $Q_{i-2}$ to the inverse quantizer 1130 in step S1130 since the entropy-decoded key value data input from the entropy decoder 1110 are quantized rotational differential data.

On the other hand, if the order of DPCM is 1, the inverse circular DPCM operator 1120 performs an inverse circular DPCM operation in step S1135 since the entropy-decoded key value data input from the entropy decoder 1110 are circular-DPCMed rotational differential data.

Supposing nKVQBit represents inverse quantization bits, the inverse circular DPCM operator 1120 performs an inverse circular DPCM operation on the rotational differential data $Q_{i-2}$ following Equation (27) and generates quantized rotational differential data $Q'_{i-2}$ in step S1135.

$$\breve{Q}'_{i-2} = \breve{Q}_{i-2} - (2^{nKVQBits} - 1) \qquad (if\ \breve{Q}_i \geq 0) \qquad \cdots(27)$$
$$\breve{Q}'_{i-2} = \breve{Q}_{i-2} + (2^{nKVQBits} - 1) \qquad (if\ \breve{Q}_i < 0)$$
$$(i = 2, ..., nNumberOfKeyValue - 1)$$

Thereafter, the inverse circular DPCM operator 1120 obtains an inversely DPCMed value A and an inversely DPCMed value B using $Q_{i-2}$ and $Q'_{i-2}$, respectively, which is shown in Equation (28).

$$A = \check{Q}_{i-2} + \widetilde{Q}_{i-1} \qquad \cdots (28)$$
$$B = \check{Q}'_{i-2} + \widetilde{Q}_{i-1}$$
$$(i = 2, \ldots, nNumberOfKeyValue - 1)$$

The inverse circular DPCM operator 1120 outputs B as inverse circular DPCMed data $\widetilde{Q}_i$ if B+ ($2^{nKVQBit-1}$ - 1) is between 0 and a maximum value in a quantization range. On the other hand, the inverse circular DPCM operator 1120 outputs A as $\widetilde{Q}_i$ if $B + (2^{nKVQBit-1} - 1)$ is smaller than 0 or greater than the maximum value in the quantization range.

An example of C++ program codes, into which the aforementioned operation of the inverse circular DPCM operator 1120 is written, is shown in Table 3.

Table 3

```
ICDPCM(int* curIDPCMKeyValue, int deltaKeyValue, int prevICDPCMKeyValue)
{
        int circularDelta;
        int tempIDPCMKeyValue;
        prevICDPCMKeyValue += ((1 << (nKVQBit-1))-1);

        if(deltaKeyValue >= 0.0)
                circularDelta = deltaKeyValue - ((1 << nKVQBit)-1);
        else
                circularDelta = deltaKeyValue + ((1 << nKVQBit)-1);


        tempIDPCMKeyValue = circularDelta + prevICDPCMKeyValue;


        if((tempIDPCMKeyValue >= 0.0) && (tempIDPCMKeyValue < ((1 << nKVQBit)-1)))
                *curIDPCMKeyValue = tempIDPCMKeyValue;
        else
                *curIDPCMKeyValue = deltaKeyValue + prevICDPCMKeyValue;


        *curIDPCMKeyValue -= ((1 << (nKVQBit-1))-1);
}
```

The inverse quantizer 1130 receives the quantized rotational differential data ($\widetilde{Q}_i = (\widetilde{q}_{i,1}, \widetilde{q}_{i,2}, \widetilde{q}_{i,3})$) generated by the inverse circular DPCM operator 1120 performing an inverse circular DPCM operation, restores a rotational differential value ($\hat{\widetilde{Q}}_i = (\hat{\widetilde{q}}_{i,0}, \hat{\widetilde{q}}_{i,1}, \hat{\widetilde{q}}_{i,2}, \hat{\widetilde{q}}_{i,3})^T$) by performing an inverse quantization operation on $\widetilde{Q}_i$ following Equation (29), and outputs the rotational differential value $\hat{\widetilde{Q}}_i$ to the quaternion multiplier 1140 in step S1140.

$$\hat{\tilde{q}}_{i,0} = \sqrt{1 - (\hat{\tilde{q}}_{f,1}^2 + \hat{\tilde{q}}_{f,2}^2 + \hat{\tilde{q}}_{f,3}^2)} \qquad \cdots (29)$$

$$\hat{\tilde{q}}_{i,J} = \tan(\frac{\pi}{4} * \left( \operatorname{sgn}(\tilde{q}_{i,j}) * \frac{|\tilde{q}_{i,J}|}{2^{nKVQBit-1} - 1} \right))$$

$$(i = 2, ..., nNumberOfKeyValue - 1, j = 1, 2, 3)$$

Thereafter, the quaternion multiplier 1140 receives the rotational differential value $\hat{\tilde{Q}}_i$. The quaternion multiplier 1140 restores a rotational transformation value $\hat{Q}_i$ (where $\hat{Q}_i = (\hat{q}_{i,0}, \hat{q}_{i,1}, \hat{q}_{i,2}, \hat{q}_{i,3})^T$ of a current keyframe in step S1154 by quaternion-multiplying the input rotational differential value $\hat{\tilde{Q}}_i$ by a rotational transformation value $\hat{Q}_{i-1}$ of a previous keyframe following Equation (30).

$$\hat{Q}_i = \hat{\tilde{Q}}_i \times \hat{Q}_{i-1} \qquad \cdots (30)$$
$$(i = 2, ..., nNumberOfKeyValue - 1)$$

After restoring a rotational transformation value, the key value data decoder 1100 checks if the restored rotational transformation value corresponds to last key value data in step S1156. If the restored rotational transformation value does not correspond to the last key value data, the key value data decoder 1100 repeatedly performs steps S1140 through S1154. On the other hand, if the restored rotational transformation value is the last key value data's, the key value data decoder 1100 outputs the restored rotational transformation value in step S1158.

If the order of DPCM is 0, the inverse circular DPCM operator 1120 outputs the decoded quantized rotational differential data $\tilde{Q}_i$ (where $\tilde{Q}_i = (q_{i,1}, q_{i,2}, q_{i-3})$) to the inverse quantizer 1130. Then, the inverse quantizer 1130 generates a rotational differential value $\hat{\tilde{Q}}_i$ (where $\hat{\tilde{Q}}_i = (\hat{\tilde{q}}_{i,0}, \hat{\tilde{q}}_{i,1}, \hat{\tilde{q}}_{i,2}, \hat{\tilde{q}}_{i,3})^T$) by inversely quantizing the rotational differential data $Q_i$ input from the inverse circular DPCM operator 1120 and outputs $\hat{\tilde{Q}}_i$ to the quaternion multiplier 1140 in step S1140.

$$\hat{\tilde{q}}_{i,0} = \sqrt{1 - (\hat{\tilde{q}}_{i,1}^2 + \hat{\tilde{q}}_{i,2}^2 + \hat{\tilde{q}}_{i,3}^2)} \qquad \cdots (31)$$

$$\hat{\tilde{q}}_{i,J} = \tan(\frac{\pi}{4} * \left( \operatorname{sgn}(\breve{q}_{i-1,j}) * \frac{|\breve{q}_{i-1,J}|}{2^{nKVQBit-1} - 1} \right))$$

$$(i = 1, ..., nNumberOfKeyValue - 1, j = 1, 2, 3)$$

Even when the order of DPCM is 0, the quaternion multiplier 1140 restores rotational transformation values in almost the same way (steps S1150 through S1158) as it does when the order of DPCM is not 0. When the order of DPCM is not 0, the quaternion multiplier 1140 performs quaternion multiplication following Equation (32).

$$\hat{Q}_i = \hat{\tilde{Q}}_t \times \hat{Q}_{i-1} \qquad \cdots (32)$$
$$(i = 1, \ldots, nNumberOfKeyValue - 1)$$

FIGS. 13A through 13E are diagrams illustrating examples of SDL-language program codes, into which the apparatus for decoding key value data according to the present invention is realized. Hereinafter, the meaning of each variable shown in FIGS. 13A through 13E will be described.

FIG. 13A is a diagram illustrating a class CompressedOrientationInterpolator. CompressedOrientationInterpolator is a top class used for reading an encoded bitstream of an orientation interpolator. OrilKeyValueHeader and OriIDPCMKeyValue are classes for information on key value data corresponding to key value field data in a conventional orientation interpolator. A function qf_start() is used to initialize an arithmetic decoder before reading a bitstream, into which key value data are encoded.

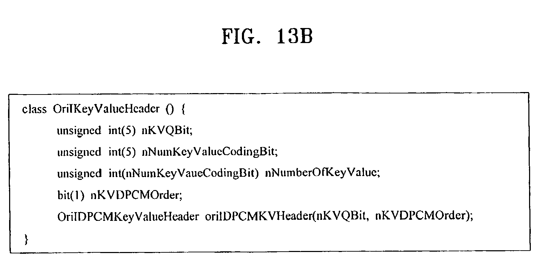

FIG. 13B is a diagram illustrating a class OrilKeyValueHeader. The meaning of each variable used in this class is as follows. nKVQBit represents an inverse quantization bit size of key value data. nNumKeyValueCodingBit represents the number of key value data. nKVDPCMOrder represents the order of inverse DPCM operation used for decoding key value data. When nKVDPCMOrder = 0, an inverse circular DPCM operation does not need to be performed. On the other hand, when nKVDPCMOrder = 1, an inverse circular DPCM operation is supposed to be performed.

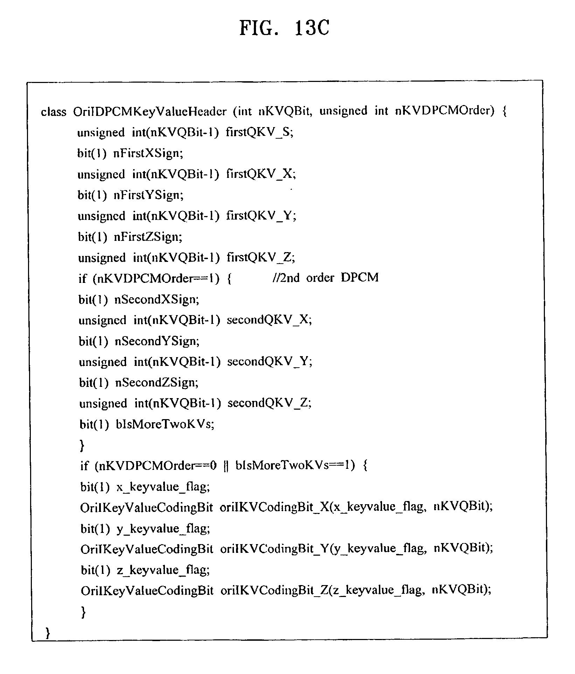

FIG. 13C is a diagram illustrating a class OriDPCMKeyValueHeader. The meaning of each variable used in this class is as follows. firstQKV_S, firstQKV_X, firstQKV_Y, and firstQKV_Z represent first values of four components s, x, y, and z, respectively, constituting a quaternion (s, x, y, z) representing quantized key value data. nFirstXSign, nFirstYSign, and nFirstZSign represent signs of firstQKV_X, firstQKV_Y, and firstQKV_Z, respectively. secondQKV_X, secondQKV_Y, and second QKV_Z represent second values of the three components x, y, and z, respectively, and nSecondXSign, nSecondYSign, and nSecondZSign represent signs of secondQKV_X, secondQKV_Y, and second QKV_Z, respectively. blsMoreTwoKVs indicates if there are more than two key value data to be decoded when an inverse circular DPCM is supposed to be performed. x_keyvalue_flag, y_keyvalue_flag, and z_keyvalue_flag indicate if all quantized values of each of the components x, y, and z, respectively, are the same.

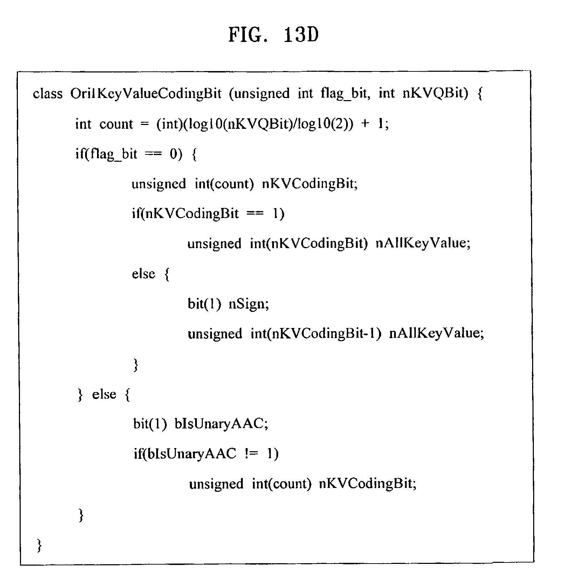

FIG. 13D is a diagram illustrating a class OrilKeyValueCodingBit. The meaning of each variable used in this class is as follows. nKVCodingBit represents the number of bits used to store each component of all quaternion key value data except for intra key value data (firstQKV_S, firstQKV_X, firstQKV_Y, firstQKV_Z, second QKV_X, secondQKV_Y, and secondQKV_Z in the class OriIDPCMKeyValueHeader) after quantization.

nAllKeyValue represents a quantized value of each component of all key value data when keyvalue_flag for each of the components is set to 0. nSign represents the sign of nAllKeyValue. BIsUnaryAAC represents an adaptive-arithmetic quantization method used for decoding quantized values of each of the components x, y, and z. If blsUnaryAAC is set as 'true', an unary AAC decoding function will be used. On the other hand, if blsUnaryAAC is set as 'false', a binaryAAC decoding function will be used.

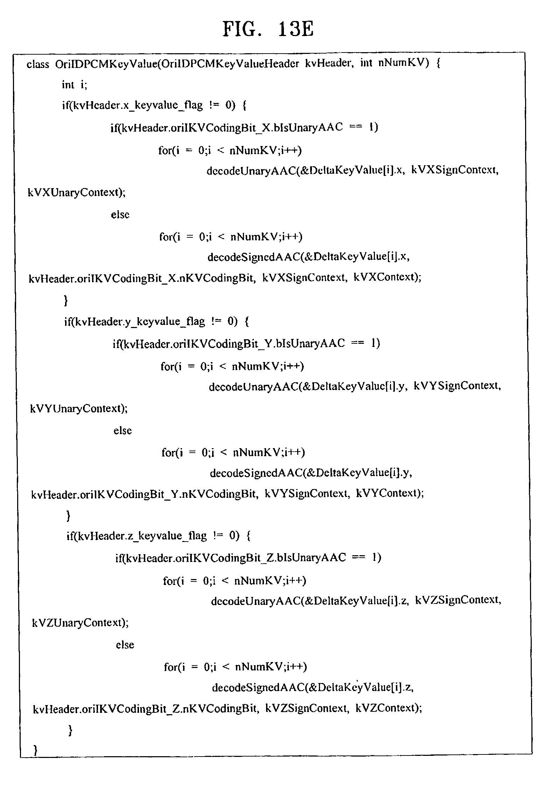

FIG. 13E is a diagram illustrating a class OriIDPCMKeyValue. The meaning of each value used in this class is as follows. DeltaKeyValue is used to store quantized key value data including the three components x, y, and z in the form of quaternion. The quantized key value data stored in DeltaKeyValue are decoded from a bitstream using a function decodeUnaryAAc or decodeSignedAAC.

kVXSignContext, kVYSignContext, and kVZSignContext are contexts used for decoding the three components x, y, and z of DeltaKeyValue using the function decodeUnaryAAC or decodeSignedAAC.

kVXUnaryContext, kVYUnaryContext, and kVZUnaryContext are contexts used for decoding the three components x, y, and z of DeltaKeyValue using the function decodeUnaryAAC.

KVXContext, kVYContext, and kVZContext are contexts used for decoding the three components x, y, and z of DeltaKeyValue using the function decodeSignedAAC.

Hereinafter, a method of measuring an error between an original rotational differential value and a rotational differential value restored by inversely quantizing a quantized rotational differential value in the error measurement unit 1050 included in a quantizer 1000 according to a third embodiment of the present invention will be described.

The method of measuring an error between an original rotational differential value and a restored rotational differential value according to the present invention can also be used for measuring an error between key value data of an orientation interpolator before encoding and key value data of the orientation interpolator obtained by decoding encoded key value data. Accordingly, in the following description of the error measurement method according to the present invention, the original rotational differential value and the restored rotational differential value will correspond to the original key value data before encoding and the key value data obtained by decoding encoded key value data, respectively.

In the process of encoding key value data of an orientation interpolator, an error occurs between original key value data and restored key value data during quantization. Here, the error between the original key value data and the restored key value data is defined by the difference between a rotation angle obtained using the original key value data and a rotation angle obtained from the restored key value data.

In other words, supposing that one key value datum included in an orientation interpolator node and its restored key value datum in a decoder are referred to as $(\vec{r}, \theta)$ and $(\hat{\vec{r}}, \hat{\theta})$, respectively, where $\vec{r}$ represents a rotation axis, and $\theta$ represents a rotation angle and satisfies $\theta \in [-\pi, \pi]$ and that an object in a three-dimensional space is moved from an arbitrary position $\bar{x}$ to an arbitrary position $\vec{y}$ and from $\vec{y}$ to an arbitrary position $\hat{\vec{y}}$ based on $(\vec{r}, \theta)$ and $(\hat{\vec{r}}, \hat{\theta})$, respectively, by rotation transformation, a quantization error is the difference between $\vec{y}$ and $\hat{\vec{y}}$ and satisfies $\vec{e}(\vec{x}) = \vec{y} - \hat{\vec{y}}$. $\bar{x}$, $\vec{y}$, and $\hat{\vec{y}}$ represented in the form of quaternion are shown in Equation (33).

$$X = (0, \vec{x}), \quad Y = (0, \vec{y}), \quad \hat{Y} = (0, \hat{\vec{y}}) \qquad \cdots (33)$$

When quaternions representing $(\vec{r}, \theta)$ and $(\hat{\vec{r}}, \hat{\theta})$ are referred to as $Q$ and $\hat{Q}$, the following equations can be derived.

$$Y = Q \times X \times Q^{\bullet} \qquad \cdots (34)$$
$$X = Q^{\bullet} \times Y \times Q$$

Here, AxB represents quaternion multiplication, and A* represents a conjugate of A. Based on Equations (33) and (34), the following equation can be derived.

$$\hat{Y} = \hat{Q} \times X \times \hat{Q}^{\bullet} = \hat{Q} \times Q^{\bullet} \times Y \times Q \times \hat{Q}^{\bullet} = Q_{error} \times Y \times Q^{\bullet}_{error} \qquad \cdots (35)$$

Here, $Q_{error}$ is a value representing the relationship between $\vec{y}$ and $\hat{\vec{y}}$ in terms of rotation transformation and is defined by the following equation.

$$Q_{error} = \hat{Q} \times Q^{*} \qquad \cdots (36)$$

When a differential rotation angle between $\vec{y}$ and $\hat{\vec{y}}$ is referred to as $\theta_{error}$, $\theta_{error}$ can be obtained using a quaternion transformation formula and Equation (36).

$$\theta_{error} = 2\cos^{-1} q_{0,error} = 2\cos^{-1}(\hat{Q} \cdot Q) \qquad \theta_{error} \in [0, \pi] \qquad \cdots (37)$$

Here, X represents an inner product operation. Equation (37) defines an instantaneous quantization error occurring among all animation keyframes at a predetermined moment of time, and an instantaneous quantization error at a predetermined moment of time (t) can be defined by the following equation in order to derive a formula for obtaining a quantization error in an entire animation interval from Equation (37).

$$e(t) = 2\arccos\{Q(t) \cdot \hat{Q}(t)\} \qquad \cdots(38)$$

An average error $E_m$ and a maximum error $E_p$ can be derived by extensively applying Equation (38) to the entire keyframe interval, during which an animation is being performed using an orientation interpolator.

Here, in order to obtain the average error $E_m$, the partial sum $E_m^i$ of errors in an interval $[t_{i-1}, t_i]$ must be obtained first, as shown in FIG. 14. Hereinafter, decoded key value data corresponding to original key value data $Q_{i-1}$ and $Q_i$ will be referred to as $\hat{Q}_{i-1}$ and $\hat{Q}_i$, respectively.

Due to the fact that an animation path is distorted in a three-dimensional space, the interval $[t_{i-1}, t_i]$ must be divided into two sub-intervals $[t_{i-1}, t_i'']$ and $[t_i'', t_i]$ and the two sub-intervals must be calculated separately from each other. Here, let us assume that a distance between two animation paths, i.e., between a group of values of $Q_i$ and a group of values of $\hat{Q}_i$ is minimized at $t_i''$ in the interval $[t_{i-1}, t_i]$. Instantaneous errors at $t_{i-1}$ and $t_i$ are calculated using the following equations.

$$e_{i-1} = 2\arccos(Q'_{i-1} \cdot \hat{Q}_{i-1}) \qquad \cdots(39)$$

$$e_i = 2\arccos(Q'_i \cdot \hat{Q}_i)$$

In addition, $t_i''$ in the interval $[t_{i-1}, t_i]$ is proportional to $\dfrac{e_{i-1}}{e_i}$ , which is shown in Equation (40).

$$t_i'' = t_{i-1} + \frac{e_{i-1}}{e_{i-1} + e_i}(t_i - t_{i-1}) \qquad \cdots(40)$$

Intermediate quaternion values and an instantaneous error at $t_i''$ are calculated following Equation (41).

$$Q_i'' = SLERP(Q_{i-1}, Q_i, \frac{t_i'' - t_{i-1}}{t_i - t_{i-1}}) \qquad \cdots(41)$$

$$\hat{Q}_i'' = SLERP(\hat{Q}_{i-1}, \hat{Q}_i, \frac{t_i'' - t_{i-1}}{t_i - t_{i-1}})$$

$$e_i'' = 2 \cdot \arccos(Q_i'' \cdot \hat{Q}_i'')$$

However, an instantaneous error at an arbitrary moment $(t)$ of time is obtained following Equation (42).

$$e(t) = 2 \cdot \arccos(Q(t) \cdot \hat{Q}(t)) \qquad \cdots(42)$$

Here, $Q(t) = SLERP(Q_{i-1}, Q_i, \frac{t - t_{i-1}}{t_i - t_{i-1}})$ and $\hat{Q}(t) = SLERP(\hat{Q}_{i-1}, \hat{Q}_i, \frac{t - t_{i-1}}{t_i - t_{i-1}})$. However, it is not easy to calculate an instantaneous error e(t) at an arbitrary moment (t) of time. Accordingly, e(t) is determined using linear approximation, which is shown in Approximation (43).

$$e(t) \cong \begin{cases} e_{i-1} + \dfrac{t - t_{i-1}}{t_i'' - t_{i-1}}(e_i'' - e_{i-1}) & (t_{i-1} \leq t \leq t_i'') \qquad \cdots(43) \\[3mm] e_i'' + \dfrac{t - t_i''}{t_i - t_i''}(e_i - e_i'') & (t_i'' \leq t \leq t_i) \end{cases}$$

The partial sum $E_m^i$ of errors in the interval $[t_{i-1}, t_i]$ and a partial sum $E_p^i$ of maximum errors in the interval $[t_{i-1}, t_i]$ can also be obtained using Approximations (43) and (44).

$$\begin{cases} E_p^i \equiv \max_{t_{i-1} \leq t \leq t_i} |e(t)| & \cdots(44) \\[3mm] E_m^i \equiv \int_{i-1}^{i''} e^2(t)dt + \int_{i''}^{i} e^2(t)dt \end{cases}$$

Approximation (45) can be rearranged as follows.

$$\begin{cases} E_p^i \cong \max\{|e_{i-1}|, |e_i''|, |e_i|\} & \cdots(45) \\[3mm] E_m^i \cong \dfrac{1}{3}(t_i'' - t_{i-1})\{(e_i'')^2 + e_{i-1}^2 + e_i'' e_{i-1}\} + \dfrac{1}{3}(t_i - t_i'')\{e_i^2 + (e_i'')^2 + e_i e_i''\} \end{cases}$$

Finally, an average error $E_m$ and a maximum error Ep in a time interval $[t_{min}, t_{max}]$ are calculated with Approximation (46) below.

$$E_m \cong \sqrt{\frac{1}{t_{max} - t_{min}} \sum_i E_m^i} \qquad \cdots(46)$$

$$E_p \cong \max_i E_p^i$$

Accordingly, the error measurement unit 1050 in the quantizer 1000 according to the third embodiment of the present invention calculates an error between original key value data and restored key value data following Equation (37) and can measure the degree to which images are distorted in a quaternion space due to a quantization error more precisely.

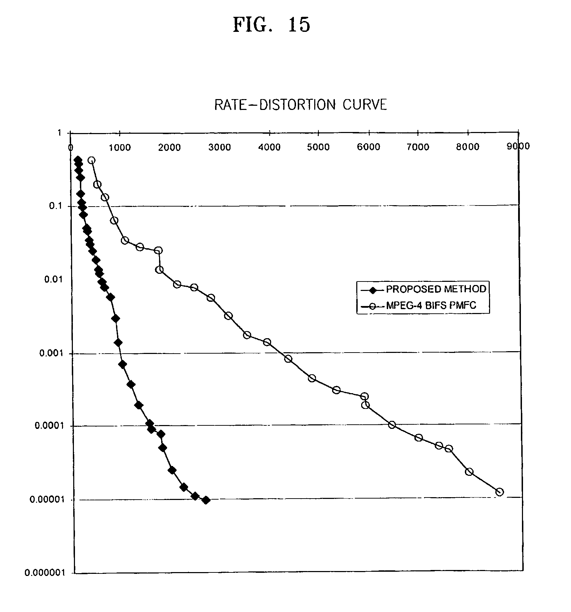

FIG. 15 is a graph showing the performance of the method for encoding key value data according to the present invention compared with a conventional method for encoding key value data. As shown in FIG. 15, according to the method for encoding key value data of the present invention, the degree, to which images are distorted when a predetermined number of bits required for encoding are given, can be lowered more considerably than in the conventional MPEG_4 BIFS PMFC method.

The present invention can be realized as computer-readable codes written on a computer-readable recording medium. Here, the computer-readable recording medium includes any kind of recording medium which can be read by a computer system. For example, the computer-readable recording medium includes a ROM, a RAM, a CD-ROM, a magnetic tape, a floppy disk, an optical data storage, carrier wave (transmission through the Internet). The computer-readable recording medium can be decentralized to computer systems connected over network, and a computer can read the recording medium in a decentralized way.

While this invention has been particularly shown and described with reference to preferred embodiments thereof, it will be understood by those skilled in the art that various changes in form and details may be made therein without departing from the scope of the invention as defined by the appended claims.

The method for encoding and decoding key value data of an orientation interpolator according to the present invention can effectively reduce redundancy among successive key value data to be encoded by encoding rotational differential values representing differences among rotational transformation values of keyframes.

In addition, according to the present invention, it is possible to prevent an object from being restored to rotate in an opposite direction to an original direction due to a quantization error by directly correcting the rotation direction of the object.

Moreover, since in the present invention, only second through fourth components having relatively small values among four components constituting a quaternion representing key value data are encoded and a first component is restored using the second through fourth components, which are adjusted so that the first component can be restored into a real number, it is possible to considerably reduce the size of data required for encoding.

**Claims**

**1.** A rotational differential data generating apparatus for an orientation interpolator of a keyframe-based graphic animation, the apparatus being adapted to generate, using a rotational transformation value of a current keyframe and a restored rotational transformation value of a previous keyframe, a rotational differential value used to rotate the object by as much as a difference between a rotational transformation applied to the object in the current keyframe by key value data and a rotational transformation applied to the object in the previous keyframe by key value data, and to output rotational differential data by quantizing the rotational differential value

**2.** The apparatus of claim 1 comprising:

a first quaternion multiplier (310, 810) which generates a rotational differential value used to rotate an object by as much as a difference between rotational transformation applied to the object in a current keyframe by a rotational transformation value of the current frame and rotational transformation applied to the object in a previous keyframe by a restored rotational transformation value of the previous frame;
a quantization unit (340, 840, 1000) which generates rotational differential data by quantizing the rotational differential value;
an inverse quantization unit (350, 850) which generates a restored rotational differential value by inversely quantizing the rotational differential data; and
a second quaternion multiplier (370, 870) which generates a restored rotational transformation value of the current frame by quaternion-multiplying the restored rotational differential value by a rotational transformation value of the previous frame.

**3.** The apparatus of claim 2, wherein the first quaternion multiplier (310, 810) generates a rotational differential value by quaternion-multiplying the rotational transformation value of the current frame by a conjugate of the restored rotational transformation value of the previous frame.

**4.** The apparatus of claim 2 or 3, wherein the quantization unit (340, 840, 1000) performs nonlinear quantization by which a region having a small rotational differential value can be quantized to have a higher resolution than a region having a great rotational differential value.

**5.** The apparatus of claim 2, 3 or 4, wherein the quantization unit (340, 840, 1000) quantizes only three components among first through fourth components of the rotational differential value represented by a quaternion.

**6.** The apparatus of any of claims 2 to 5, wherein the quantization unit (340, 840, 1000) adjusts components of the rotational differential data so that a component value of a rotational differential value, which is restored using the component values of the rotational differential data and has not been quantized, can be converted into a real number and outputs the adjusted components of the rotational differential data.

7.  The apparatus of claim 6, wherein the quantization unit (340, 840, 1000) generates final rotational differential data by adding/subtracting a variable in a predetermined adjustment range to/from each of the quantized components of the rotational differential data or to/from each of the adjusted components of the rotational differential data.

8.  The apparatus of any of claims 2 to 7, wherein the quantization unit (1000) comprises:

    a quantizer (1010) which generates rotational differential data by quantizing three component values of a rotational differential value input thereinto;
    a quantized data adjustor (1020) which adjusts three component values of rotational differential data input thereinto;
    an inverse quantizer (1030) which inversely quantizes the adjusted component values;
    a rotational differential value restorer (1040) which generates a restored rotational differential value by restoring one component value, which has not been quantized, using the three inversely quantized component values; and
    an error measurement unit (1050) which measures an error between a rotational differential value input into the quantization unit and the restored rotational differential value and outputs rotational differential data having adjusted components so that the error can be minimized.

9.  The apparatus of claim 8, wherein the error measurement unit (1050) renews an adjusted error with a current error between the rotational differential value input into the quantization unit (1000) and the restored rotational differential value if the current error is smaller than the adjusted error, renews a final error with the adjusted error if the adjusted error is smaller than the final error, and outputs adjusted rotational differential data corresponding to the adjusted error to the quantized data adjustor (1020).

10. The apparatus of any of claims 2 to 9, wherein the inverse quantizer (350, 850) inversely quantizes quantized component values and restores a component value, which has not been quantized, using the inversely quantized component values.

11. The apparatus of any of claims 2 to 10, further comprising a rotation direction error detector (830) which generates a first rotational differential value between the rotational transformation value of the current frame and the rotational transformation value of the previous frame, a second rotational differential value between the rotational transformation value of the previous frame and the restored rotational transformation value of the previous frame input from the second quaternion multiplier, and a third rotational differential value between the rotational transformation value of the current frame and the restored rotational transformation value of the previous frame and detects whether or not a rotation direction error has occurred.

12. The apparatus of claim 11, wherein the rotation direction error detector (830) determines that the rotational direction error has occurred when the rotation direction of the object obtained from the first rotational differential value is opposite to the rotation direction of the object obtained from the third rotational differential value, the rotation direction of the object obtained from the second rotational differential value is opposite to the rotation direction of the object obtained from the third rotational differential value, and rotation angles obtained from the first through third rotational differential values exceed a predetermined critical rotation angle.

13. The apparatus of any of claims 2 to 12, further comprising:

    a rotation direction error detector (830) which receives the rotational transformation value of the current frame and the restored rotational transformation value of the previous frame from the second quaternion multiplier and detects whether or not a rotation direction error has occurred so that an original rotation direction of the object is opposite to a decoded rotation direction of the object,
    a rotation direction corrector (815) which adjusts the rotational differential value input from the first quaternion multiplier (810) so that the original rotation direction of the object can be the same as the decoded rotational direction of the object and outputs the adjusted rotational differential value; and
    a rotation direction selector (835) which outputs the rotational transformation value input from the first quaternion multiplier (810) or the adjusted rotational differential value input from the rotation direction corrector (815) to the quantization unit (840) depending on the result of the detection performed in the rotation direction error detector (830).

**14.** The apparatus of claim 13, wherein the quantization unit (1000) comprises:

a quantizer (1010) which generates rotational differential data by quantizing three component values of a rotational differential value input thereinto;

a quantized data adjustor (1020) which adjusts three component values of rotational differential data input thereinto;

an inverse quantizer (1030) which inversely quantizes the adjusted component values;

a rotational differential value restorer (1040) which generates a restored rotational differential value by restoring one component value, which has not bee quantized, using the three inversely quantized component values; and

an error measurement unit (1050) which measures an error between a rotational differential value input into the quantization unit and the restored rotational differential value and outputs rotational differential data having adjusted component values so that the error can be minimized.

**15.** An apparatus for encoding key value data of an orientation interpolator representing rotation transformation of an object in keyframes of a keyframe-based graphic animation, the apparatus comprising:

the rotational differential data generating apparatus of claim 1; and

an entropy encoder (450) which entropy-encodes the rotational differential data.

**16.** The apparatus of claim 15, wherein the rotational differential data generator generates the rotational differential value by quaternion-multiplying the rotational transformation value of the current keyframe by a conjugate of the restored rotational transformation value of the previous keyframe.

**17.** The apparatus of claim 15 or 16, wherein the rotational differential data generator performs nonlinear quantization by which a region having a small rotational differential value can be quantized to have a higher resolution than a region having a great rotational differential value.

**18.** The apparatus of claim 15, 16 or 17, wherein the rotational differential data generator adjusts component values of the rotational differential data so that not-quantized component values of rotational differential data can be restored into real numbers by inversely quantizing quantized component values of rotational differential data.

**19.** The apparatus of claim 18, wherein the rotational differential data generator generates the rotational differential data to be entropy-encoded by adding/subtracting a variable in a predetermined adjustment range to/from each of the quantized component values of the rotational differential data or to/from each of the adjusted component values of the rotational differential data.

**20.** The apparatus of any of claims 15 to 19, wherein the rotational differential data generator comprises:

a quantizer (1010) which generates rotational differential data by quantizing three component values of the rotational differential value;

a quantized data adjustor (1020) which adjusts three component values of rotational differential data input thereinto;

an inverse quantizer (1030) which inversely quantizes the adjusted component values;

a rotational differential value restorer (1040) which restores one component value, which has not been quantized, using the three inversely quantized component values and thus generate a restored rotational differential value; and

an error measurement unit (1050) which measures an error between a rotational differential value input into the quantizer and the restored rotational differential value and outputs rotational differential data having adjusted component values so that the error can be minimized.

**21.** The apparatus of claim 20, wherein the error measurement unit (1050) renews an adjusted error with a current error between the rotational differential value input into the quantizer (1010) and the restored rotational differential value if the current error is smaller than the adjusted error, renews a final error with the adjusted error if the adjusted error is smaller than the final error, and outputs adjusted rotational differential data corresponding to the adjusted error to the quantized data adjustor (1020).

**22.** The apparatus any of claims 15 to 21, wherein the rotational differential data generator comprises:

a first quaternion multiplier (310, 810) which generates the rotational differential value using the rotational transformation value of the current keyframe and the restored rotational transformation value of the previous keyframe;

a quantizer (340, 840, 1000) which generates rotational differential data by quantizing the rotational differential value;

an inverse quantizer (350, 850) which generates a restored rotational differential value by inversely quantizing the rotational differential data; and

a second quaternion multiplier (370, 870) which generates a restored rotational differential value of the current keyframe by quaternion-multiplying the restored rotational differential value by a rotational transformation value of the previous keyframe.

23. The apparatus of claim 22, wherein the quantizer (340, 840, 1000) quantizes only three component values among first through fourth component values of the rotational differential value represented by a quaternion.

24. The apparatus of any of claims 15 to 23, wherein the rotational differential data generator generates a first rotational differential value between the rotational transformation value of the current keyframe and the rotational transformation value of the previous keyframe, a second rotational differential value between the rotational transformation value of the previous keyframe and the restored rotational transformation value of the previous keyframe, and a third rotational differential value between the rotational transformation value of the current keyframe and the restored rotational transformation value of the previous keyframe and detects whether or not a rotation direction error has occurred so that the object rotates in an opposite direction to an original direction.

25. The apparatus of claim 24, wherein the rotational differential data generator determines that the rotational direction error has occurred when the rotation direction of the object obtained from the first rotational differential value is opposite to the rotation direction of the object obtained from the third rotational differential value, the rotation direction of the object obtained from the second rotational differential value is opposite to the rotation direction of the object obtained from the third rotational differential value, and rotation angles obtained from the first through third rotational differential values exceed a predetermined critical rotation angle.

26. The apparatus of any of claims 15 to 25, wherein the rotational differential data generator comprises:

a rotation direction error detector (830) which detects whether or not the rotation direction error has occurred so that the original rotation direction of the object is opposite to a decoded rotation direction of the object, a based on the rotational transformation value of the current keyframe and the restored rotational transformation value of the previous keyframe;

a rotation direction corrector (815) which adjusts the rotational differential value so that the decoded rotation direction of the object can be the same as the original rotation direction of the object; and

a rotation direction selector (835) which selects either the rotation differential value or the rotation differential value input from the rotation direction corrector (815) as differential data to be quantized, depending on the result of the detection input from the rotation direction error detector (830).

27. The apparatus of claim 26, wherein the rotational differential data generator further comprises a quantization unit (1000), which quantizes the differential values selected by the rotation direction selector and outputs the quantized differential data and the quantization unit (1000) comprises:

a quantizer (1010) which generates rotational differential data by quantizing three component values of a rotational differential value input thereinto;

an quantized data adjustor (1020) which adjusts three component values of rotational differential data input thereinto;

an inverse quantizer (1030) which inversely quantizes the adjusted component values;

a rotational differential value restorer (1040) which generates a restored rotational differential value by restoring one component value, which has not been quantized, using the three inversely quantized component values; and

an error measurement unit (1050) which measures an error between a rotational differential value input into the quantization unit and the restored rotational differential value and outputs adjusted rotational differential data based on the measured error.

28. The apparatus of claim 27, wherein the quantized data adjustor (1020) generates adjusted rotational differential data by adding/subtracting a variable in a predetermined adjustment range to/from each of the quantized component values of the rotational differential data input from the quantizer (1010) or to/from each of the adjusted component values of the rotational differential data input from the error measurement unit (1050).

29. The apparatus of claim 27 or 28, wherein the error measurement unit (1050) renews an adjusted error with a current error between the rotational differential value input into the quantizer (1010) and the restored rotational differential value if the current error is smaller than the adjusted error, renews a final error with the adjusted error if the adjusted error is smaller than the final error, and outputs adjusted rotational differential data corresponding to the adjusted error to the quantized data adjustor (1020).

30. The apparatus of any of claims 15 to 29, further comprising a circular DPCM operator (400) which generates differential data having a reduced size by performing a linear DPCM operation on the rotational differential data and then performing a predetermined operation on the linear-DPCMed differential data, the operation comprising representing data having an absolute value greater than a maximum value in a quantization range are represented by data of lesser absolute value and opposite polarity,
wherein the entropy encoder (450) entropy-encodes circular-DPCMed rotational differential data.

31. The apparatus of claim 30, wherein the circular DPCM operator (400) outputs the smaller ones between the linear-DPCMed differential data and differences between the linear-DPCMed differential data and the maximum value in the quantization range.

32. The apparatus of claim 30 or 31, wherein the rotational differential data generator comprises:

a first quaternion multiplier (310, 810) which generates the rotational differential value using a rotational transformation value of a current keyframe and a restored rotational transformation value of a previous keyframe;
a quantizer (340, 840, 1000) which generates rotational differential data by quantizing the rotational differential value;
an inverse quantizer (350, 850) which generates a restored rotational differential value by inversely quantizing the rotational differential data; and
a second quaternion multiplier (370, 870) which generates a restored rotational transformation value of the current keyframe by quaternion multiplying the restored rotational differential value by a rotational transformation value of the previous keyframe.

33. The apparatus of any of claims 15 to 32, wherein the entropy encoder (450) encodes rotational differential data to be encoded into a series of first figures, the number of which corresponds to the magnitude of the rotational differential data to be encoded, and a one-bit second figure indicating that the series of first figures ends.

34. The apparatus of any of claims 15 to 33, wherein the entropy encoder (450) encodes rotational differential data to be encoded on every bit plane.

35. An apparatus for decoding a bitstream, into which key value data of an orientation interpolator representing the rotational transformation of an object in keyframes are encoded, the apparatus comprising:

an entropy decoder (1110) which generates circular-DPCMed rotational differential data or quantized rotational differential data by entropy-decoding the bitstream;
an inverse circular DPCM operator (1120) which generates quantized rotational differential data by performing an inverse circular DPCM operation on the rotational differential data input from the entropy decoder (1110) depending on the order of DPCM decoded from the bitstream, the inverse circular DPCM operation comprising replacing DPCMed data having an absolute value less than a maximum value in a quantization range by DPCMed data of greater absolute value and opposite polarity and performing an inverse linear DPCM operation;
an inverse quantizer (1130) which generates rotational differential data, used to rotate an object by as much as a difference between rotational transformation applied to the object in the current keyframe by key value data and rotational transformation applied to the object in the previous keyframe by key value data, by inversely quantizing quantized rotational differential data; and
a quaternion multiplier (1140) which generates a rotational transformation value of a current keyframe by quaternion-multiplying a rotational differential value of the current keyframe by a decoded rotational transformation value of a previous keyframe.

36. The apparatus of claim 35, wherein the entropy decoder (1110) decodes each component of the key value data of the keyframes into predetermined values decoded from the bitstream if key value flags decoded from the bitstream indicate that each component of differential data of all keyframes have the same value.

37. The apparatus of claim 35 or 36, wherein the inverse circular DPCM operation comprises adding to or subtracting from the circular-DPCMed rotational differential data a maximum value in a quantization range of the rotational differential data.

38. The apparatus of claim 35, 36 or 37, wherein the inverse quantizer (1130) generates a rotational differential value by inversely quantizing three component values of a unit quaternion and restoring the other using the three restored component values.

39. A rotational differential data generating method, for generating differential data of rotational transformation values representing the rotation of an object in keyframes of a keyframe-based graphic animation, the method comprising:

   (a) generating a rotational differential value used to rotate the object by as much as a difference between a rotational transformation applied to the object in the current keyframe by key value data and a rotational transformation applied to the object in the previous keyframe by key value data; and
   (b) generating rotational differential data by quantizing the rotational differential value.

40. The method of claim 39, wherein the step (a) comprises generating a rotational differential value used to rotate the object by as much as a difference between rotation transformations applied to the object in each of the frames using a rotational transformation value of a current frame and a restored rotational transformation value of a previous frame, and further comprising the steps of:

   (c) generating a restored rotational differential value by inversely quantizing the rotational differential value; and
   (d) generating a restored rotational transformation value of a current frame by quaternion-multiplying the restored rotational differential value by a rotational transformation value of a previous frame and performing steps (a) through (d) again on the restored rotational transformation value of the current frame and a rotational transformation value of a next frame.

41. The method of claim 40, wherein in step (a), a rotational differential value is generated by quaternion-multiplying the rotational transformation value of the current frame by a conjugate of the restored rotational transformation value of the previous frame.

42. The method of claim 40 or 41, wherein in step (b), nonlinear quantization is performed so that a region having a small rotational differential value can be quantized to have a higher resolution than a region having a great rotational differential value.

43. The method of claim 40, 41 or 42, wherein in step (b), only three components among first through fourth component values of the rotational differential value represented by a quaternion are quantized.

44. The method of claim 40, 41, 42 or 43, wherein in step (b), the quantized component values of the rotational differential data are adjusted so that a component value of a rotational differential value, which has not been quantized, is restored into a real value by inversely quantizing the component values of the rotational differential data and.

45. The method of claim 44, wherein in step (b), final rotational differential data are generated by adding/subtracting a variable in a predetermined adjustment range to/from each of the quantized components of the rotational differential data or to/from each of the adjusted components of the rotational differential data.

46. The method of any of claims 40 to 45, wherein step (b) comprises:

   (b1) generating rotational differential data by quantizing three component values of the rotational differential value;
   (b2) adjusting three component values of the rotational differential data;
   (b3) inversely quantizing the adjusted component values;
   (b4) generating a restored rotational differential value by restoring one component value, which has not been quantized, using the three inversely quantized component values; and
   (b5) measuring an error between the rotational differential value and the restored rotational differential value and outputting rotational differential data having adjusted component values so that the error can be minimized.

47. The method of claim 46, wherein step (b5) comprises:

(b51) renewing an adjusted error with a current error between the rotational differential value and the restored rotational differential value if the current error is smaller than the adjusted error;

(b52) repeatedly performing steps (b2) through (b51) until the variable added to or subtracted from the rotational differential value in step (b2) is beyond the predetermined adjustment range; and

(b53) renewing a final error with the adjusted error if the adjusted error is smaller than the final error, performing steps (b2) through (b52) on adjusted rotational differential data corresponding to the adjusted error, and outputting adjusted rotational differential data corresponding the final error.

48. The method of any of claims 40 to 47, wherein in step (c), a component value of a rotational differential value, which has not been quantized, is restored by inversely quantizing the rotational differential data.

49. The method of any of claims 40 to 48, wherein step (a) further comprises (a2) detecting a rotation direction error by generating a first rotational differential value between the rotational transformation value of the current frame and the rotational transformation value of the previous frame, a second rotational differential value between the rotational transformation value of the previous frame and the restored rotational transformation value of the previous frame, and a third rotational differential value between the rotational transformation value of the current frame and the restored rotational transformation value of the previous frame.

50. The method of claim 49, wherein in step (a2), the rotational direction error is determined to have occurred when the rotation direction of the object obtained from the first rotational differential value is opposite to the rotation direction of the object obtained from the third rotational differential value, the rotation direction of the object obtained from the second rotational differential value is opposite to the rotation direction of the object obtained from the third rotational differential value, and rotation angles obtained from the first through third rotational differential values exceed a predetermined critical rotation angle.

51. A method for encoding key value data of an orientation interpolator representing the rotation of an object in each keyframe of a keyframe-based graphic animation, the method comprising:

the rotational differential data generating method of claim 39; followed by a step of

(c) entropy-encoding the rotational differential data.

52. The method of claim 51, wherein in step (a), the rotational differential value is generated by quaternion-multiplying the rotational transformation value of the current keyframe by the restored rotational transformation value of the previous keyframe.

53. The method of claim 51 or 52, wherein in step (b), nonlinear quantization is performed so that a region having a small rotational differential value can be quantized to have a higher resolution than a region having a great rotational differential value.

54. The method of claim 51, 52 or 53, wherein in step (b), the component values of the rotational differential data are adjusted so that a component value of a rotational differential value, which is restored by inversely quantizing the quantized component values of the rotational differential data and has not been quantized, can be converted into a real number.

55. The method of claim 54, wherein in step (b), the rotational differential data to be entropy-encoded are generated by adding/subtracting a variable in a predetermined adjustment range to/from each of the component values of the rotational differential data or to/from each of the adjusted component values of the rotational differential data.

56. The method of any of claims 51 to 55, wherein step (b) comprises:

(b1) generating rotational differential data by quantizing three component values of the rotational differential value;

(b2) adjusting three component values of the rotational differential data;

(b3) inversely quantizing the adjusted component values;

(b4) generating a restored rotational differential value by restoring one component value using the three inversely quantized component values; and

(b5) measuring an error between the rotational differential value and the restored rotational differential value and determining rotational differential data having adjusted component values so that the error can be minimized as rotational differential data to be entropy-encoded.

**57.** The method of claim 56, wherein step (b5) comprises:

(b51) renewing an adjusted error with a current error between the rotational differential value and the restored rotational differential value if the current error is smaller than the adjusted error;

(b52) repeatedly performing steps (b2) through (b51) until the variable added to or subtracted from the rotational differential value is beyond the predetermined adjustment range; and

(b53) renewing a final error with the adjusted error if the adjusted error is smaller than the final error, performing steps (b2) through (b52) on adjusted rotational differential data corresponding to the adjusted error, and determining adjusted rotational differential data corresponding the final error as rotational differential data to be entropy-encoded.

**58.** The method of any of claims 51 to 57, wherein step (a) comprises:

(a1) generating the rotational differential value using a rotational transformation value of the current keyframe and a restored rotational transformation value of the previous keyframe, and step (b) comprises:

(b1) generating rotational differential data by quantizing the rotational differential value;

(b2) generating a restored rotational differential value by inversely quantizing the rotational differential data; and

(b3) generating a restored rotational transformation value of the current keyframe by quaternion-multiplying the restored rotational differential value by a rotational transformation value of the previous keyframe.

**59.** The method of claim 58, wherein in step (b1), only three components among first through fourth components of the rotational differential value represented by a quaternion are quantized.

**60.** The method of any of claims 51 to 59, wherein in step (a), a first rotational differential value between the rotational transformation value of the current keyframe and the rotational transformation value of the previous keyframe, a second rotational differential value between the rotational transformation value of the previous keyframe and the restored rotational transformation value of the previous keyframe, and a third rotational differential value between the rotational transformation value of the current keyframe and the restored rotational transformation value of the previous keyframe are generated and thus it is detected whether or not a rotation direction error has occurred, which causes the decoded rotation direction of the object to be opposite to the original rotation direction.

**61.** The method of claim 60, wherein in step (a), the rotational direction error is determined to have occurred when the rotation direction of the object obtained from the first rotational differential value is opposite to the rotation direction of the object obtained from the third rotational differential value, the rotation direction of the object obtained from the second rotational differential value is opposite to the rotation direction of the object obtained from the third rotational differential value, and rotation angles obtained from the first through third rotational differential values exceed a predetermined critical rotation angle.

**62.** The method of any of claims 51 to 61, wherein step (a) comprises:

(a1) detecting whether or not a rotation direction error has occurred so that an original rotation direction of the object is opposite to a decoded rotation direction of the object depending on the rotational transformation value of the current keyframe and the restored rotational transformation value of the previous keyframe;

(a2) adjusting the rotational differential value so that the original rotation direction of the object can be the same as the decoded rotation direction of the object; and

(a3) selecting the rotational differential value or the adjusted rotational differential value in step (a2) as differential data to be quantized depending on the result of the detection performed in step (a1).

**63.** The method of claim 62, wherein step (b) comprises quantizing the rotational differential value selected in step (a3), comprising:

(b1) generating rotational differential data by quantizing three component values of the selected rotational differential value;

(b2) adjusting three quantized component values of the rotational differential data;

(b3) inversely quantizing the adjusted component values;

(b4) generating a restored rotational differential value by restoring one component value, which has not been quantized, using the three inversely quantized component values; and

(b5) measuring an error between the rotational differential value and the restored rotational differential value and renewing rotational differential data to be entropy-encoded based on the error.

64. The method of claim 63, wherein in step (b2), the three components of the rotational differential data are adjusted by adding/subtracting a variable in a predetermined adjustment range to/from each of the component values of the rotational differential data generated in step (b1) or to/from each of the component values of the rotational differential data renewed in step (b5).

65. The method of claim 63 or 64, wherein step (b5) comprises:

(b51) renewing an adjusted error with a current error between the rotational differential value and the restored rotational differential value if the current error is smaller than the adjusted error;

(b52) repeatedly performing steps (b2) through (b51) until the variable added to or subtracted from the rotational differential value is beyond the predetermined adjustment range; and

(b53) renewing a final error with the adjusted error if the adjusted error is smaller than the final error, performing steps (b2) through (b52) on adjusted rotational differential data corresponding to the adjusted error, and determining adjusted rotational differential data corresponding the final error as rotational differential data to be entropy-encoded.

66. The method of any of claims 51 to 65, further comprising (bb) generating differential data having a reduced size by performing a linear DPCM operation on the rotational differential data and performing a predetermined operation on the linear-DPCMed differential data and a maximum value in a quantization range between steps (b) and (c), wherein in step (c), the differential data, the size of which is reduced in step (bb), are entropy-encoded.

67. The method of claim 66, wherein in step (bb), the smaller ones between the linear-DPCMed differential data and differences between the linear-DPCMed differential data and the maximum value in the quantization range are output.

68. The method of claim 66 or 67, wherein step (a) comprises:

(a1) generating the rotational differential value using a rotational transformation value of the current keyframe and a restored rotational transformation value of the previous keyframe, and step (b) comprises:

(b1) generating rotational differential data by quantizing the rotational differential value;

(b2) generating a restored rotational differential value by inversely quantizing the rotational differential data; and

(b3) generating a restored rotational transformation value of the current keyframe by quaternion-multiplying the restored rotational differential value by a rotational transformation value of the previous keyframe.

69. The method of any of claims 51 to 68, wherein in step (c), rotational differential data are encoded into a series of first figures, the number of which corresponds to the magnitude of the rotational differential data, and a one-bit second figure indicating the series of first figures ends.

70. The method of any of claims 51 to 69, wherein in step (c), rotational differential data are encoded on each bit plane.

71. A method of decoding a bitstream in a keyframe-based graphic animation method, the bitstream obtained by encoding key value data of an orientation interpolator representing the rotation of an object in each keyframe, the method comprising:

restoring rotational differential data entropy-encoded by quantizing a rotational differential value representing the rotation of the object by as much as a difference between rotation transformations applied to the object by quaternion key value data of each keyframe;
restoring entropy-decoding information including an entropy decoding mode indicating an entropy decoding method for the rotational differential data;
restoring inverse circular differential pulse code modulation (DPCM) information including the order of an inverse DPCM operation, which indicates whether to perform the inverse DPCM operation on the rotational differential data entropy-decoded according to the entropy decoding mode; and
restoring quantization information including the number of inverse quantization bits which is used to restore the rotational differential value, by inverse-quantizing the rotational differential data on which the inverse circular DPCM operation has been performed according to the order of the inverse DPCM operation.

72. The method of claim 71, wherein the rotational differential data are encoded so that only three components of the rotational differential value represented by a quaternion are quantized.

73. The method of claim 72, wherein the entropy-decoding information further comprises:

a key value flag indicating whether or not rotational differential data of each component of the key value data have the same value; and
predetermined rotational differential data to be decoded into each component of rotational differential data of all key value data when the key value flag indicates that the rotational differential data of each of the components of the key value data have the same value.

74. The method of claim 71, wherein the inverse circular DPCM information further comprises intra rotational differential data used for performing the inverse circular DPCM operation on the rotational differential data.

75. A bitstream, into which key value data of an orientation interpolator representing the rotation of an object in each keyframe are encoded, the bitstream comprising:

rotational differential data entropy-encoded by quantizing a rotational differential value used to rotate the object by as much as a difference between rotational transformations applied to the object by quaternion key value data of each of the keyframes;
entropy-decoding information which comprises an entropy-decoding mode indicating an entropy-decoding method, which has been performed on the rotational differential data;
inverse circular DPCM information which comprises the order of inverse circular DPCM operation indicating whether or not an inverse circular DPCM operation will be performed on rotational differential data entropy-decoded following the entropy-decoding mode, the inverse circular DPCM operation comprising replacing DPCMed data having an absolute value less than a maximum value in a quantization range by DPCMed data of greater absolute value and opposite polarity and performing an inverse linear DPCM operation; and
inverse quantization bits which are used to restore a rotational differential value by inversely quantizing inversely circular-DPCMed rotational differential data following the order of inverse circular DPCM operation.

76. The bitstream of claim 75, wherein the rotational differential data are encoded so that only three components of a rotational differential value represented by a quaternion are quantized.

77. The bitstream of claim 75 or 76, wherein the entropy-decoding information further comprises:

a key value flag indicating whether or not rotational differential data of each component of the key value data have the same value; and
predetermined rotational differential data to be decoded into each component of rotational differential data of all key value data when the key value flag indicates that the rotational differential data of each of the components of the key value data have the same value.

78. The bitstream of claim 75, 76 or 77, wherein the inverse circular DPCM information further comprises intra rotational differential data used for performing an inverse circular DPCM operation on the rotational differential data.

79. A computer program comprising computer program code means for performing all of the steps of any of claims 39 to 74, when said program is run on a computer.

80. A computer program as claimed in claim 79, embodied on a computer readable medium.

# EP 1 322 120 B1

**Patentansprüche**

1. Vorrichtung zum Erzeugen von Rotationsdifferenzdaten für einen Orientierungsinterpolator einer key-frame-basierten graphischen Animation, wobei die Vorrichtung dazu ausgebildet ist, dass sie unter Verwendung eines Rotationstransformationswerts eines vorliegenden Key-Frames und eines wiederhergestellten Rotationstransformationswerts eines vorhergehenden Key-Frames einen Rotationsdifferenzwert erzeugt, der dazu verwendet wird, das Objekt um eine Differenz zwischen einer Rotationstransformation, die von Key-Wertdaten am Objekt im vorliegenden Key-Frame angewendet ist, und einer Rotationstransformation, die von Key-Wertdaten am Objekt im vorhergehenden Key-Frame angewendet ist, zu rotieren und Rotationsdifferenzdaten durch Quantisieren des Rotationsdifferenzwerts auszugeben.

2. Vorrichtung nach Anspruch 1, umfassend:

   einen ersten Quaternion-Multiplikator (310, 810), der einen Rotationsdifferenzwert erzeugt, der zum Rotieren eines Objekts um eine Differenz zwischen einer Rotationstransformation, die von einem Rotationstransformationswert des vorliegenden Frames am Objekt in einem vorliegenden Key-Frame angewendet ist, und einer Rotationstransformation, die von einem wiederhergestellten Rotationstransformationswert des vorhergehenden Frames am Objekt in einem vorhergehenden Key-Frame angewendet ist,
   eine Quantisierungseinheit (340, 840, 1000), die Rotationsdifferenzdaten durch Quantisieren des Rotationsdifferenzwerts erzeugt,
   eine Invers-Quantisierungseinheit (350, 850), die einen wiederhergestellten Rotationsdifferenzwert durch Invers-Quantisieren der Rotationsdifferenzdaten erzeugt, und
   einen zweiten Quaternion-Multiplikator (370, 870), der einen wiederhergestellten Rotationstransformationswert des vorliegenden Frames durch Quaternion-Multipfikation des wiederhergestellten Rotationsdifferenzwerts mit einem Rotationstransformationswert des vorhergehenden Frames erzeugt.

3. Vorrichtung nach Anspruch 2, wobei der erste Quaternion-Multiplikator (310, 810) einen Rotationsdifferenzwert durch Quaternion-Multiplikation des Rotationstransformationswerts des vorliegenden Frames mit einem Konjugat des wiederhergestellten Rotationstransformationswerts des vorhergehenden Frames erzeugt.

4. Vorrichtung nach Anspruch 2 oder 3, wobei die Quantisierungseinheit (340, 840, 1000) eine nichtlineare Quantisierung ausführt, durch die eine Region mit einem kleinen Rotationsdifferenzwert so quantisiert werden kann, dass sie eine höhere Auflösung aufweist als eine Region mit einem großen Rotationsdifferenzwert.

5. Vorrichtung nach Anspruch 2, 3 oder 4, wobei die Quantisierungseinheit (340, 840, 1000) nur drei Komponenten von der ersten bis vierten Komponente des von einem Quaternion dargestellten Rotationsdifferenzwerts quantisiert.

6. Vorrichtung nach einem der Ansprüche 2 bis 5, wobei die Quantisierungseinheit (340, 840, 1000) die Komponenten der Rotationsdifferenzdaten so anpasst, dass ein Komponentenwert eines Rotationsdifferenzwerts, der unter Verwendung der Komponentenwerte der Rotationsdifferenzdaten wiederhergestellt ist und nicht quantisiert worden ist, in eine reale Zahl umgewandelt werden kann, und die angepassten Komponenten der Rotationsdifferenzdaten ausgibt.

7. Vorrichtung nach Anspruch 6, wobei die Quantisierungseinheit (340, 840, 1000) endgültige Rotationsdifferenzdaten durch Addieren/Subtrahieren einer Variable in einem vorgegebenen Anpassungsbereich zu/von jeder der quantisierten Komponenten der Rotationsdifferenzdaten oder zu/von jeder der angepassten Komponenten der Rotationsdifferenzdaten erzeugt.

8. Vorrichtung nach einem der Ansprüche 2 bis 7, wobei die Quantisierungseinheit (1000) umfasst:

   eine Quantisierungseinrichtung (1010), die Rotationsdifferenzdaten durch Quantisieren von drei Komponentenwerten eines darin eingegebenen Rotationsdifferenzwerts erzeugt,
   eine Anpassungseinheit (1020) für quantisierte Daten, die drei Komponentenwerte von darin eingegebenen Rotationsdifferenzdaten anpasst,
   eine Invers-Quantisierungseinheit (1030), die die angepassten Komponentenwerte invers-quantisiert,
   eine Wiederherstellungseinheit (1040) für Rotationsdifferenzwerte, die einen wiederhergestellten Rotationsdifferenzwert durch Wiederherstellen eines Komponentenwerts, der nicht quantisiert worden ist, unter Verwendung der drei invers-quantisierten Komponentenwerten erzeugt, und

eine Fehlermesseinheit (1050), die einen Fehler zwischen einem in die Quantisierungseinheit eingegebenen Rotationsdifferenzwert und dem wiederhergestellten Rotationsdifferenzwert misst und Rotationsdifferenzdaten mit so angepassten Komponenten ausgibt, dass der Fehler minimiert werden kann.

9. Vorrichtung nach Anspruch 8, wobei die Fehlermesseinheit (1050) einen angepassten Fehler gegen einen vorliegenden Fehler zwischen dem in die Quantisierungseinheit (1000) eingegebenen Rotationsdifferenzwert und dem wiederhergestellten Rotationsdifferenzwert auswechselt, wenn der vorliegende Fehler kleiner ist als der angepasste Fehler, einen endgültigen Fehler gegen den angepassten Fehler auswechselt, wenn der angepasste Fehler kleiner ist als der endgültige Fehler, und angepasste Rotationsdifferenzdaten, die dem angepassten Fehler zugeordnet sind, an die Anpassungseinheit (1020) für quantisierte Daten ausgibt.

10. Vorrichtung nach einem der Ansprüche 2 bis 9, wobei die Invers-Quantisierungseinheit (350, 850) quantisierte Komponentenwerte invers-quantisiert und einen Komponentenwert, der nicht quantisiert worden ist, unter Verwendung der invers-quantisierten Komponentenwerte wiederherstellt.

11. Vorrichtung nach einem der Ansprüche 2 bis 10, weiter umfassend:

einen Rotationsrichtungsfehlerdetektor (830), der einen ersten Rotationsdifferenzwert zwischen dem Rotationstransformationswert des vorliegenden Frames und dem Rotationstransformationswert des vorhergehenden Frames, einen zweiten Rotationsdifferenzwert zwischen dem Rotationstransformationswert des vorhergehenden Frames und dem wiederhergestellten Rotationstransformationswert des vorhergehenden Frames, der vom zweiten Quaternion-Multiplikator eingegeben ist, und einen dritten Rotationsdifferenzwert zwischen dem Rotationstransformationswert des vorliegenden Frames und dem wiederhergestellten Rotationstransformationswert des vorhergehenden Frames erzeugt und detektiert, ob ein Rotationsrichtungsfehler aufgetreten ist oder nicht.

12. Vorrichtung nach Anspruch 11, wobei der Rotationsrichtungsfehlerdetektor (830) bestimmt, dass der Rotationsrichtungsfehler aufgetreten ist, wenn die Rotationsrichtung des Objekts, die vom ersten Rotationsdifferenzwert ermittelt ist, zu der Rotationsrichtung des Objekts, die vom dritten Rotationsdifferenzwert ermittelt ist, entgegengesetzt ist, die Rotationsrichtung des Objekts, die vom zweiten Rotationsdifferenzwert ermittelt ist, zu der Rotationsrichtung des Objekts, die vom dritten Rotationsdifferenzwert ermittelt ist, entgegengesetzt ist, und Rotationswinkel, die von den ersten bis dritten Rotationsdifferenzwerten ermittelt sind, einen vorgegebenen kritischen Rotationswinkel übersteigen.

13. Vorrichtung nach einem der Ansprüche 2 bis 12, weiter umfassend:

einen Rotationsrichtungsfehlerdetektor (830), der den Rotationstransformationswert des vorliegenden Frames und den wiederhergestellten Rotationstransformationswert des vorhergehenden Frames vom zweiten Quaternion-Multiplikator empfängt und detektiert, ob ein Rotationsrichtungsfehler aufgetreten ist oder nicht, so dass eine ursprüngliche Rotationsrichtung des Objekts zu einer dekodierten Rotationsrichtung des Objekts entgegengesetzt ist,
eine Rotationsrichtungskorrektureinheit (815), die den vom ersten Quaternion-Multiplikator (810) eingegebenen Rotationsdifferenzwert so anpasst, dass die ursprüngliche Rotationsrichtung des Objekts gleich der dekodierten Rotationsrichtung des Objekts sein kann und den angepassten Rotationsdifferenzwert ausgibt, und
eine Rotationsrichtungsauswahleinheit (835), die den vom ersten Quaternion-Multiplikator (810) eingegebenen Rotationstransformationswert oder den von der Rotationsrichtungskorrektureinheit (815) eingegebenen angepassten Rotationsdifferenzwert, in Abhängigkeit vom Ergebnis der Detektion, die im Rotationsrichtungsfehlerdetektor (830) ausgeführt ist, an die Quantisierungseinheit (840) ausgibt.

14. Vorrichtung nach Anspruch 13, wobei die Quantisierungseinheit (1000) umfasst:

eine Quantisierungseinrichtung (1010), die Rotationsdifferenzdaten durch Quantisieren von drei Komponentenwerten eines darin eingegebenen Rotationsdifferenzwerts erzeugt,
eine Anpassungseinheit (1020) für quantisierte Daten, die drei Komponentenwerte von darin eingegebenen Rotationsdifferenzdaten anpasst,
eine Invers-Quantisierungseinheit (1030), die die angepassten Komponentenwerte invers-quantisiert,
eine Wiederherstellungseinheit (1040) für Rotationsdifferenzwerte, die einen wiederhergestellten Rotationsdifferenzwert durch Wiederherstellen eines Komponentenwerts, der nicht quantisiert worden ist, unter Verwendung der drei invers-quantisierten Komponentenwerten erzeugt, und

eine Fehlermesseinheit (1050), die einen Fehler zwischen einem in die Quantisierungseinheit eingegebenen Rotationsdifferenzwert und dem wiederhergestellten Rotationsdifferenzwert misst und Rotationsdifferenzdaten mit so angepassten Komponenten ausgibt, dass der Fehler minimiert werden kann.

15. Vorrichtung zum Kodieren von Key-Wertdaten eines Orientierungsinterpolators, die eine Rotationstransformation eines Objekts in Key-Frames einer key-frame-basierten graphischen Animation darstellen, wobei die Vorrichtung umfasst:

eine Vorrichtung zum Erzeugen von Rotationsdifferenzdaten nach Anspruch 1, und

einen Entropie-Kodierer (450), der die Rotationsdifferenzdaten entropie-kodiert.

16. Vorrichtung nach Anspruch 15, wobei der Generator für Rotationsdifferenzdaten den Rotationsdifferenzwert durch eine Quaternion-Multiplikation des Rotationstransformationswerts eines vorliegenden Key-Frames mit einem Konjugat des wiederhergestellten Rotationstransformationswerts des vorhergehenden Frames erzeugt.

17. Vorrichtung nach Anspruch 15 oder 16, wobei der Generator für Rotationsdifferenzdaten eine nichtlineare Quantisierung ausführt, durch die eine Region mit einem kleinen Rotationsdifferenzwert so quantisiert werden kann, dass sie eine höhere Auflösung aufweist als eine Region mit einem großen Rotationsdifferenzwert.

18. Vorrichtung nach Anspruch 15, 16 oder 17, wobei der Generator für Rotationsdifferenzdaten Komponentwerte der Rotationsdifferenzdaten so anpasst, dass nicht quantisierte Komponentwerte von Rotationsdifferenzdaten durch Invers-Quantisieren quantisierter Komponentwerte von Rotationsdifferenzdaten in reale Zahlen wiederhergestellt werden können.

19. Vorrichtung nach Anspruch 18, wobei der Generator für Rotationsdifferenzdaten die Rotationsdifferenzdaten für eine Entropie-Kodierung durch Addieren/Subtrahieren einer Variable in einem vorgegebenen Anpassungsbereich zu/von jedem der quantisierten Komponentenwerte der Rotationsdifferenzdaten oder zu/von jedem der angepassten Komponentenwerte der Rotationsdifferenzdaten erzeugt.

20. Vorrichtung nach einem der Ansprüche 15 bis 19, wobei der Generator für Rotationsdifferenzdaten umfasst:

eine Quantisierungseinrichtung (1010), die Rotationsdiffierenzdaten durch Quantisieren von drei Komponentenwerten des Rotationsdifferenzwerts erzeugt,

eine Anpassungseinheit (1020) für quantisierte Daten, die drei Komponentenwerte von darin eingegebenen Rotationsdifferenzdaten anpasst,

eine Invers-Quantisierungseinheit (1030), die die angepassten Komponentenwerte invers-quantisiert,

eine Wiederherstellungseinheit (1040) für Rotationsdifferenzwerte, die einen Komponentenwert, der nicht quantisiert worden ist, unter Verwendung der drei invers-quantisierten Komponentenwerte wiederherstellt und auf diese Weise einen wiederhergestellen Rotationsdifferenzwert erzeugt, und

eine Fehlermesseinheit (1050), die einen Fehler zwischen einem in die Quantisierungseinheit eingegebenen Rotationsdifferenzwert und dem wiederhergestellten Rotationsdifferenzwert misst und Rotationsdifferenzdaten mit so angepassten Komponenten ausgibt, dass der Fehler minimiert werden kann.

21. Vorrichtung nach Anspruch 20, wobei die Fehlermesseinheit (1050) einen angepassten Fehler gegen einen vorliegenden Fehler zwischen dem in die Quantisierungseinrichtung (1010) eingegebenen Rotationsdiffierenzwert und dem wiederhergestellten Rotationsdifferenzwert auswechselt, wenn der vorliegende Fehler kleiner ist als der angepasste Fehler, einen endgültigen Fehler gegen den angepassten Fehler auswechselt, wenn der angepasste Fehler kleiner ist als der endgültige Fehler, und angepasste Rotationsdifferenzdaten, die dem angepassten Fehler zugeordnet sind, an die Anpassungseinheit (1020) für quantisierte Daten ausgibt.

22. Vorrichtung nach einem der Ansprüche 15 bis 21, wobei der Generator für Rotationsdififerenzdaten umfasst:

einen ersten Quaternion-Multiplikator (310, 810), der den Rotationsdifferenzwert unter Verwendung des Rotationstransformationswerts des vorliegenden Key-Frames und des wiederhergestellten Rotationstransformationswerts des vorhergehenden Key-Frames erzeugt,

eine Quantisierungseinheit (340, 840, 1000), die Rotationsdififerenzdaten durch Quantisieren des Rotationsdifferenzwerts erzeugt,

eine Invers-Quantisierungseinheit (350, 850), die einen wiederhergestellten Rotationsdifferenzwert durch Invers-Quantisieren der Rotationsdifferenzdaten erzeugt, und

einen zweiten Quaternion-Multiplikator (370, 870), der einen wiederhergestellten Rotationsdifferenzwert des vorliegenden Frames durch Quaternion-Multiplikation des wiederhergestellten Rotationsdifferenzwerts mit einem Rotationstransformationswert des vorhergehenden Frames erzeugt.

23. Vorrichtung nach Anspruch 22, wobei die Quantisierungseinheit (340, 840, 1000) nur drei Komponentenwerten von den ersten bis vierten Komponentenwerten des von einem Quaternion dargestellten Rotationsdifferenzwerts quantisiert.

24. Vorrichtung nach einem der Ansprüche 15 bis 23, wobei der Generator für Rotationsdifferenzdaten einen ersten Rotationsdifferenzwert zwischen dem Rotationstransformationswert des vorliegenden Key-Frames und dem Rotationstransformationswert des vorhergehenden Key-Frames, einen zweiten Rotationsdifferenzwert zwischen dem Rotationstransformationswert des vorhergehenden Key-Frames und dem wiederhergestellten Rotationstransformationswert des vorhergehenden Key-Frames und einen dritten Rotationsdifferenzwert zwischen dem Rotationstransformationswert des vorliegenden Key-Frames und dem wiederhergestellten Rotationstransformationswert des vorhergehenden Key-Frames erzeugt und detektiert, ob ein Rotationsrichtungsfehler aufgetreten ist oder nicht, so dass das Objekt in eine zur ursprünglichen Richtung entgegengesetzte Richtung rotiert.

25. Vorrichtung nach Anspruch 24, wobei der Generator für Rotationsdifferenzdaten bestimmt, dass der Rotationsrichtungsfehler aufgetreten ist, wenn die Rotationsrichtung des Objekts, die vom ersten Rotationsdifferenzwert ermittelt ist, zu der Rotationsrichtung des Objekts, die vom dritten Rotationsdifferenzwert ermittelt ist, entgegengesetzt ist, die Rotationsrichtung des Objekts, die vom zweiten Rotationsdifferenzwert ermittelt ist, zu der Rotationsrichtung des Objekts, die vom dritten Rotationsdifferenzwert ermittelt ist, entgegengesetzt ist, und Rotationswinkel, die von den ersten bis dritten Rotationsdifferenzwerten ermittelt sind, einen vorgegebenen kritischen Rotationswinkel übersteigen.

26. Vorrichtung nach einem der Ansprüche 15 bis 25, wobei der Generator für Rotationsdifferenzdaten umfasst:

einen Rotationsrichtungsfehlerdetektor (830), der ausgehend vom Rotationstransformationswert des vorliegenden Key-Frames und dem wiederhergestellten Rotationstransformationswert des vorhergehenden Key-Frames detektiert, ob der Rotationsrichtungsfehler aufgetreten ist oder nicht, so dass die ursprüngliche Rotationsrichtung des Objekts zu einer dekodierten Rotationsrichtung des Objekts entgegengesetzt ist,

eine Rotationsrichtungskorrektureinheit (815), die den Rotationsdifferenzwert so anpasst, dass die dekodierte Rotationsrichtung des Objekts zur ursprünglichen Rotationsrichtung des Objekts gleich sein kann, und

eine Rotationsrichtungsauswahleinheit (835), die entweder den Rotationsdifferenzwert oder den von der Rotationsrichtungskorrektureinheit (815) eingegebenen Rotationsdifferenzwert in Abhängigkeit vom Ergebnis der Detektion, die vom Rotationsrichtungsfehlerdetektor (830) eingegeben ist, als zu quantisierende Differenzdaten auswählt.

27. Vorrichtung nach Anspruch 26, wobei der Generator für Rotationsdifferenzdaten weiter eine Quantisierungseinheit (1000) umfasst, die die von der Rotationsrichtungsauswahleinheit ausgewählten Differenzdaten quantisiert und die quantisierten Differenzdaten ausgibt, wobei die Quantisierungseinheit (1000) umfasst:

eine Quantisierungseinrichtung (1010), die Rotationsdifferenzdaten durch Quantisieren von drei Komponentenwerten eines darin eingegebenen Rotationsdifferenzwerts erzeugt, eine Anpassungseinheit (1020) für quantisierte Daten, die drei Komponentenwerte von darin eingegebenen Rotationsdifferenzdaten anpasst, eine Invers-Quantisierungseinheit (1030), die die angepassten Komponentenwerte invers-quantisiert, eine Wiederherstellungseinheit (1040) für Rotationsdifferenzwerte, die einen wiederhergestellten Rotationsdifferenzwert durch Wiederherstellen eines Komponentenwerts, der nicht quantisiert worden ist, unter Verwendung der drei invers-quantisierten Komponentenwerten erzeugt, und eine Fehlermesseinheit (1050), die einen Fehler zwischen einem in die Quantisierungseinheit eingegebenen Rotationsdifferenzwert und dem wiederhergestellten Rotationsdifferenzwert misst und ausgehend vom gemessenen Fehler angepasste Rotationsdifferenzdaten ausgibt.

28. Vorrichtung nach Anspruch 27, wobei die Anpassungseinheit (1020) für quantisierte Daten angepasste Rotationsdifferenzdaten durch Addieren/Subtrahieren einer Variable in einem vorgegebenen Anpassungsbereich zu/von

EP 1 322 120 B1

jedem der quantisierten Komponentenwerte der Rotationsdifferenzdaten, die von der Quantisierungseinrichtung (1010) eingegeben sind, oder zu/von jedem der angepassten Komponentenwerte der Rotationsdifferenzdaten, die von der Fehlermesseinheit (1050) eingegeben sind, erzeugt.

29. Vorrichtung nach Anspruch 27 oder 28, wobei die Fehlermesseinheit (1050) einen angepassten Fehler gegen einen vorliegenden Fehler zwischen dem in die Quantisierungseinrichtung (1010) eingegebenen Rotationsdifferenzwert und dem wiederhergestellten Rotationsdifferenzwert auswechselt, wenn der vorliegende Fehler kleiner ist als der angepasste Fehler, einen endgültigen Fehler gegen den angepassten Fehler auswechselt, wenn der angepasste Fehler kleiner ist als der endgültige Fehler, und angepasste Rotationsdifferenzdaten, die dem angepassten Fehler zugeordnet sind, an die Anpassungseinheit (1020) für quantisierte Daten ausgibt.

30. Vorrichtung nach einem der Ansprüche 15 bis 29, weiter umfassend einen Circular-DPCM-Operator (400), der Differenzdaten mit einem verringerten Umfang durch Ausführen einer Linear-DPCM-Operation an den Rotationsdifferenzdaten und dann Ausführen einer vorgegebenen Operation an den einer Linear-DPCM unterzogenen Daten erzeugt, wobei die Operation Darstellen von Daten mit einem Absolutwert größer als ein Maximalwert in einem Quantisierungsbereich durch Daten mit einem kleineren Absolutwert und entgegengesetzter Polarität umfasst, wobei der Entropie-Kodierer (450) einer Linear-DPCM unterzogene Rotationsdifferenzdaten entropie-kodiert.

31. Vorrichtung nach Anspruch 30, wobei der Circular-DPCM-Operator (400) die kleineren von den einer Linear-DPCM unterzogenen Differenzdaten und Differenzen zwischen den einer Linear-DPCM unterzogenen Differenzdaten und dem Maximalwert im Quantisierungsbereich ausgibt.

32. Vorrichtung nach Anspruch 30 oder 31, wobei der Generator für Rotationsdifferenzdaten umfasst:

einen ersten Quaternion-Multiplikator (310, 810), der den Rotationsdifferenzwert unter Verwendung eines Rotationstransformationswerts eines vorliegenden Key-Frames und eines wiederhergestellten Rotationstransformationswerts eines vorhergehenden Key-Frames erzeugt,
eine Quantisierungseinheit (340, 840, 1000), die Rotationsdifferenzdaten durch Quantisieren des Rotationsdifferenzwerts erzeugt,
eine Invers-Quantisierungseinheit (350, 850), die einen wiederhergestellten Rotationsdifferenzwert durch Invers-Quantisieren der Rotationsdifferenzdaten erzeugt, und
einen zweiten Quaternion-Muftiplikator (370, 870), der einen wiederhergestellten Rotationstransformationswert des vorliegenden Key-Frames durch Quaternion-Multiplikation des wiederhergestellten Rotationsdifferenzwerts mit einem Rotationstransformationswert des vorhergehenden Key-Frames erzeugt.

33. Vorrichtung nach einem der Ansprüche 15 bis 32, wobei der Entropie-Kodierer (450) zu kodierende Rotationsdifferenzdaten in eine Reihe von ersten Zahlen, deren Anzahl dem Umfang der zu kodierenden Rotationsdifferenzdaten zugeordnet ist, und eine zweite Zahl von einem Bit kodiert, die angibt, dass die Reihe von ersten Zahlen endet.

34. Vorrichtung nach einem der Ansprüche 15 bis 33, wobei der Entropie-Kodierer (450) auf jeder Bitebene zu kodierende Rotationsdifferenzdaten kodiert.

35. Vorrichtung zum Dekodieren eines Bitstroms, in den Key-Wertdaten eines Orientierungsinterpolators, der die Rotationstransformation eines Objekts in Key-Frames darstellt, kodiert werden, wobei die Vorrichtung umfasst:

einen Entropie-Dekodierer (1110), der durch Entropie-Dekodieren des Bitstroms einer Circular-DPCM-Operation unterzogene Rotationsdifferenzdaten oder quantisierte Rotationsdifferenzdaten erzeugt,
einen Invers-Circular-DPCM-Operator (1120), der quantisierte Rotationsdifferenzdaten durch Ausführen einer Invers-Circular-DPCM-Operation an den vom Entropie-Dekodierer (1110) eingegebenen RotationsDifferenzdaten erzeugt, in Abhängigkeit von der aus dem Bitstrom dekodierten Abfolge der DPCM, wobei die Invers-Circular-DPCM-Operation Ersetzen von einer DPCM unterzogenen Daten mit einem Absolutwert kleiner als ein Maximalwert in einem Quantisierungsbereich durch einer DPCM unterzogene Daten mit einem größeren Absolutwert und entgegengesetzter Polarität und Ausführen einer Invers-Linear-DPCM-Operation umfasst,
eine Invers-Quantisierungseinheit (1130), die Rotationsdifferenzdaten, die verwendet werden, um ein Objekt um eine Differenz zwischen einer Rotationstransformation, die von Key-Wertdaten am Objekt im vorliegenden Key-Frame angewendet ist, und einer Rotationstransformation, die von Key-Wertdaten am Objekt im vorhergehenden Key-Frame angewendet ist, zu rotieren, durch Invers-Quantisieren von quantisierten Rotationsdifferenzdaten erzeugt, und

43

einen Quaternion-Multiplikator (1140), der einen Rotationstransformationswert eines vorliegenden Key-Frames durch eine Quaternion-Multiplikation eines Rotationsdifferenzwerts des vorliegenden Key-Frames mit einem dekodierten Rotationstransformationswert eines vorhergehenden Key-Frames erzeugt.

36. Vorrichtung nach Anspruch 35, wobei der Entropie-Dekodierer (1110) jede Komponente der Key-Wertdaten der Key-Frames in vorgegebene Werte dekodiert, die aus dem Bitstrom dekodiert sind, wenn aus dem Bitstrom dekodierte Key-Wert-Flags anzeigen, dass jede Komponente von Differenzdaten aller Key-Frames den gleichen Wert aufweisen.

37. Vorrichtung nach Anspruch 35 oder 36, wobei die Invers-Circular-DPCM-Operation Addieren oder Subtrahieren eines Maximalwerts in einem Quantisierungsbereich der Rotationsdifferenzdaten zu oder von den einer Circular-DPCM unterzogenen Rotationsdifferenzdaten umfasst.

38. Vorrichtung nach Anspruch 35, 36 oder 37, wobei die Invers-Quantisierungseinheit (1130) einen Rotationsdifferenzwert durch Invers-Quantisieren von drei Komponentenwerten einer Quaternioneinheit und Wiederherstellen der anderen unter Verwendung der drei wiederhergestellten Komponentenwerte erzeugt.

39. Verfahren zum Erzeugen von Rotationsdifferenzdaten zum Erzeugen von Differenzdaten von Rotationstransformationswerten, die die Rotation eines Objekts in Key-Frames einer key-frame-basierten graphischen Animation darstellen, wobei das Verfahren umfasst:

(a) Erzeugen eines Rotationsdifferenzwerts, der dazu verwendet wird, das Objekt um eine Differenz zwischen einer Rotationstransformation, die von Key-Wertdaten am Objekt im vorliegenden Key-Frame angewendet ist, und einer Rotationstransformation, die von Key-Wertdaten am Objekt im vorhergehenden Key-Frame angewendet ist, zu rotieren und
(b) Erzeugen von Rotationsdifferenzdaten durch Quantisieren des Rotationsdifferenzwerts.

40. Verfahren nach Anspruch 39, wobei Schritt (a) umfasst:

Erzeugen eines Rotationsdifferenzwerts, der dazu verwendet wird, das Objekt um eine Differenz zwischen Rotationstransformationen, die in jedem der Frames am Objekt angewendet sind, zu rotieren, unter Verwendung eines Rotationstransformationswerts eines vorliegenden Frames und eines wiederhergestellten Rotationstransformationswerts eines vorhergehenden Frames, und weiter umfassend die Schritte:

(c) Erzeugen eines wiederhergestellten Rotationsdifferenzwerts durch Invers-Quantisieren des Rotationsdifferenzwerts und
(d) Erzeugen eines wiederhergestellten Rotationstransformationswerts eines vorliegenden Frames durch Quaternion-Multiplikation des wiederhergestellten Rotationsdifferenzwerts mit einem Rotationstransformationswert eines vorhergehenden Frames und wiederholtes Ausführen der Schritte (a) bis (d) am wiederhergestellten Rotationstransformationswert des vorliegenden Frames und einem Rotationstransformationswert eines nächsten Frames.

41. Verfahren nach Anspruch 40, wobei in Schritt (a) ein Rotationsdifferenzwert durch Quaternion-Multiplikation des Rotationstransformationswerts des vorliegenden Frames mit einem Konjugat des wiederhergestellten Rotationstransformationswerts des vorhergehenden Frames erzeugt wird.

42. Verfahren nach Anspruch 40 oder 41, wobei in Schritt (b) eine nichtlineare Quantisierung derart ausgeführt wird, dass eine Region mit einem kleinen Rotationsdifferenzwert so quantisiert werden kann, dass sie eine höhere Auflösung aufweist als eine Region mit einem großen Rotationsdifferenzwert.

43. Verfahren nach Anspruch 40, 41 oder 42, wobei in Schritt (b) nur drei Komponenten vom ersten bis vierten Komponentenwert des von einem Quaternion dargestellten Rotationsdifferenzwerts quantisiert werden.

44. Verfahren nach Anspruch 40, 41, 42 oder 43, wobei in Schritt (b) die quantisierten Komponentenwerte der Rotationsdifferenzwerte so angepasst werden, dass ein Komponentenwert eines Rotationsdifferenzwerts, der nicht quantisiert worden ist, durch Invers-Quantisieren der Komponentenwerte der Rotationsdifferenzdaten in einen realen Wert umgewandelt werden.

**45.** Verfahren nach Anspruch 44, wobei in Schritt (b) die endgültigen Rotationsdifferenzdaten durch Addieren/Subtrahieren einer Variable in einem vorgegebenen Anpassungsbereich zu/von jeder der quantisierten Komponenten der Rotationsdifferenzdaten oder zu/von jeder der angepassten Komponenten der Rotationsdifferenzdaten erzeugt werden.

**46.** Verfahren nach einem der Ansprüche 40 bis 45, wobei Schritt (b) umfasst:

(b1) Erzeugen von Rotationsdifferenzdaten durch Quantisieren von drei Komponentenwerten des Rotationsdifferenzwerts,
(b2) Anpassen von drei Komponentenwerten der Rotationsdifferenzdaten,
(b3) Invers-Quantisieren der angepassten Komponentenwerte,
(b4) Erzeugen eines wiederhergestellten Rotationsdifferenzwerts durch Wiederherstellen eines Komponentenwerts, der nicht quantisiert worden ist, unter Verwendung der drei invers-quantisierten Komponentenwerte und
(b5) Messen eines Fehlers zwischen dem Rotationsdifferenzwert und dem wiederhergestellten Rotationsdifferenzwert und Ausgeben von Rotationsdifferenzdaten mit so angepassten Komponentenwerken, dass der Fehler minimiert werden kann.

**47.** Verfahren nach Anspruch 46, wobei Schritt (b5) umfasst:

(b51) Auswechseln eines angepassten Fehlers gegen einen vorliegenden Fehler zwischen dem Rotationsdifferenzwert und dem wiederhergestellten Rotationsdifferenzwert, wenn der vorliegende Fehler kleiner ist als der angepasste Fehler,
(b52) Wiederholtes Ausführen der Schritte (b2) bis (b51), bis die in Schritt (b2) zum Rotationsdifferenzwert hinzuaddierte oder davon subtrahierte Variable unter dem vorgegebenen Anpassungsbereich liegt, und
(b53) Auswechseln eines endgültigen Fehlers gegen einen angepassten Fehler, wenn der angepasste Fehler kleiner ist als der endgültige Fehler, Ausführen der Schritte (b2) bis (b52) an angepassten Rotationsdifferenzdaten, die dem angepassten Fehler zugeordnet sind, und Ausgeben von angepassten Rotationsdifferenzdaten, die dem endgültigen Fehler zugeordnet sind.

**48.** Verfahren nach einem der Ansprüche 40 bis 47, wobei in Schritt (c) ein Komponentenwert eines Rotationsdifferenzwerts, der nicht quantisiert worden ist, durch Invers-Quantisieren der Rotationsdifferenzdaten wiederhergestellt wird.

**49.** Verfahren nach einem der Ansprüche 40 bis 48, wobei Schritt (a) weiter umfasst:

(a2) Detektieren eines Rotationsrichtungsfehlers durch Erzeugen eines ersten Rotationsdifferenzwerts zwischen dem Rotationstransformationswert des vorliegenden Frames und dem Rotationstransformationswert des vorhergehenden Frames, eines zweiten Rotationsdifferenzwerts zwischen dem Rotationstransformationswert des vorhergehenden Frames und dem wiederhergestellten Rotationstransformationswert des vorhergehenden Frames, und eines dritten Rotationsdifferenzwerts zwischen dem Rotationstransformationswert des vorliegenden Frames und dem wiederhergestellten Rotationstransformationswert des vorhergehenden Frames.

**50.** Verfahren nach Anspruch 49, wobei in Schritt (a2) bestimmt wird, dass der Rotationsrichtungsfehler aufgetreten ist, wenn die Rotationsrichtung des Objekts, die vom ersten Rotationsdifferenzwert ermittelt ist, zu der Rotationsrichtung des Objekts, die vom dritten Rotationsdifferenzwert ermittelt ist, entgegengesetzt ist, die Rotationsrichtung des Objekts, die vom zweiten Rotationsdifferenzwert ermittelt ist, zu der Rotationsrichtung des Objekts, die vom dritten Rotationsdifferenzwert ermittelt ist, entgegengesetzt ist, und Rotationswinkel, die von den ersten bis dritten Rotationsdifferenzwerten ermittelt sind, einen vorgegebenen kritischen Rotationswinkel übersteigen.

**51.** Verfahren zum Kodieren von Key-Wertdaten eines Orientierungsinterpolators, die die Rotation eines Objekts in jedem Key-Frame einer key-frame-basierten graphischen Animation darstellen, wobei das Verfahren umfasst:

das Verfahren zum Erzeugen von Rotationsdifferenzdaten nach Anspruch 39, gefolgt von einem Schritt zum

(c) Entropie-Kodieren der Rotationsdifferenzdaten.

**52.** Verfahren nach Anspruch 51, wobei in Schritt (a) der Rotationsdifferenzwert durch Quaternion-Multiplikation des Rotationstransformationswerts des vorliegenden Key-Frames mit dem wiederhergestellten Rotationstransformationswert des vorhergehenden Key-Frames erzeugt wird.

53. Verfahren nach Anspruch 51 oder 52, wobei in Schritt (b) eine nichtlineare Quantisierung derart ausführt wird, dass eine Region mit einem kleinen Rotationsdifferenzwert so quantisiert werden kann, dass sie eine höhere Auflösung aufweist als eine Region mit einem großen Rotationsdifferenzwert.

54. Verfahren nach Anspruch 51, 52 oder 53, wobei in Schritt (b) die Komponentenwerte der Rotationsdifferenzdaten so angepasst werden, dass ein Komponentenwert eines Rotationsdifferenzwerts, der durch Invers-Quantisieren der quantisierten Komponentenwerte der Rotationsdifferenzdaten wiederhergestellt und nicht quantisiert worden ist, in eine reale Zahl umgewandelt werden kann.

55. Verfahren nach Anspruch 54, wobei in Schritt (b) die Rotationsdifferenzdaten für eine Entropie-Kodierung durch Addieren/Subtrahieren einer Variable in einem vorgegebenen Anpassungsbereich zu/von jedem der quantisierten Komponentenwerte der Rotationsdifferenzdaten oder zu/von jedem der angepassten Komponentenwerte der Rotationsdifferenzdaten erzeugt werden.

56. Verfahren nach einem der Ansprüche 51 bis 55, wobei Schritt (b) umfasst:

(b1) Erzeugen von Rotationsdifferenzdaten durch Quantisieren von drei Komponentenwerten des Rotationsdifferenzwerts,
(b2) Anpassen von drei Komponentenwerten der Rotationsdifferenzdaten,
(b3) Invers-Quantisieren der angepassten Komponentenwerte,
(b4) Erzeugen eines wiederhergestellten Rotationsdifferenzwerts durch Wiederherstellen eines Komponentenwerts unter Verwendung der drei invers-quantisierten Komponentenwerten und
(b5) Messen eines Fehlers zwischen dem Rotationsdifferenzwert und dem wiederhergestellten Rotationsdifferenzwert und Bestimmen von Rotationsdifferenzdaten mit angepassten Komponentenwerten als Rotationsdifferenzdaten für eine Entropie-Kodierung, so dass der Fehler minimiert werden kann.

57. Verfahren nach Anspruch 56, wobei Schritt (b5) umfasst:

(b51) Auswechseln eines angepassten Fehlers gegen einen vorliegenden Fehler zwischen dem Rotationsdifferenzwert und dem wiederhergestellten Rotationsdifferenzwert, wenn der vorliegende Fehler kleiner ist als der angepasste Fehler,
(b52) Wiederholtes Ausführen der Schritte (b2) bis (b51), bis die zum Rotationsdifferenzwert hinzuaddierte oder davon subtrahierte Variable unterdem vorgegebenen Anpassungsbereich liegt, und
(b53) Auswechseln eines endgültigen Fehlers gegen den angepassten Fehler, wenn der angepasste Fehler kleiner ist als der endgültige Fehler, Ausführen der Schritte (b2) bis (b52) an angepassten Rotationsdifferenzdaten, die dem angepassten Fehler zugeordnet sind, und Bestimmen von angepassten Rotationsdifferenzdaten, die dem endgültigen Fehler zugeordnet sind, als Rotationsdifferenzdaten für eine Entropie-Kodierung.

58. Verfahren nach einem der Ansprüche 51 bis 57, wobei Schritt (a) umfasst:

(a1) Erzeugen des Rotationsdifferenzwerts unter Verwendung eines Rotationstransformationswerts des vorliegenden Key-Frames und eines wiederhergestellten Rotationstransformationswerts des vorhergehenden Key-Frames, wobei Schritt (b) umfasst:

(b1) Erzeugen von Rotationsdifferenzdaten durch Quantisieren des Rotationsdifferenzwerts,
(b2) Erzeugen eines wiederhergestellten Rotationsdifferenzwerts durch Invers-Quantisieren der Rotationsdifferenzdaten und
(b3) Erzeugen eines wiederhergestellten Rotationstransformationswerts des vorliegenden Key-Frames durch Quaternion-Multiplikation des wiederhergestellten Rotationsdifferenzwerts mit einem Rotationstransformationswerts des vorhergehenden Key-Frames.

59. Verfahren nach Anspruch 58, wobei in Schritt (b1) nur drei Komponenten von der ersten bis vierten Komponente des von einem Quaternion dargestellten Rotationsdifferenzwerts quantisiert werden.

60. Verfahren nach einem der Ansprüche 51 bis 59, wobei in Schritt (a) in erster Rotationsdifferenzwert zwischen dem Rotationstransformationswert des vorliegenden Key-Frames und dem Rotationstransformationswert des vorhergehenden Key-Frames,
ein zweiter Rotationsdifferenzwert zwischen dem Rotationstransformationswert des vorhergehenden Key-Frames und dem wiederhergestellten Rotationstransformationswert des vorhergehenden Key-Frames, und ein dritter Rotationsdifferenzwert zwischen dem Rotationstransformationswert des vorliegenden Key-Frames und dem wiederhergestellten Rotationstransformationswert des vorhergehenden Key-Frames erzeugt werden und auf diese Weise detektiert wird, ob ein Rotationsrichtungsfehler aufgetreten ist oder nicht, was dazu führt, dass die dekodierte Rotationsrichtung des Objekts zur ursprünglichen Rotationsrichtung des Objekts entgegengesetzt ist.

61. Verfahren nach Anspruch 60, wobei in Schritt (a) bestimmt wird, dass der Rotationsrichtungsfehler aufgetreten ist, wenn die Rotationsrichtung des Objekts, die vom ersten Rotationsdifferenzwert ermittelt ist, zu der Rotationsrichtung des Objekts, die vom dritten Rotationsdifferenzwert ermittelt ist, entgegengesetzt ist, die Rotationsrichtung des Objekts, die vom zweiten Rotationsdifferenzwert ermittelt ist, zu der Rotationsrichtung des Objekts, die vom dritten Rotationsdifferenzwert ermittelt ist, entgegengesetzt ist, und Rotationswinkel, die von den ersten bis dritten Rotationsdifferenzwerten ermittelt sind, einen vorgegebenen kritischen Rotationswinkel übersteigen.

62. Verfahren nach einem der Ansprüche 51 bis 61, wobei Schritt (a) umfasst:

(a1) Detektieren, ob ein Rotationsrichtungsfehler aufgetreten ist oder nicht, so dass eine ursprüngliche Rotationsrichtung des Objekts zu einer dekodierten Rotationsrichtung des Objekts entgegengesetzt ist, in Abhängigkeit vom Rotationstransformationswert des vorliegenden Key-Frames und dem wiederhergestellten Rotationstransformationswert des vorhergehenden Key-Frames,
(a2) Anpassen des Rotationsdifferenzwerts so, dass die ursprüngliche Rotationsrichtung des Objekts zur dekodierten Rotationsrichtung des Objekts gleich sein kann, und
(a3) Auswählen des Rotationsdifferenzwerts oder des angepassten Rotationsdifferenzwerts in Schritt (a2) als zu quantisierende Differenzdaten in Abhängigkeit vom Ergebnis der in Schritt (a1) ausgeführten Detektion.

63. Verfahren nach Anspruch 62, wobei Schritt (b) Quantisieren des in Schritt (a3) ausgewählten Rotationsdifferenzwerts umfasst, umfassend:

(b1) Erzeugen von Rotationsdifferenzdaten durch Quantisieren von drei Komponentenwerten des ausgewählten Rotationsdifferenzwerts,
(b2) Anpassen von drei Komponentenwerten der Rotationsdifferenzdaten,
(b3) Invers-Quantisieren der angepassten Komponentenwerte,
(b4) Erzeugen eines wiederhergestellten Rotationsdifferenzwerts durch Wiederherstellen eines Komponentenwerts, der nicht quantisiert worden ist, unter Verwendung der drei invers-quantisierten Komponentenwerte und
(b5) Messen eines Fehlers zwischen dem Rotationsdifferenzwert und dem wiederhergestellten Rotationsdifferenzwert und Auswechseln von Rotationsdifferenzdaten für eine Entropie-Kodierung ausgehend von dem Fehler.

64. Verfahren nach Anspruch 63, wobei in Schritt (b2) die drei Komponenten der Rotationsdifferenzdaten durch Addieren/Subtrahieren einer Variable in einem vorgegebenen Anpassungsbereich zu/von jedem der Komponentenwerte der in Schritt (b1) erzeugten Rotationsdifferenzdaten oder zu/von jedem der Komponentenwerte der in Schritt (b5) ausgewechselten Rotationsdifferenzdaten angepasst werden.

65. Verfahren nach Anspruch 63 oder 64, wobei Schritt (b5) umfasst:

(b51) Auswechseln eines angepassten Fehlers gegen einen vorliegenden Fehler zwischen dem Rotationsdifferenzwert und dem wiederhergestellten Rotationsdifferenzwert, wenn der vorliegende Fehler kleiner ist als der angepasste Fehler,
(b52) Wiederholtes Ausführen der Schritte (b2) bis (b51), bis die zum Rotationsdifferenzwert hinzuaddierte oder davon subtrahierte Variable unter dem vorgegebenen Anpassungsbereich liegt, und
(b53) Auswechseln eines endgültigen Fehlers gegen den angepassten Fehler, wenn der angepasste Fehler kleiner ist als der endgültige Fehler, Ausführen der Schritte (b2) bis (b52) an angepassten Rotationsdifferenzdaten, die dem angepassten Fehler zugeordnet sind, und Bestimmen von angepassten Rotationsdifferenzdaten, die dem endgültigen Fehler zugeordnet sind, als Rotationsdifferenzdaten für eine Entropie-Kodierung.

66. Verfahren nach einem der Ansprüche 51 bis 65, weiter umfassend:

(bb) Erzeugen von Differenzdaten mit einem verringerten Umfang durch Ausführen einer Linear-DPCM-Operation an den Rotationsdifferenzdaten und Ausführen einer vorgegebenen Operation an den einer Linear-DPCM unterzogenen Daten und einem Maximalwert in einem Quantisierungsbereich zwischen den Schritten (b) und (c), wobei in Schritt (c) die Differenzdaten, deren Umfang in Schritt (bb) verringert worden ist, entropie-kodiert werden.

67. Verfahren nach Anspruch 66, wobei in Schritt (bb) die kleineren von den einer Linear-DPCM unterzogenen Differenzdaten und Differenzen zwischen den einer Linear-DPCM unterzogenen Differenzdaten und dem Maximalwert im Quantisierungsbereich ausgegeben werden.

68. Verfahren nach Anspruch 66 oder 67, wobei Schritt (a) umfasst:

(a1) Erzeugen des Rotationsdifferenzwerts unter Verwendung eines Rotationstransformationswerts des vorliegenden Key-Frames und eines wiederhergestellten Rotationstransformationswerts des vorhergehenden Key-Frames, wobei Schritt (b) umfasst:

(b1) Erzeugen von Rotationsdifferenzdaten durch Quantisieren des Rotationsdifferenzwerts,
(b2) Erzeugen eines wiederhergestellten Rotationsdifferenzwerts durch Invers-Quantisieren der Rotationsdifferenzdaten und
(b3) Erzeugen eines wiederhergestellten Rotationstransformationswerts des vorliegenden Key-Frames durch Quaternion-Multiplikation des wiederhergestellten Rotationsdifferenzwerts mit einem Rotationstransformationswert des vorhergehenden Key-Frames.

69. Verfahren nach einem der Ansprüche 51 bis 68, wobei in Schritt (c) Rotationsdifferenzdaten in eine Reihe von ersten Zahlen, deren Anzahl dem Umfang der Rotationsdifferenzdaten zugeordnet ist, und eine zweite Zahl von einem Bit kodiert werden, die angibt, dass die Reihe von ersten Zahlen endet.

70. Verfahren nach einem der Ansprüche 51 bis 69, wobei in Schritt (c) Rotationsdifferenzdaten in jeder Bitebene kodiert werden.

71. Verfahren zum Dekodieren eines Bitstroms in einem key-frame-basierten graphischen Animationsverfahren, wobei der Bitstrom durch Kodieren von Key-Wertdaten eines Orientierungsinterpolators, der die Rotation eines Objekts in jedem Key-Frame darstellt, erhalten ist, wobei das Verfahren umfasst:

Wiederherstellen von Rotationsdifferenzdaten, die entropie-kodiert sind durch Quantisieren eines Rotationsdifferenzwerts, der die Rotation des Objekts um eine Differenz zwischen Rotationstransformationen, die von Quaternion-Key-Wertdaten jedes Key-Frames am Objekt angewendet sind, darstellt,
Wiederherstellen von Entropie-Dekodierungsinformationen mit einem Entropie-Dekodierungsmodus, die ein Entropie-Dekodierungsverfahren für die Rotationsdifferenzdaten anzeigen,
Wiederherstellen von Invers-Circular-Differential-Pulse-Code-Modulation(DPCM)-Informationen mit der Abfolge einer Invers-DPCM-Operation, die anzeigen, ob die Invers-DPCM-Operation an den nach dem Entropie-Dekodierungsmodus entropie-dekodierten Rotationsdifferenzdaten auszuführen ist, und
Wiederherstellen von Quantisierungsinformationen mit der Anzahl an Invers-Quantisierungsbits, die verwendet werden, um den Rotationsdifferenzwert wiederherzustellen, durch Invers-Quantisieren der Rotationsdifferenzdaten, an denen die Invers-Circular-DPCM-Operation gemäß der Abfolge einer Invers-DPCM-Operation ausgeführt worden ist.

72. Verfahren nach Anspruch 71, wobei die Rotationsdifferenzdaten so kodiert werden, dass nur drei Komponenten des von einem Quaternion dargestellten Rotationsdifferenzwerts quantisiert werden.

73. Verfahren nach Anspruch 72, wobei die Entropie-Dekodierungsinformationen weiter umfassen:

ein Key-Wert-Flag, das anzeigt, ob Rotationsdifferenzdaten jeder Komponente von Key-Wertdaten den gleichen Wert aufweisen oder nicht, und
vorgegebene Rotationsdifferenzdaten, die in jede Komponente von Rotationsdifferenzdaten aller Key-Wertdaten zu dekodieren sind, wenn das Key-Wert-Flag anzeigt, dass die Rotationsdifferenzdaten jeder der Komponenten von Key-Wertdaten den gleichen Wert aufweisen.

**74.** Verfahren nach Anspruch 71, wobei die Invers-Circular-DPCM-Informationen weiter Intra-Rotationsdifferenzdaten umfassen, die zum Ausführen der Invers-Circular-DPCM-Operation an den Rotationsdifferenzdaten verwendet werden.

**75.** Bitstrom, in den Key-Wertdaten eines Orientierungsinterpolators, der die Rotation eines Objekts in jedem Key-Frame darstellt, kodiert sind, wobei der Bitstrom umfasst:

Rotationsdifferenzdaten, die entropie-kodiert sind durch Quantisieren eines Rotationsdifferenzwerts, der zum Rotieren des Objekts um eine Differenz zwischen Rotationstransformationen, die von Quaternion-Key-Wertdaten jedes Key-Frames am Objekt angewendet sind, verwendet ist,
Entropie-Dekodierungsinformationen, die einen Entropie-Dekodierungsmodus umfassen, die ein Entropie-Dekodierungsverfahren anzeigen, das an den Rotationsdifferenzdaten ausgeführt worden ist, Invers-Circular-DPCM-Informationen, die die Abfolge einer Invers-Circular-DPCM-Operation umfasst, die angeben, ob eine Invers-Circular-DPCM-Operation an nach dem Entropie-Dekodierungsmodus entropie-dekodierten Rotationsdifferenzdaten ausgeführt wird oder nicht, wobei die Invers-Circular-DPCM-Operation Ersetzen von einer DPCM unterzogenen Daten mit einem Absolutwert kleiner als ein Maximalwert in einem Quantisierungsbereich durch einer DPCM unterzogene Daten mit einem größeren Absolutwert und entgegengesetzter Polarität und Ausführen einer Invers-Linear-DPCM-Operation umfasst, und
Invers-Quantisierungsbits, die zum Wiederherstellen eines Rotationsdifferenzwert durch Invers-Quantisieren von einer Invers-Circular-DPCM-Operation unterzogenen Rotationsdifferenzdaten gemäß der Abfolge einer Invers-Circular-DPCM-Operation verwendet werden.

**76.** Bitstrom nach Anspruch 75, wobei die Rotationsdifferenzdaten so kodiert sind, dass nur drei Komponenten des von einem Quaternion dargestellten Rotationsdifferenzwerts quantisiert sind.

**77.** Bitstrom nach Anspruch 75 oder 76, wobei die Entropie-Dekodierungsinformationen weiter umfassen:

ein Key-Wert-Flag, das anzeigt, ob Rotationsdifferenzdaten jeder Komponente von Key-Wertdaten den gleichen Wert aufweisen oder nicht, und
vorgegebene Rotationsdifferenzdaten, die in jede Komponente von Rotationsdifferenzdaten aller Key-Wertdaten zu dekodieren sind, wenn das Key-Wert-Flag anzeigt, dass die Rotationsdifferenzdaten jeder der Komponenten von Key-Wertdaten den gleichen Wert aufweisen.

**78.** Bitstrom nach Anspruch 75, 76 oder 77, wobei die Invers-Circular-DPCM-Informationen weiter Intra-Rotationsdifferenzdaten umfassen, die zum Ausführen einer Invers-Circular-DPCM-Operation an den Rotationsdifferenzdaten verwendet werden.

**79.** Computerprogramm umfassend Computerprogrammkodemittel zum Ausführen aller Schritte nach einem der Ansprüche 39 bis 74, wenn das Programm auf einem Computer läuft.

**80.** Computerprogramm nach Anspruch 79, das auf einem computerfesbaren Medium ausgebildet ist.

**Revendications**

**1.** Appareil de génération de données différentielles de rotation pour un interpolateur d'orientation d'une animation graphique basée sur des images clés, l'appareil étant conçu pour générer, à l'aide d'une valeur de transformation rotationnelle d'une image clé courante et d'une valeur de transformation rotationnelle restaurée d'une image clé précédente, une valeur différentielle rotationnelle utilisée pour faire tourner l'objet d'autant qu'une différence entre une transformation rotationnelle appliquée à l'objet dans l'image clé courante par les données de valeurs clés et une transformation rotationnelle appliquée à l'objet dans l'image clé précédente par les données de valeurs clés, et produire les données différentielles de rotation en quantifiant la valeur différentielle de rotation.

**2.** Appareil selon la revendication 1, comprenant :

un premier multiplicateur de quaternions (310, 810) qui génère une valeur de rotation différentielle utilisée pour faire tourner un objet d'autant qu'une différence entre la transformation rotationnelle appliquée à l'objet dans une image clé courante par une valeur de transformation rotationnelle de l'image courante et une transformation rotationnelle appliquée à l'objet dans une image clé précédente par une valeur de transformation rotationnelle restaurée de l'image précédente ;

une unité de quantification (340, 840, 1000) qui génère des données différentielles rotationnelles en quantifiant la valeur différentielle rotationnelle ;

une unité de quantification inverse (350, 850) qui génère une valeur différentielle rotationnelle restaurée en quantifiant inversement les données différentielles rotationnelles ; et un second multiplicateur de quaternions (370, 870) qui génère une valeur de transformation rotationnelle restaurée de l'image courante par multiplication de quaternions de la valeur différentielle rotationnelle restaurée par une valeur de transformation rotationnelle de l'image précédente.

3. Appareil selon la revendication 2, dans lequel le premier multiplicateur de quarternions (310, 810) génère une valeur différentielle de rotation par multiplication de quaternions de la valeur de transformation rotationnelle de l'image courante par un conjugué de la valeur de transformation rotationnelle restaurée de l'image précédente.

4. Appareil selon la revendication 2 ou 3, dans lequel l'unité de quantification (340, 840, 1000) effectue une quantification non linéaire au moyen de laquelle une région ayant une faible valeur différentielle de rotation peut être quantifiée pour avoir une résolution plus élevée qu'une région ayant une valeur différentielle de rotation importante.

5. Appareil selon la revendication 2, 3 ou 4, dans lequel l'unité de quantification (340, 840, 1000) quantifie uniquement trois composantes parmi les première à quatrième composantes de la valeur différentielle de rotation représentées par un quaternion.

6. Appareil selon l'une quelconque des revendications 2 à 5, dans lequel l'unité de quantification (340, 840, 1000) ajuste les composantes des données différentielles de rotation de sorte qu'une valeur de composante d'une valeur différentielle de rotation, qui est restaurée à l'aide des valeurs de composantes des données différentielles de rotation et n'a pas été quantifiée, peut être convertie en un nombre réel et produit en sortie les composantes ajustées des données différentielles de rotation.

7. Appareil selon la revendication 6, dans lequel l'unité de quantification (340, 840, 1000) génère des données différentielles de rotation finales en ajoutant/soustrayant une variable dans une plage d'ajustement prédéterminée à/de chacune des composantes quantifiées des données différentielles de rotation ou à/de chacune des composantes ajustées des données différentielles de rotation.

8. Appareil selon l'une quelconque des revendications 2 à 7, dans lequel l'unité de quantification (1000) comprend :

un quantificateur (1010) qui génère des données différentielles de rotation en quantifiant trois valeurs de composantes d'une valeur différentielle de rotation entrée dans celui-ci ;

un ajusteur de données quantifiées (1020) qui ajuste trois valeurs de composantes de données différentielles de rotation entrées dans celui-ci ;

un quantificateur inverse (1030) qui quantifie de façon inverse les valeurs de composantes ajustées ;

un restaurateur de valeur différentielle de rotation (1040) qui génère une valeur différentielle de rotation restaurée en restaurant une valeur de composante, qui n'a pas été quantifiée, à l'aide des trois valeurs de composantes quantifiées de façon inverse ; et

une unité de mesure d'erreur (1050) qui mesure une erreur entre une valeur différentielle de rotation entrée dans l'unité de quantification et la valeur différentielle de rotation restaurée et produit en sortie des données différentielles de rotation ayant des composantes ajustées de sorte que l'erreur peut être minimisée.

9. Appareil selon la revendication 8, dans lequel l'unité de mesure d'erreur (1050) renouvelle une erreur ajustée avec une erreur courante entre la valeur différentielle de rotation entrée dans l'unité de quantification (1000) et la valeur différentielle de rotation restaurée si l'erreur courante est plus petite que l'erreur ajustée, renouvelle une erreur finale avec l'erreur ajustée si l'erreur ajustée est plus petite que l'erreur finale, et produit les données différentielles de rotation ajustées correspondant à l'erreur ajustée en sortie vers l'ajusteur de données quantifiées (1020).

10. Appareil selon l'une quelconque des revendications 2 à 9, dans lequel le quantificateur inverse (350, 850) quantifie de façon inverse les valeurs de composantes et restaure une valeur de composante, qui n'a pas été quantifiée, à l'aide des valeurs de composantes quantifiées de façon inverse.

11. Appareil selon l'une quelconque des revendications 2 à 10, comprenant en outre un détecteur d'erreur de direction de rotation (830) qui génère une première valeur différentielle de rotation entre la valeur de transformation rotationnelle de l'image courante et la valeur de transformation rotationnelle de l'image précédente, une deuxième valeur différentielle de rotation entre la valeur de transformation rotationnelle de l'image précédente et la valeur de transformation rotationnelle restaurée de l'image précédente entrée à partir du second multiplicateur de quaternions, et une troisième valeur différentielle de rotation entre la valeur de transformation rotationnelle de l'image courante et la valeur de transformation rotationnelle restaurée de l'image précédente et détecte si une erreur de direction de rotation s'est produite ou non.

**12.** Appareil selon la revendication 11, dans lequel le détecteur d'erreur de direction de rotation (830) détermine que l'erreur de direction de rotation s'est produite lorsque la direction de rotation de l'objet obtenue à partir de la première valeur différentielle de rotation est opposée à la direction de rotation de l'objet obtenue à partir de la troisième valeur différentielle de rotation, la direction de rotation de l'objet obtenue à partir de la deuxième valeur différentielle de rotation est opposée à la direction de rotation de l'objet obtenue à partir de la troisième valeur différentielle de rotation, et les angles de rotation obtenus à partir des première à troisième valeurs différentielles de rotation dépassent un angle de rotation critique prédéterminé.

**13.** Appareil selon l'une quelconque des revendications 2 à 12, comprenant en outre :

un détecteur d'erreur de direction de rotation (830) qui reçoit la valeur de transformation rotationnelle de l'image courante et la valeur de transformation rotationnelle restaurée de l'image précédente à partir du second multiplicateur de quaternions et détecte si une erreur de direction de rotation s'est ou non produite de sorte qu'une direction de rotation originale de l'objet est opposée à une direction de rotation décodée de l'objet ;
un correcteur de direction de rotation (815) qui ajuste l'entrée de valeur différentielle de rotation provenant du premier multiplicateur de quaternions (810) de sorte que la direction de rotation originale de l'objet peut être identique à la direction de rotation décodée de l'objet et produit en sortie la valeur différentielle de rotation ajustée ; et
un sélecteur de direction de rotation (835) qui produit en sortie l'entrée de valeur de transformation rotationnelle à partir du premier multiplicateur de quaternions (810) ou la valeur différentielle de rotation ajustée entrée à partir du correcteur de direction de rotation (815) vers l'unité de quantification (840) en fonction du résultat de la détection effectuée dans le détecteur d'erreur de direction de rotation (830).

**14.** Appareil selon la revendication 13, dans lequel l'unité de quantification (1000) comprend :

un quantificateur (1010) qui génère des données différentielles de rotation en quantifiant trois valeurs de composantes d'une valeur différentielle de rotation entrée dans celui-ci ;
un ajusteur de données quantifiées (1020) qui ajuste trois valeurs de composantes de données différentielles de rotation entrées dans celui-ci ;
un quantificateur inverse (1030) qui quantifie de façon inverse les valeurs de composantes ajustées ;
un restaurateur de valeur différentielle de rotation (1040) qui génère une valeur différentielle de rotation restaurée en restaurant une valeur de composante, qui n'a pas été quantifiée, en utilisant les trois valeurs de composantes quantifiées de façon inverse ; et
une unité de mesure d'erreur (1050) qui mesure une erreur entre une valeur différentielle de rotation entrée dans l'unité de quantification et la valeur différentielle de rotation restaurée et produit en sortie des données différentielles de rotation ayant des valeurs de composantes ajustées de sorte que l'erreur peut être minimisée.

**15.** Appareil destiné à coder les données de valeurs clés d'un interpolateur d'orientation représentant la transformation rotationnelle d'un objet dans des images clés d'une animation graphique basée sur des images clés, l'appareil comprenant :

l'appareil de génération de données différentielles de rotation selon la revendication 1 ; et
un codeur entropique (450) qui code de façon entropique les données différentielles de rotation.

**16.** Appareil selon la revendication 15, dans lequel le générateur de données différentielles de rotation génère la valeur différentielle de rotation par multiplication de quaternions de la valeur de transformation rotationnelle de l'image clé courante par un conjugué de la valeur de transformation rotationnelle restaurée de l'image clé précédente.

**17.** Appareil selon la revendication 15 ou 16, dans lequel le générateur de données différentielles de rotation effectue une quantification non linéaire au moyen de laquelle une région ayant une faible valeur différentielle de rotation peut être quantifiée pour avoir une résolution plus élevée qu'une région ayant une valeur différentielle de rotation importante.

18. Appareil selon la revendication 15, 16 ou 17, dans lequel le générateur de données différentielles de rotation ajuste les valeurs de composantes des données différentielles de rotation de sorte que les valeurs de composantes non quantifiées des données différentielles de rotation peuvent être restaurées en nombre réels par quantification inverse des valeurs de composantes quantifiées des données différentielles de rotation.

19. Appareil selon la revendication 18, dans lequel le générateur de données différentielles de rotation génère les données différentielles de rotation devant faire l'objet d'un codage entropique en ajoutant/soustrayant une variable dans une plage d'ajustement prédéterminée à/de chacune des valeurs de composantes quantifiées des données différentielles de rotation ou à/de chacune des valeurs de composantes ajustées des données différentielles de rotation.

20. Appareil selon l'une quelconque des revendications 15 à 19, dans lequel le générateur de données différentielles de rotation comprend :

un quantificateur (1010) qui génère des données différentielles de rotation en quantifiant trois valeurs de composantes de la valeur différentielle de rotation ;

un ajusteur de données quantifiées (1020) qui ajuste trois valeurs de composantes des données différentielles de rotation entrées dans celui-ci ;

un quantificateur inverse (1030) qui quantifie de façon inverse les valeurs de composantes ajustées ;

un restaurateur de valeur différentielle de rotation (1040) qui restaure une valeur de composante, qui n'a pas été quantifiée, en utilisant les trois valeurs de composantes quantifiées de façon inverse et génère ainsi une valeur différentielle de rotation restaurée ; et

une unité de mesure d'erreur (1050) qui mesure une erreur entre une valeur différentielle de rotation entrée dans le quantificateur et la valeur différentielle de rotation restaurée et produit en sortie les données différentielles de rotation ayant des valeurs de composants ajustées de sorte que l'erreur peut être minimisée.

21. Appareil selon la revendication 20, dans lequel l'unité de mesure d'erreur (1050) renouvelle une erreur ajustée avec une erreur courante entre la valeur différentielle de rotation entrée dans le quantificateur (1010) et la valeur différentielle de rotation restaurée si l'erreur courante est plus petite que l'erreur ajustée, renouvelle une erreur finale avec l'erreur ajustée si l'erreur ajustée est plus petite que l'erreur finale, et produit en sortie les données différentielles de rotation ajustées correspondant à l'erreur ajustée vers l'ajusteur de données quantifiées (1020).

22. Appareil selon l'une quelconque des revendications 15 à 21, dans lequel le générateur de données différentielles de rotation comprend :

un premier multiplicateur de quaternions (310, 810) qui génère la valeur différentielle de rotation en utilisant la valeur de transformation rotationnelle de l'image clé courante et la valeur de transformation rotationnelle restaurée de l'image clé précédente ;

un quantificateur (340, 840, 1000) qui génère des données différentielles de rotation en quantifiant les valeurs différentielles de rotation ;

un quantificateur inverse (350, 850) qui génère une valeur différentielle de rotation restaurée en quantifiant de façon inverse les données différentielles de rotation ; et

un second multiplicateur de quaternions (370, 870) qui génère une valeur différentielle de rotation restaurée de l'image clé courante par multiplication des quaternions de la valeur différentielle de rotation restaurée par une valeur de transformation rotationnelle de l'image clé précédente.

23. Appareil selon la revendication 22, dans lequel le quantificateur (340, 840, 1000) quantifie uniquement trois valeurs de composantes parmi les première à quatrième valeurs de composantes de la valeur différentielle de rotation représentées par un quaternion.

24. Appareil selon l'une quelconque des revendications 15 à 23, dans lequel le générateur de données différentielles de rotation génère une première valeur différentielle de rotation entre la valeur de transformation rotationnelle de l'image clé courante et la valeur de transformation rotationnelle de l'image clé précédente, une deuxième valeur différentielle de rotation entre la valeur de transformation rotationnelle de l'image clé précédente et la valeur de transformation rotationnelle restaurée de l'image clé précédente, et une troisième valeur différentielle de rotation entre la valeur de transformation rotationnelle de l'image clé courante et la valeur de transformation rotationnelle restaurée de l'image clé précédente et détecte si une erreur de direction de rotation s'est produite ou non de sorte que l'objet tourne dans une direction opposée à une direction originale.

25. Appareil selon la revendication 24, dans lequel le générateur de données différentielles de rotation détermine que l'erreur de direction de rotation s'est produite lorsque la direction de rotation de l'objet obtenue à partir de la première valeur différentielle de rotation est opposée à la direction de rotation de l'objet obtenue à partir de la troisième valeur différentielle de rotation, la direction de rotation de l'objet obtenue à partir de la deuxième valeur différentielle de rotation est opposée à la direction de rotation de l'objet obtenue à partir de la troisième valeur différentielle de rotation, et les angles de rotation obtenus à partir des première à troisième valeurs différentielles de rotation dépassent un angle de rotation critique prédéterminé.

26. Appareil selon l'une quelconque des revendications 15 à 25, dans lequel le générateur de données différentielles de rotation comprend :

un détecteur d'erreur de direction de rotation (830) qui détecte si l'erreur de direction de rotation s'est produite de sorte que la direction de rotation originale de l'objet est opposée à une direction de rotation décodée de l'objet, sur la base de la valeur de transformation rotationnelle de l'image clé courante et de la valeur de transformation rotationnelle restaurée de l'image clé précédente ;

un correcteur de direction de rotation (815) qui ajuste la valeur différentielle de rotation de sorte que la direction de rotation décodée de l'objet peut être identique à la direction de rotation originale de l'objet ; et

un sélecteur de direction de rotation (835) qui choisit soit la valeur différentielle de rotation soit la valeur différentielle de rotation entrée à partir du correcteur de direction de rotation (815) en tant que données différentielles devant être quantifiées, en fonction du résultat de la détection entrée à partir du détecteur d'erreur de direction de rotation (830).

27. Appareil selon la revendication 26, dans lequel le générateur de données différentielles de rotation comprend une unité de quantification (1000) qui quantifie les valeurs différentielles choisies par le sélecteur de direction de rotation et produit en sortie les données différentielles quantifiées et l'unité de quantification (1000) comprend :

un quantificateur (1010) qui génère des données différentielles de rotation en quantifiant trois valeurs de composantes d'une valeur différentielle de rotation entrée dans celui-ci ;

un ajusteur de données quantifiées (1020) qui ajuste trois valeurs de composantes de données différentielles de rotation entrées dans celui-ci ,

un quantificateur d'image (1030) qui quantifie de façon inverse les valeurs de composantes ajustées ;

un restaurateur de valeur différentielle de rotation (1040) qui génère une valeur différentielle de rotation restaurée en restaurant une valeur de composante, qui n'a pas été quantifiée, à l'aide des trois valeurs de composantes quantifiées de façon inverse ; et

une unité de mesure d'erreur (1050) qui mesure une erreur entre une valeur différentielle de rotation entrée dans l'unité de quantification et la valeur différentielle de rotation restaurée et produit en sortie des données différentielles de rotation ajustées sur la base de l'erreur mesurée.

28. Appareil selon la revendication 27, dans lequel l'ajusteur de données quantifiées (1020) génère des données différentielles de rotation ajustées en ajoutant/soustrayant une variable dans une plage d'ajustement prédéterminée à/de chacune des valeurs de composantes quantifiées des données différentielles de rotation entrées à partir du quantificateur (1010) ou à/de chacune des valeurs composantes ajustées des données différentielles de rotation entrées à partir de l'unité de mesure d'erreur (1050).

29. Appareil selon la revendication 27 ou 28, dans lequel l'unité de mesure d'erreur (1050) renouvelle une erreur ajustée avec une erreur courante entre la valeur différentielle de rotation entrée dans le quantificateur (1010) et la valeur différentielle de rotation restaurée si l'erreur de courant est plus petite que l'erreur ajustée, renouvelle une erreur finale avec l'erreur ajustée si l'erreur ajustée est plus petite que l'erreur finale, et produit en sortie les données différentielles de rotation ajustées correspondant à l'erreur ajustée vers l'ajusteur de données quantifiées (1020).

30. Appareil selon l'une quelconque des revendications 15 à 29, comprenant en outre un opérateur MICD circulaire (400) qui génère des données différentielles ayant une taille réduite en effectuant une opération MICD linéaire sur les données différentielles de rotation et en effectuant ensuite une opération prédéterminée sur les données différentielles MICDées de façon linéaire, l'opération comprenant la représentation de données ayant une valeur absolue supérieure à une valeur maximale dans une plage de quantification représentée par des données ayant une valeur absolue inférieure et une polarité opposée,

dans lequel le codeur entropique (450) code de façon entropique les données différentielles de rotation MICDées de façon circulaire.

31. Appareil selon la revendication 30, dans lequel l'opérateur MICD circulaire (400) produit en sortie les données les plus petites entre les données différentielles MICDées de façon circulaire et les différences entre les données différentielles MICDées de façon linéaire et la valeur maximale dans la plage de quantification.

32. Appareil selon la revendication 30 ou 31, dans lequel le générateur de données différentielles de rotation comprend :

un premier multiplicateur de quaternions (310, 810) qui génère la valeur différentielle de rotation à l'aide d'une valeur de transformation rotationnelle d'une image clé courante et d'une valeur de transformation rotationnelle restaurée d'une image clé précédente ;

un quantificateur (340, 840, 1000) qui génère des données différentielles de rotation en quantifiant la valeur différentielle de rotation ;

un quantificateur inverse (350, 850) qui génère une valeur différentielle restaurée en quantifiant de façon inverse les données différentielles de rotation ; et

un second multiplicateur de quaternions (370, 870) qui génère une valeur de transformation rotationnelle restaurée de l'image clé courante par multiplication de quaternions de la valeur différentielle de rotation restaurée par une valeur de transformation rotationnelle de l'image clé précédente.

33. Appareil selon l'une quelconque des revendications 15 à 32, dans lequel le codeur entropique (450) code les données différentielles de rotation devant être codées en une série de premières figures, dont le nombre correspond à la grandeur des données différentielles de rotation devant être codées, et une seconde figure monobit indiquant que la série de première figures se terminé.

34. Appareil selon l'une quelconque des revendications 15 à 33, dans lequel le codeur entropique (450) code les données différentielles de rotation devant être codées sur chaque plan binaire.

35. Appareil destiné à décoder un train de bits, dans lequel les données de valeurs clés d'un interpolateur d'orientation représentant la transformation rotationnelle d'un objet dans les images clés sont codées, l'appareil comprenant :

un décodeur entropique (1110) qui génère des données différentielles de rotation MICDées de façon circulaire ou des données différentielles de rotation quantifiées par décodage entropique du train de bits ;

un opérateur MICD circulaire inverse (1120) qui génère des données différentielles de rotation quantifiées en effectuant une opération MICD circulaire inverse sur les données différentielles de rotation entrées à partir du décodeur entropique (1110) en fonction de l'ordre du MICD décodé à partir du train de bits, l'opération MICD circulaire inverse comprenant le remplacement des données MICDées ayant une valeur absolue inférieure à une valeur maximale dans une plage de quantification par des données MICDées de valeur absolue plus grande et de polarité opposée et effectuer une opération MICD linéaire inverse ;

un quantificateur inverse (1130) qui génère des données différentielles de rotation, utilisées pour faire tourner un objet d'autant qu'une différence entre la transformation rotationnelle appliquée à l'objet dans l'image clé courante par les données de valeurs clés et la transformation rotationnelle appliquée à l'objet dans l'image clé précédente par les données de valeurs clés, en quantifiant de façon inverse les données différentielles de rotation quantifiées ; et

un multiplicateur de quaternions (1140) qui génère une valeur de transformation rotationnelle d'une image clé courante par multiplication de quaternions d'une valeur différentielle de rotation de l'image clé courante par une valeur de transformation rotationnelle décodée d'une image clé précédente.

36. Appareil selon la revendication 35, dans lequel le décodeur entropique (1110) décode chaque composante des données de valeurs clés des images clés en valeur prédéterminées décodées à partir du train de bits si les indicateurs de valeurs clés décodés à partir du train de bits indiquent que chaque composante de données différentielles de l'ensemble des images clés a la même valeur.

37. Appareil selon la revendication 35 ou 36, dans lequel l'opération MICD circulaire inverse comprend l'ajout ou à la soustraction des données différentielles de rotation MICDées de façon circulaire d'une valeur maximale dans une plage de quantification des données différentielles de rotation.

**38.** Appareil selon la revendication 35, 36 ou 37, dans lequel le quantificateur inverse (1130) génère une valeur différentielle de rotation en quantifiant de façon inverse trois valeurs de composantes d'un quaternion unitaire et en restaurant l'autre à l'aide des trois valeurs de composantes restaurées.

**39.** Procédé de génération de données différentielles de rotation, destiné à générer des données différentielles de valeurs de transformation rotationnelle représentant la rotation d'un objet dans des images clés d'une animation graphique basée sur des images clés, le procédé consistant à :

(a) générer une valeur différentielle de rotation utilisée pour faire tourner l'objet d'autant qu'une différence entre une transformation rotationnelle appliquée à l'objet dans l'image clé courante par des données de valeurs clés et une transformation rotationnelle appliquée à l'objet dans l'image clé précédente par des données de valeurs clés ; et
(b) générer des données différentielles de rotation par quantification de la valeur différentielle de rotation.

**40.** Procédé selon la revendication 39, dans lequel l'étape (a) consiste à

(a) générer une valeur de rotation différentielle utilisée pour faire tourner un objet d'autant qu'une différence entre les transformations de rotation appliquées à l'objet dans chacune des images en utilisant une valeur de transformation rotationnelle d'une image courante et une valeur de transformation rotationnelle restaurée d'une image précédente comprenant les étapes consistant à :
(c) générer une valeur différentielle de rotation restaurée en quantifiant de façon inverse la valeur différentielle de rotation ; et
(d) générer une valeur de transformation rotationnelle restaurée d'une image courante par multiplication de quaternions de la valeur différentielle de rotation restaurée par une valeur de transformation rotationnelle d'une image précédente et en effectuant à nouveau les étapes (a) à (d) sur la valeur de transformation rotationnelle restaurée de l'image courante et une valeur de transformation rotationnelle d'une image suivante.

**41.** Procédé selon la revendication 40, dans lequel dans l'étape (a), une valeur différentielle de rotation est générée par multiplication de quaternions de la valeur de transformation rotationnelle de l'image courante par un conjugué de la valeur de transformation rotationnelle restaurée de l'image précédente.

**42.** Procédé selon la revendication 40 ou 41, dans lequel dans l'étape (b), une quantification non linéaire est effectuée de sorte qu'une région ayant une faible valeur différentielle de rotation peut être quantifiée pour avoir une résolution plus élevée qu'une région ayant une valeur différentielle de rotation importante.

**43.** Procédé selon la revendication 40, 41 ou 42, dans lequel dans l'étape (b), seules trois composantes parmi les première à quatrième valeurs de composantes de la valeur différentielle de rotation représentées par un quaternion sont quantifiées.

**44.** Procédé selon la revendication 40, 41, 42 ou 43, dans lequel dans l'étape (b), les valeurs de composantes quantifiées des données différentielles de rotation sont ajustées de sorte qu'une valeur de composante d'une valeur différentielle de rotation, qui n'a pas été quantifiée, est restaurée en une valeur réelle par quantification inverse des valeurs de composantes des données différentielles de rotation.

**45.** Procédé selon la revendication 44, dans lequel dans l'étape (b) des données différentielles de rotation finales sont générées en ajoutant/soustrayant une variable dans une plage d'ajustement prédéterminée à/de chacune des composantes quantifiées des données différentielles de rotation ou à/de chacune des composantes ajustées des données différentielles de rotation.

**46.** Procédé selon l'une quelconque des revendications 40 à 45, dans lequel l'étape (b) consiste à :

(b1) générer des données différentielles de rotation en quantifiant trois valeurs de composantes de la valeur différentielle de rotation ;
(b2) ajuster trois valeurs de composantes des données différentielles de rotation ;
(b3) quantifier de façon inverse les valeurs de composantes ajustées ;
(b4) générer une valeur différentielle de rotation restaurée en restaurant une valeur de composante, qui n'a pas été quantifiée, à l'aide des trois valeurs de composantes quantifiées de façon inverse ; et
(b5) mesurer une erreur entre la valeur différentielle de rotation et la valeur différentielle de rotation restaurée et produire en sortie des données différentielles de rotation ayant des valeurs de composantes ajustées de sorte que l'erreur peut être minimisée.

**47.** Procédé selon la revendication 46, dans lequel l'étape (b5) consiste à :

(b51) renouveler une erreur ajustée avec une erreur courante entre la valeur différentielle de rotation et la valeur différentielle de rotation restaurée si l'erreur courante est plus petite que l'erreur ajustée,

(b52) effectuer les étapes (b2) à (b51) de façon répétée jusqu'à ce que la variable ajoutée à la valeur différentielle de rotation ou soustraite de celle-ci dans l'étape (b2) soit au-delà de la plage d'ajustement prédéterminée ; et

(b53) renouveler une erreur finale avec l'erreur ajustée si l'erreur ajustée est plus petite que l'erreur finale, effectuer les étapes (b2) à (b52) sur les données différentielles de rotation ajustées correspondant à l'erreur ajustée, et produire en sortie les données différentielles de rotation ajustées correspondant à l'erreur finale.

**48.** Procédé selon l'une quelconque des revendications 40 à 47, dans lequel dans l'étape (c), une valeur de composante d'une valeur différentielle de rotation, qui n'a pas été quantifiée, est restaurée en quantifiant de façon inverse les données différentielles de rotation.

**49.** Procédé selon l'une quelconque des revendications 40 à 48, dans lequel l'étape (a) consiste en outre à (a2) détecter une erreur de direction de rotation en générant une première valeur différentielle de rotation entre la valeur de transformation rotationnelle de l'image courante et la valeur de transformation rotationnelle de l'image précédente, une deuxième valeur différentielle de rotation entre la valeur de transformation rotationnelle de l'image précédente et la valeur de transformation rotationnelle restaurée de l'image précédente, et une troisième valeur différentielle de rotation entre la valeur de transformation rotationnelle de l'image courante et la valeur de transformation rotationnelle restaurée de l'image précédente.

**50.** Procédé selon la revendication 49, dans lequel dans l'étape (a2), il est déterminé que l'erreur de direction de rotation s'est produite lorsque la direction de rotation de l'objet obtenue à partir de la première valeur différentielle de rotation est opposée à la direction de rotation de l'objet obtenue à partir de la troisième valeur différentielle de rotation, la direction de rotation de l'objet obtenue à partir de la deuxième valeur différentielle de rotation est opposée à la direction de rotation de l'objet obtenue à partir de la troisième valeur différentielle de rotation, et les angles de rotation obtenus à partir des première à troisième valeurs différentielles de rotation dépassent un angle de rotation critique prédéterminé.

**51.** Procédé de codage de données de valeurs clés d'un interpolateur d'orientation représentant la rotation d'un objet dans chaque image clé d'une animation graphique basée sur des images clés, le procédé comprenant :

le procédé de génération de données différentielles de rotation de la revendication 39 ; suivi par une étape de (c) codage entropique des données différentielles de rotation.

**52.** Procédé selon la revendication 51, dans lequel dans l'étape (a), la valeur différentielle de rotation est générée par multiplication de quaternions de la valeur de transformation rotationnelle de l'image clé courante par la valeur de transformation rotationnelle restaurée de l'image clé précédente.

**53.** Procédé selon la revendication 51 ou 52, dans lequel dans l'étape (b), une quantification non linéaire est effectuée de sorte qu'une région ayant une faible valeur différentielle de rotation peut être quantifiée pour avoir une résolution plus élevée qu'une région ayant une valeur différentielle de rotation importante.

**54.** Procédé selon la revendication 51, 52 ou 53, dans lequel dans l'étape (b), les valeurs de composantes des données différentielles de rotation sont ajustées de sorte qu'une valeur de composante d'une valeur différentielle de rotation, qui est restaurée en quantifiant de façon inverse les valeurs de composantes quantifiées des données différentielles de rotation et n'a pas été quantifiée, peut être convertie en un nombre réel.

**55.** Procédé selon la revendication 54, dans lequel dans l'étape (b), les données différentielles de rotation devant faire l'objet d'un codage entropique sont générées en ajoutant/soustrayant une variable dans une plage d'ajustement prédéterminée à/de chacune des valeurs de composantes des données différentielles de rotation ou à/de chacune des valeurs de composantes ajustées des données différentielles de rotation.

**56.** Procédé selon l'une quelconque des revendications 51 à 55, dans lequel l'étape (b) consiste à :

(b1) générer des données différentielles de rotation en quantifiant trois valeurs de composantes de la valeur différentielle de rotation ;

(b2) ajuster trois valeurs de composantes des données différentielles de rotation ;

(b3) quantifier de façon inverse les valeurs de composantes ajustées ;

(b4) générer une valeur différentielle de rotation restaurée en restaurant une valeur de composante en utilisant les trois valeurs de composantes quantifiées de façon inverse ; et

(b5) mesurer une erreur entre la valeur différentielle de rotation et la valeur différentielle de rotation restaurée et déterminer les données différentielles de rotation ayant des valeurs de composantes ajustées de sorte que l'erreur peut être minimisée en tant que données différentielles de rotation devant être codées de façon entropique.

**57.** Procédé selon la revendication 56, dans lequel l'étape (b5) consiste à :

(b51) renouveler une erreur ajustée avec une erreur courante entre la valeur différentielle de rotation et la valeur différentielle de rotation restaurée si l'erreur courante est plus petite que l'erreur ajustée ;

(b52) effectuer de façon répétée les étapes (b2) à (b51) jusqu'à ce que la variable ajoutée à la valeur différentielle de rotation ou soustraite à celle-ci soit au-delà de la plage d'ajustement prédéterminée ; et

(b53) renouveler une erreur finale avec l'erreur ajustée si l'erreur ajustée est plus petite que l'erreur finale, effectuer les étapes (b2) à (b52) sur les données différentielles de rotation ajustées correspondant à l'erreur ajustée, et déterminer les données différentielles de rotation ajustées correspondant à l'erreur finale en tant que données différentielles de rotation devant être codées de façon entropique.

**58.** Procédé selon l'une quelconque des revendications 51 à 57, dans lequel l'étape (a) consiste à :

(a1) générer la valeur différentielle de rotation en utilisant une valeur de transformation rotationnelle de l'image clé courante et une valeur de transformation rotationnelle restaurée de l'image clé précédente, et l'étape (b) consiste à :

(b1) générer des données différentielles de rotation en quantifiant la valeur différentielle de rotation ;

(b2) générer une valeur différentielle de rotation restaurée en quantifiant de façon inverse les données différentielles de rotation ; et

(b3) générer une valeur de transformation rotationnelle restaurée de l'image clé courante par multiplication de quaternions de la valeur différentielle de rotation restaurée par une valeur de transformation rotationnelle de l'image clé précédente.

**59.** Procédé selon la revendication 58, dans lequel dans l'étape (b1), seules trois composantes parmi les première à quatrième valeurs de composantes de la valeur différentielle de rotation représentées par un quaternion sont quantifiées.

**60.** Procédé selon l'une quelconque des revendications 51 à 59, dans lequel dans l'étape (a), une première valeur différentielle de rotation entre la valeur de transformation rotationnelle de l'image clé courante et la valeur de transformation rotationnelle de l'image clé précédente, une deuxième valeur différentielle de rotation entre la valeur de transformation rotationnelle de l'image clé précédente et la valeur de transformation rotationnelle restaurée de l'image clé précédente, et une troisième valeur différentielle de rotation entre la valeur de transformation rotationnelle de l'image clé courante et la valeur de transformation rotationnelle restaurée de l'image clé précédente sont générées et ainsi, ceci permettant de détecter si une erreur de direction de rotation s'est produite ou non, la direction de rotation décodée de l'objet étant de ce fait opposée à la direction de rotation originale.

**61.** Procédé selon la revendication 60, dans lequel dans l'étape (a), l'erreur de direction de rotation est déterminée comme s'étant produite lorsque la direction de rotation de l'object obtenue à partir de la première valeur différentielle de rotation est opposée à la direction de rotation de l'objet obtenue à partir de la troisième valeur différentielle de rotation, la direction de rotation de l'objet obtenue à partir de la deuxième valeur différentielle de rotation est opposée à la direction de rotation de l'objet obtenue à partir de la troisième valeur différentielle de rotation, et les angles de rotation obtenus à partir des première à troisième valeurs différentielles de rotation dépassent un angle de rotation critique prédéterminée.

**62.** Procédé selon l'une quelconque des revendications 51 à 61, dans lequel l'étape (a) consiste à :

(a1) détecter si l'erreur de direction de rotation s'est produite ou non de sorte qu'une direction de rotation originale de l'objet est opposée à une direction de rotation décodée de l'objet en fonction de la valeur de transformation rotationnelle de l'image clé courante et de la valeur de transformation rotationnelle restaurée de l'image clé précédente ;

(a2) ajuster la valeur différentielle de rotation de sorte que la direction de rotation originale de l'objet puisse être identique à la direction de rotation décodée de l'objet ; et

(a3) sélectionner la valeur différentielle de rotation ou la valeur différentielle de rotation ajustée dans l'étape (a2) en tant que données différentielles devant être quantifiées en fonction du résultat de la détection effectuée dans l'étape (a1).

63. Procédé selon la revendication 62, dans laquelle l'étape (b) comprend la quantification de la valeur différentielle de rotation choisie dans l'étape (a3), consistant à :

(b1) générer des données différentielles de rotation en quantifiant trois valeurs de composantes d'une valeur différentielle de rotation sélectionnée ;

(b2) ajuster trois valeurs de composantes quantifiées des données différentielles de rotation ,

(b3) quantifier de façon inverse les valeurs de composantes ajustées ;

(b4) générer une valeur différentielle de rotation restaurée en restaurant une valeur de composante, qui n'a pas été quantifiée, en utilisant les trois valeurs de composantes quantifiées de façon inverse ; et

(b5) mesurer une erreur entre une valeur différentielle de rotation et la valeur différentielle de rotation restaurée et renouveler les données différentielles de rotation devant faire l'objet d'un codage entropique sur la base de l'erreur.

64. Procédé selon la revendication 63, dans lequel dans l'étape (b2), les trois composantes des données différentielles de rotation sont ajustées en ajoutant/soustrayant une variable dans une plage d'ajustement prédéterminée à/de chacune des valeurs de composantes des données différentielles de rotation dans l'étape (b1) ou à/de chacune des valeurs de composantes des données différentielles de rotation renouvelées dans l'étape (b5).

65. Procédé selon la revendication 63 ou 64, dans lequel l'étape (b5) consiste à :

(b51) renouveler une erreur ajustée avec une erreur courante entre la valeur différentielle de rotation et la valeur différentielle de rotation restaurée si l'erreur courante est plus petite que l'erreur ajusté ;

(b52) effectuer les étapes (b2) à (b51) de façon répétée jusqu'à ce que la variable ajoutée à la valeur différentielle de rotation ou soustraite de celle-ci soit au-delà de la plage d'ajustement prédéterminée ; et

(b53) renouveler une erreur finale avec l'erreur ajustée si l'erreur ajustée est plus petite que l'erreur finale, effectuer les étapes (b2) à (b52) sur les données différentielles de rotation ajustées correspondant à l'erreur ajustée, et déterminer les données différentielles de rotation ajustées correspondant à l'erreur finale en tant que données différentielles de rotation devant être codées de façon entropique.

66. Procédé selon l'une quelconque des revendications 51 à 65, consistant en outre à (bb) générer des données différentielles ayant une taille réduite en effectuant une opération MICD linéaire sur les données différentielles de rotation et en effectuant une opération prédéterminée sur les données différentielles MICDées de façon linéaire et une valeur maximale dans une plage de quantification entre les étapes (b) et (c),

dans lequel dans l'étape (c), les données différentielles, dont la taille est réduite dans l'étape (bb), sont codées de façon entropique.

67. Procédé selon la revendication 66, dans lequel dans l'étape (bb), les plus petites entre les données différentielles MICDées de façon circulaire et les différences entre les données différentielles MICDées de façon linéaire et la valeur maximale dans la plage de quantification sont produites en sortie.

68. Procédé selon la revendication 66 ou 67, dans lequel l'étape (a) consiste à :

(a1) générer la valeur différentielle de rotation en utilisant une valeur de transformation rotationnelle de l'image clé courante et une valeur de transformation rotationnelle restaurée de l'image clé précédente, et l'étape (b) consiste à :

(b1) générer des données différentielles de rotation en quantifiant la valeur différentielle de rotation ;

(b2) générer une valeur différentielle de rotation restaurée en quantifiant de façon inverse les données différentielles de rotation ; et

(b3) générer une valeur de transformation rotationnelle restaurée de l'image clé courante par multiplication de quaternions de la valeur différentielle de rotation restaurée par une valeur de transformation rotationnelle de l'image clé précédente.

69. Procédé selon l'une quelconque des revendications 51 à 68, dans lequel dans l'étape (c), les données différentielles de rotation sont codées en une série de premières figures, dont le nombre correspond à la grandeur des données différentielles de rotation devant être codées, et une seconde figure monobit indiquant que la série de première figures se termine.

70. Procédé selon l'une quelconque des revendications 51 à 69, dans lequel dans l'étape (c), les données différentielles de rotation sont codées sur chaque plan binaire.

71. Procédé de décodage d'un train de bits dans un procédé d'animation graphique basée sur des images clés, le train de bits obtenu par codage de données de valeurs clés d'un interpolateur d'orientation représentant la rotation d'un objet dans chaque image clé, le procédé consistant à :

restaurer les données différentielles de rotation codées de façon entropique en quantifiant une valeur différentielle de rotation représentant la rotation de l'objet d'autant qu'une différence entre les transformations de rotation appliquées à l'objet par les données de valeurs clés de quaternions de chaque image clé ;
restaurer les informations de décodage entropique comprenant un mode de décodage entropique indiquant un procédé de décodage entropique pour les données différentielles de rotation ;
restaurer les informations de modulation par impulsion et codage différentielle (MICD) circulaire inverse, qui indiquent s'il faut effectuer l'opération MICD inverse sur les données différentielles de rotation décodées de façon entropique selon le mode de décodage entropique ; et
restaurer les informations de quantification comprenant le nombre de bits de quantification inverse qui est utilisé pour restaurer la valeur différentielle de rotation, par quantification inverse des données différentielles de rotation sur lesquelles l'opération MICD circulaire inverse a été effectuée selon l'ordre de l'opération MICD inverse.

72. Procédé selon la revendication 71, dans lequel les données différentielles de rotation sont codées de sorte que seules trois composantes de la valeur différentielle de rotation représentées par un quaternion sont quantifiées.

73. Procédé selon la revendication 72, dans lequel les informations de décodage entropique comprennent :

un indicateur de valeur clé indiquant si les données différentielles de rotation de chaque composante des données de valeurs clés ont ou n'ont pas la même valeur ; et
des données différentielles de rotation prédéterminées devant être décodées dans chaque composante des données différentielles de rotation de l'ensemble des données de valeurs clés lorsque l'indicateur de valeur clé indique que les données différentielles de rotation de chacune des composantes des données de valeurs clés ont la même valeur.

74. Procédé selon la revendication 71, dans lequel les informations MICD circulaires inverses comprennent en outre les données différentielles intrarotationnelles utilisées pour effectuer l'opération MICD circulaire inverse sur les données différentielles de rotation.

75. Train de bis, dans lequel sont codées les données de valeurs clés d'un interpolateur d'orientation représentant la rotation d'un objet dans chaque image clé, le train de bits comprenant :

des données différentielles de rotation codées de façon entropique en quantifiant une valeur différentielle de rotation utilisée pour faire tourner l'objet d'autant qu'une différence entre les transformations de rotation appliquées à l'objet par des données de valeurs clés de quaternions de chacune des images clés ;
des informations de décodage entropique qui comprennent un mode de décodage entropique indiquant un procédé de décodage entropique, qui a été effectué sur les données différentielles de rotation ;
des informations MICD circulaires inverses qui comprennent l'ordre de l'opération MICD circulaire inverse indiquant si une opération MICD circulaire inverse sera ou ne sera pas effectuée sur les données différentielles de rotation décodées de façon entropique selon le mode de décodage entropique, l'opération MICD circulaire inverse comprenant le remplacement des données MICDées ayant une valeur absolue inférieure à une valeur maximale dans une plage de quantification par les données MICDées de valeur absolue plus grande et de polarité opposée et effectuer une opération MICD linéaire inverse ; et
des bits de quantification inverse qui sont utilisés pour restaurer une valeur différentielle de rotation en quantifiant de façon inverse les données différentielles de rotation MICDées de façon circulaire en suivant l'ordre de l'opération MICD circulaire inverse.

**76.** Train de bits selon la revendication 75, dans lequel les données différentielles de rotation sont codées de sorte que seules trois composantes d'une valeur différentielle de rotation représentées par un quaternion sont quantifiées.

**77.** Train de bits selon la revendication 75 ou 76, dans lequel les informations de décodage entropique comprennent en outre :

un indicateur de valeur clé indiquant si les données différentielles de rotation de chaque composante de la valeur clé ont ou n'ont pas la même valeur ; et
des données différentielles de rotation prédéterminées devant être décodées dans chaque composante de données différentielles de rotation de l'ensemble des données de valeurs clés lorsque l'indicateur de valeur clé indique que les données différentielles de rotation de chacune des composantes des données de valeurs clés a la même valeur.

**78.** Train de bits selon la revendication 75, 76 ou 77, dans lequel les informations MICD circulaires inverses comprennent en outre des données différentielles intrarotationnelles utilisées pour effectuer une opération MICD circulaire inverse sur les données différentielles de rotation.

**79.** Programme informatique comprenant des moyens de code de programme informatique pour effectuer l'ensemble des étapes selon l'une quelconque des revendications 39 à 74, lorsque ledit programme est exécuté sur un ordinateur.

**80.** Programme informatique selon la revendication 79, mis en oeuvre sur un support lisible par ordinateur.

## FIG. 1

FIG. 2A (PRIOR ART)

EP 1 322 120 B1

FIG. 3A

EP 1 322 120 B1

FIG. 3B

START

RECEIVE KEY VALUE DATA
$(Q_i, i=0,...n)$, DPCM ORDER, AND — S300
ENTROPY−ENCODING MODE

S305
FIRST KEY
VALUE DATA Qo ?

YES

NO

FIRST QUATERNION
MULTIPLICATION — S310
$(\dot{Q}_i = Q_i \times \hat{Q}_{i-1}^*)$

PERFORM QUANTIZATION $(\widetilde{Q}_i)$ — S330

S340
LAST KEY
VALUE DATA?

NO

YES

S400
DPCM ORDER
=0?

YES

NO — S410

PERFORM LINEAR DPCM
AND CIRCULAR DPCM

S450
ENTROPY−
−ENCODING MODE?

UNARY

BINARY — S460

BINARY ENTROPY−ENCODING

S370
SECOND QUATERNION
MULTIPLICATION
$(\hat{Q}_i = \hat{\widetilde{Q}}_i \times \hat{Q}_{i-1})$

NO

S360
SECOND KEY
VALUE DATA Qo ?

YES

S380
$\hat{Q}_o = \hat{\widetilde{Q}}_o$

S350
PERFORM INVERSE
QUANTIZATION $(\hat{\widetilde{Q}}_i)$

S470
UNARY ENTROPY−ENCODING

END

## FIG. 4A

PDF ($q_1$)

## FIG. 4B

COMPONENT VALUE

FIG. 5A

THE OUTPUT OF QUANTIZER

$(2^{nQBits-1} - 1)$

$-(2^{nQBits-1} - 1)$

FIG. 5B

THE RESULT OF DPCM

$(2^{nQBits} - 2)$

$-(2^{nQBits} - 2)$

## FIG. 5C

THE RESULT OF CIRCULAR DPCM

$(2^{nQBits-1} - 1)$

$-(2^{nQBits-1} - 1)$

## FIG. 6A

ENCODING ORDER ⟶ 1 3 4 5 6 7 8

VALUE ≈ 74

| 1 | 0 | 0 | 1 | 0 | 1 | 0 |

2

0

SIGN

ENCODING ORDER ⟶ 1 2 4 5 6 7 8

VALUE = −49

| 0 | 1 | 1 | 0 | 0 | 0 | 1 |

3

1

SIGN

## FIG. 6B

ONE SYMBOL      ONE SYMBOL ...

| 0 | 0 | 0 | $\cdots$ | 0 | 1 | 0 | $\cdots$ |

MAGNITUDE
OF SYMBOL

ENDING
FLAG

SIGN

## FIG. 7

$$Q_A = Q_i \times Q_{i-1}^*$$

AREA 2

$\hat{Q}_i$

AREA 3

$Q_i$

$Q_{i-1}$

$$E_{i-1} = Q_B = Q_{i-1} \times \hat{Q}_{i-1}^*$$

AREA 4

$\hat{Q}_{i-1}$

AREA 1

$$Q_C = Q_i \times \hat{Q}_{i-1}^*$$

## FIG. 8A

KEY VALUE DATA OF ORIENTATION INTERPOLATOR

FIRST QUATERNION MULTIPLIER — 810

ROTATION DIRECTION CORRECTOR — 815

ROTATION DIRECTION SELECTOR — 835

QUANTIZER — 840

ROTATIONAL CONVERSION DIFFERENTIAL DATA

ROTATION DIRECTION ERROR CALCULATOR — 820

ROTATION DIRECTION ERROR DETECTOR — 830

DELAYER — 890

SECOND QUATERNION MULTIPLIER — 870

INVERSE QUANTIZER — 850

EP 1 322 120 B1

FIG. 8B

71

## FIG. 9A

```
                    START

    RECEIVE KEY VALUE DATA ─── S900
        (Qᵢ, i=0,...n)

    FIRST QUATERNION ─── S910
      MULTIPLICATION

   DETECT ROTATION DIRECTION ─── S920
      ERROR AND CORRECT
      ROTATION DIRECTION

         S930
      IS ROTATION          YES
   DIRECTION ERROR ────────────────►  QUANTIZE ROTATIONAL ─── S940
      DETECTED?                         DIFFERENTIAL VALUE
                                         HAVING CORRECTED
         NO    S950                      ROTATION DIRECTION
   QUANTIZE ORIGINAL ROTATIONAL
      DIFFERENTIAL VALUE

              S960
                           YES
   LAST KEY VALUE DATA? ───────────►  OUTPUT QUANTIZED ─── S970
                                      ROTATIONAL DIFFERENTIAL
         NO    S980                        DATA (Q̃ᵢ)
   INVERSELY QUANTIZE QUANTIZED
   ROTATIONAL DIFFERENTIAL DATA            END

              S990
   SECOND QUATERNION
     MULTIPLICATION
```

FIG. 9B

```
┌─────────────────────────┐
│   CALCULATE ROTATION     │ ── S922
│    DIRECTION ERROR       │
└─────────────────────────┘
            │
            ▼
┌─────────────────────────┐
│     DETECT ROTATION      │ ── S924
│    DIRECTION ERROR       │
└─────────────────────────┘
            │
            ▼
┌─────────────────────────┐
│   GENERATE ROTATIONAL    │
│   DIFFERENTIAL VALUE     │ ── S926
│    HAVING CORRECTED      │
│    ROTATION DIRECTION    │
└─────────────────────────┘
```

FIG. 10A

FIG. 10B

START

QUANTIZE ROTATIONAL
DIFFERENTIAL VALUE($\hat{Q}$) — S1005

ADJUST QUANTIZED ROTATIONAL
DIFFERENTIAL DATA — S1010

INVERSE QUANTIZATION — S1020

RETRIEVE ROTATIONAL
DIFFERENTIAL VALUE — S1030

S1035
IS RETRIEVED
DIFFERENTIAL VALUE
REAL NUMBER?

NO

YES — S1045

MEASURE ERROR

S1050
$e_{i,j,k} < e_{i*j*k*}$ ?

NO

YES — S1055

RENEW ADJUSTED ERROR ($e_{i*j*k*}$)

S1060
$-d \leq i,j,k \leq d$ ?

YES

NO

S1070
$e_{i*j*k*} < e_{gi*gj*gk*}$ ?

YES

S1075
RENEW FINAL ERROR
($e_{gi*gj*gk*}$) AND
QNATIZED ROTATIONAL
DIFFERENTIAL DATA

NO — S1080

OUTPUT QNANTIZED ROTATIONAL
DIFFERENTIAL DATA

END

# FIG. 11A

KEY VALUE
HEADER DECODER — 1170

1100

BITSTREAM

$\overline{Q}_i$

1110

ENTROPY
DECODER

$\breve{Q}_i$

1120

INVERSE
CIRCULAR
DPCM
OPERATOR

$\tilde{Q}_i$

1130

INVERSE
QUANTIZER

$\hat{\tilde{Q}}_i$

1140

QUATERNION
MULTIPLIER

$\hat{Q}_i$

DECODED KEY
VALUE DATA OF
ORIENTATION
INTERPOLATOR

DELAYER

1160

# FIG. 11B

START

KEY VALUE HEADER DECODING — S1100

Keyvalue_flag=0 ? — S1120

YES → ENTROPY-DECODE KEY VALUE DATA INTO THE SAME VALUE AS nAllKeyValues — S1122

NO

ENTORPY-DECODING MODE= BINARY ? — S1124

NO → ENTROPY-DECODING USING UnaryAAC FUNCTION — S1128

YES — S1126

ENTROPY-DECODING USING Binary AAC FUNCTION

DPCM ORDER=0 ? — S1130    YES

NO — S1135

INVERSE CIRCULAR DPCM

INVERSE QUANTIZATION — S1140

QUATERNION MULTIPLICATION — S1154

LAST KEY VALUE DATA? — S1156    NO

YES

OUTPUT DECODED KEY VALUE DATA ($\hat{Q}_i$) — S1158

END

FIG. 12

FIG. 13A

```
class CompressedOrientationInterpolator {
      OrilKeyValueHeader orilKVHeader;
      qf_start();
      if(orilKVHeader.nKVDPCMOrder == 0)    //1st order DPCM
            OrilDPCMKeyValue orilDPCMKeyValue(orilKVHeader.orilDPCMKVHeader,
orilKVHeader.nNumberOfKeyValue-1);
      else      //2nd order DPCM
            OrilDPCMKeyValue orilDPCMKeyValue(orilKVHeader.orilDPCMKVHeader,
orilKVHeader.nNumberOfKeyValue-2);
}
```

# FIG. 13B

```
class OrilKeyValueHeader () {
        unsigned int(5) nKVQBit;
        unsigned int(5) nNumKeyValueCodingBit;
        unsigned int(nNumKeyVaueCodingBit) nNumberOfKeyValue;
        bit(1) nKVDPCMOrder;
        OrilDPCMKeyValueHeader orilDPCMKVHeader(nKVQBit, nKVDPCMOrder);

}
```

# FIG. 13C

```
class OriIDPCMKeyValueHeader (int nKVQBit, unsigned int nKVDPCMOrder) {
      unsigned int(nKVQBit-1) firstQKV_S;
      bit(1) nFirstXSign;
      unsigned int(nKVQBit-1) firstQKV_X;
      bit(1) nFirstYSign;
      unsigned int(nKVQBit-1) firstQKV_Y;
      bit(1) nFirstZSign;
      unsigned int(nKVQBit-1) firstQKV_Z;
      if (nKVDPCMOrder==1) {          //2nd order DPCM
      bit(1) nSecondXSign;
      unsigned int(nKVQBit-1) secondQKV_X;
      bit(1) nSecondYSign;
      unsigned int(nKVQBit-1) secondQKV_Y;
      bit(1) nSecondZSign;
      unsigned int(nKVQBit-1) secondQKV_Z;
      bit(1) bIsMoreTwoKVs;
      }
      if (nKVDPCMOrder==0 || bIsMoreTwoKVs==1) {
      bit(1) x_keyvalue_flag;
      OriIKeyValueCodingBit oriIKVCodingBit_X(x_keyvalue_flag, nKVQBit);
      bit(1) y_keyvalue_flag;
      OriIKeyValueCodingBit oriIKVCodingBit_Y(y_keyvalue_flag, nKVQBit);
      bit(1) z_keyvalue_flag;
      OriIKeyValueCodingBit oriIKVCodingBit_Z(z_keyvalue_flag, nKVQBit);
      }
}
```

## FIG. 13D

```
class OrilKeyValueCodingBit (unsigned int flag_bit, int nKVQBit) {
        int count = (int)(log10(nKVQBit)/log10(2)) + 1;
        if(flag_bit == 0) {
                unsigned int(count) nKVCodingBit;
                if(nKVCodingBit == 1)
                        unsigned int(nKVCodingBit) nAllKeyValue;
                else {
                        bit(1) nSign;
                        unsigned int(nKVCodingBit-1) nAllKeyValue;
                }
        } else {
                bit(1) bIsUnaryAAC;
                if(bIsUnaryAAC != 1)
                        unsigned int(count) nKVCodingBit;
        }
}
```

## FIG. 13E

```
class OriIDPCMKeyValue(OriIDPCMKeyValueHeader kvHeader, int nNumKV) {
    int i;
    if(kvHeader.x_keyvalue_flag != 0) {
        if(kvHeader.oriIKVCodingBit_X.bIsUnaryAAC == 1)
            for(i = 0;i < nNumKV;i++)
                decodeUnaryAAC(&DeltaKeyValue[i].x, kVXSignContext,
kVXUnaryContext);
        else
            for(i = 0;i < nNumKV;i++)
                decodeSignedAAC(&DeltaKeyValue[i].x,
kvHeader.oriIKVCodingBit_X.nKVCodingBit, kVXSignContext, kVXContext);
    }
    if(kvHeader.y_keyvalue_flag != 0) {
        if(kvHeader.oriIKVCodingBit_Y.bIsUnaryAAC == 1)
            for(i = 0;i < nNumKV;i++)
                decodeUnaryAAC(&DeltaKeyValue[i].y, kVYSignContext,
kVYUnaryContext);
        else
            for(i = 0;i < nNumKV;i++)
                decodeSignedAAC(&DeltaKeyValue[i].y,
kvHeader.oriIKVCodingBit_Y.nKVCodingBit, kVYSignContext, kVYContext);
    }
    if(kvHeader.z_keyvalue_flag != 0) {
        if(kvHeader.oriIKVCodingBit_Z.bIsUnaryAAC == 1)
            for(i = 0;i < nNumKV;i++)
                decodeUnaryAAC(&DeltaKeyValue[i].z, kVZSignContext,
kVZUnaryContext);
        else
            for(i = 0;i < nNumKV;i++)
                decodeSignedAAC(&DeltaKeyValue[i].z,
kvHeader.oriIKVCodingBit_Z.nKVCodingBit, kVZSignContext, kVZContext);
    }
}
```

FIG. 14

FIG. 15

RATE−DISTORTION CURVE

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0141156 A

- US 6075901 A

**Non-patent literature cited in the description**

- **Jang.** 3D Animation Coding: its history and framework. *Proceedings of IEEE International Conference on Multimedia and Expo,* 2000, vol. 2, 1119-1122

- **Signes.** Binary Format for Scene (BIFS): Combining MPEG-4 media to build rich multimedia services. *Proceedings of the SPIE,* vol. 3653, 1506-1517